# EUROPEAN PATENT APPLICATION

(11) **EP 4 624 476 A1**
(43) Date of publication of application: **01.10.2025**
(21) Application number: 23902844.2
(22) Date of filing: 15.12.2023
(51) Int. Cl.: C07F 5/02, C07F 7/08, C09K 11/06, H10K 85/60, H10K 85/40, H10K 50/11

(54) **BORON-CONTAINING ORGANIC COMPOUNDS AND ORGANIC ELECTROLUMINESCENT DEVICE PREPARED FROM SAME**

(30) Priority: 15.12.2022 CN 202211624214; 30.03.2023 CN 202310330105
(71) Applicant: Huawei Technologies Co., Ltd., Shenzhen, Guangdong 518129 (CN); Jiangsu Sunera Technology Co., Ltd, Wuxi, Jiangsu 214112 (CN)
(72) Inventor: CAO, Xudong, Wuxi, Jiangsu 214112 (CN); ZHAN, Ge, Shenzhen, Guangdong 518129 (CN); WU, Jiang, Shenzhen, Guangdong 518129 (CN); LIANG, Xiao, Wuxi, Jiangsu 214112 (CN); CHEN, Shangqian, Wuxi, Jiangsu 214112 (CN); DUAN, Lian, Wuxi, Jiangsu 214112 (CN)
(74) Representative: Körber, Martin Hans
(86) International application number: PCT/CN2023/139294
(87) International publication number: WO 2024/125652

(57) **Abstract**

The present invention discloses a boron-containing organic compound and an organic electroluminescent device prepared from same, and belongs to the field of semiconductor technologies. A structure of the organic compound in the present invention is shown in general formula (A-1). The compound in the present invention is used as a green light doping material of a light-emitting layer for the organic electroluminescent device, so that a lifetime of the device can be improved.

## Description

### TECHNICAL FIELD

The present invention relates to the field of semiconductor technologies, and in particular, to a boron-containing organic compound and an organic electroluminescent device prepared from same.

### BACKGROUND

Conventional fluorescent doping materials, limited by early technologies, can use only 25% of singlet excitons formed by excitation to emit light, resulting in low internal quantum efficiency (25% at most) of devices and external quantum efficiency of the devices usually lower than 5%, and a huge gap from phosphorescent devices in efficiency. Phosphorescent materials, due to intersystem crossing enhanced by strong spin-orbit coupling at the center of heavy atoms, can effectively use singlet excitons and triplet excitons formed by excitation to emit light, resulting in 100% internal quantum efficiency of devices. However, most phosphorescent materials have high prices, poor material stability, poor color purity, severe device efficiency roll-off, and other problems, limiting use of the phosphorescent materials in OLEDs.

With the advent of the 5G era, higher requirements are imposed on a color rendering criterion. In addition to high efficiency and stability, light-emitting materials also require a narrower full width at half maximum to improve color purity for light emission of devices. Fluorescent doping materials can achieve high fluorescence quantum and a narrow full width at half maximum through molecular engineering. Blue fluorescent doping materials have achieved a breakthrough in a stage, and a full width at half maximum of boron-based materials can be reduced to 30 nm or less. Research for a green light region to which human eyes are more sensitive mainly focuses on phosphorescent doping materials, but it is difficult to narrow a luminescence peak shape of the phosphorescent doping materials by a simple method. Therefore, it is of great significance to study highly efficient green fluorescent doping materials with a narrow full width at half maximum to meet a higher color rendering criterion.

In addition, a triplet exciton-sensitizing material and a fluorescent doping material are combined by using a sensitization technology. The triplet exciton-sensitizing material, used as an exciton-sensitizing medium, transfers energy to the fluorescent doping material through energy transfer by fully utilizing triplet excitons. In this way, 100% internal quantum efficiency of devices can also be reached. This technology can cover the shortage of insufficient exciton utilization of the fluorescent doping material, and effectively achieve the advantages of the fluorescent doping material such as a high fluorescence quantum yield, high device stability, high color purity, and a low price, having a broad application prospect in OLEDs.

It is easier for boron-based compounds with resonance structures to achieve luminescence with a narrow full width at half maximum. The use of this type of materials in the sensitization technology can implement preparation of devices for highly efficient emission with a narrow full width at half maximum. For example, CN107507921A and CN110492006A disclose a technology for combining, into a light-emitting layer, a TADF material as a host material whose energy gap between the lowest singlet state and the lowest triplet state is less than or equal to 0.2 eV and a boron-containing material as a doping material; and CN110492005A and CN110492009A disclose a solution for combining, into a light-emitting layer, an exciplex as a host material and a boron-containing material as a doping material. Both solutions can achieve efficiency comparable to that of phosphorescence materials, and a relatively narrow full width at half maximum. Development of a sensitization technology based on a boron-based light-emitting material with a narrow full width at half maximum offers unique advantages and strong potential for the BT.2020 display standard.

### SUMMARY

For the foregoing problems in the conventional technology, the present invention provides a boron-containing organic compound and an organic electroluminescent device prepared from same. The compound in the present invention can be used as a green light doping material of a light-emitting layer for the organic electroluminescent device.

The present invention provides the following technical solutions. Provided is a boron-containing organic compound. A structure of the boron-containing organic compound is shown in general formula (A-1):

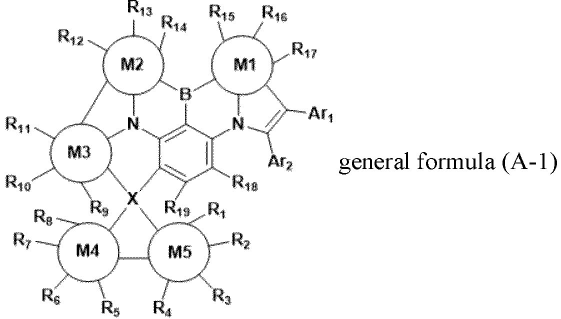

In general formula (A-1), R₁ to R₁₉ each time present identically or differently represent one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkenyl, substituted or unsubstituted C1-C10 alkynyl, substituted or unsubstituted silanyl, substituted or unsubstituted boranyl, substituted or unsubstituted C1-C10 alkoxy, substituted or unsubstituted C6-C30 aryloxy, substituted or unsubstituted arylamido, substituted or unsubstituted C6-C30 aryl, and substituted or unsubstituted C2-C30 heteroaryl;
any adjacent two of R₁ to R₁₇ are linkable to form a ring;
R₁₈ and R₁₉ are linkable to form a ring;
Ar₁ and Ar₂ each time present identically or differently represent one of a hydrogen atom, substituted or unsubstituted C1-C10 alkyl, substituted or unsubstituted C3-C10 cycloalkyl, substituted or unsubstituted C1-C10 alkenyl, substituted or unsubstituted C1-C10 alkynyl, substituted or unsubstituted silanyl, substituted or unsubstituted boranyl, substituted or unsubstituted C1-C10 alkoxy, substituted or unsubstituted C6-C30 aryloxy, substituted or unsubstituted arylamido, substituted or unsubstituted C6-C30 aryl, and substituted or unsubstituted C2-C30 heteroaryl;
M₁, M₂, M₃, M₄, and M₅ each independently represent one of a substituted or unsubstituted C₆-C₃₀ aromatic ring, a substituted or unsubstituted 5-membered to 30-membered heteroaromatic ring, and a substituted or unsubstituted C6-C10 aliphatic ring;
X represents C or Si; and
a substituent for substituting a group is optionally selected from any one of deuterium, tritium, a halogen atom, cyano, C1-C10 alkyl, deuterium- or tritium-substituted C1-C10 alkyl, C6-C30 aryl, deuterium- or tritium-substituted C6-C30 aryl, C2-C30 heteroaryl, and deuterium- or tritium-substituted C2-C30 heteroaryl.

In a preferred solution, in general formula (A-1), any adjacent two of R₁ to R₁₇ may be linked to form a substituted or unsubstituted C6-C30 aromatic ring, a substituted or unsubstituted C2-C30 heteroaromatic ring, or a substituted or unsubstituted C6-C30 aliphatic ring.

In a preferred solution, in general formula (A-1), R₁ to R₁₉ each time present identically or differently represent:
any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 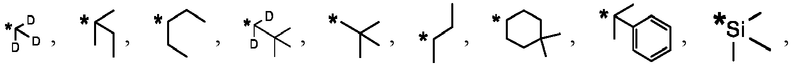 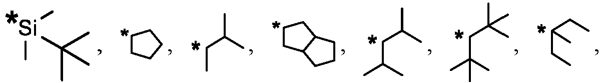 or phenyl;
Ar₁ and Ar₂ each time present identically or differently represent:
any one of methyl, 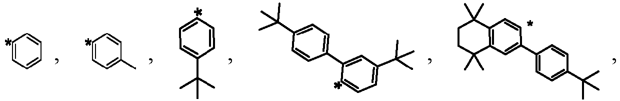 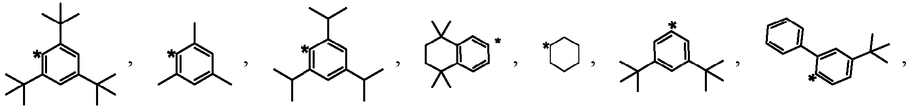 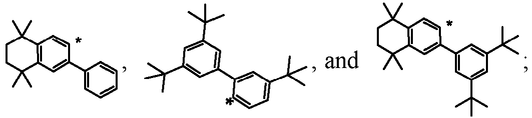
M₁, M₂, and M₃ represent any one of the following ring structures: 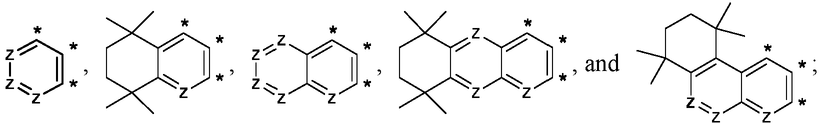
M₄ and M₅ represent the following ring structure: 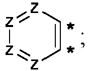
Z represents C-Rₐ;
Rₐ each time present independently represents: any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 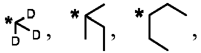 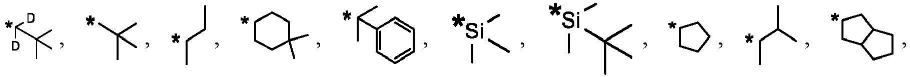 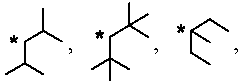 or phenyl; and
X represents C or Si.

In a preferred solution, a structure of the boron-containing organic compound is shown in general formula (A):

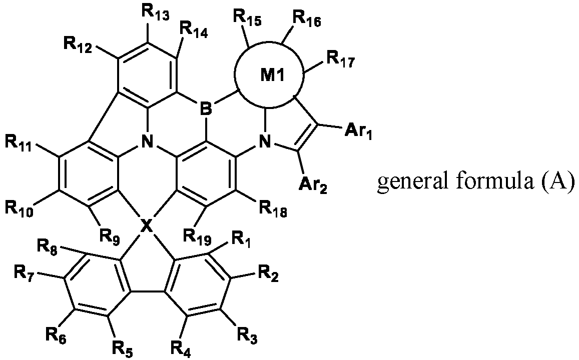

In general formula (A), R₁ to R₁₉ each time present identically or differently represent one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
any adjacent two of R₁ to R₁₄ are linkable to form a ring;
R₁₈ and R₁₉ are linkable to form a ring;
Ar₁ and Ar₂ each time present identically or differently represent one of substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
M₁ represents one of a substituted or unsubstituted C₆-C₃₀ aromatic ring and a substituted or unsubstituted 5-membered to 30-membered heteroaromatic ring;
X represents C or Si; and
a substituent for substituting a group is optionally selected from any one of deuterium, tritium, a halogen atom, cyano, C1-C10 alkyl, deuterium- or tritium-substituted C1-C10 alkyl, C6-C30 aryl, deuterium- or tritium-substituted C6-C30 aryl, C5-C30 heteroaryl, and deuterium- or tritium-substituted C2-C30 heteroaryl.

In a preferred solution, in general formula (A), any adjacent two of R₁ to R₁₄ may be linked to form a substituted or unsubstituted C6-C30 aromatic ring, a substituted or unsubstituted C2-C30 heteroaromatic ring, or a substituted or unsubstituted C6-C30 aliphatic ring.

In a preferred solution, in general formula (A), R₁ to R₁₉ each time present identically or differently represent:
any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 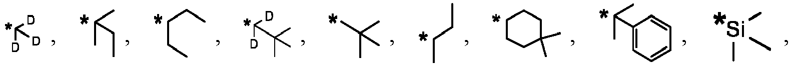 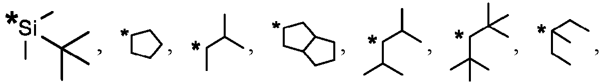 or phenyl;
Ar₁ and Ar₂ each time present identically or differently represent:
any one of methyl, 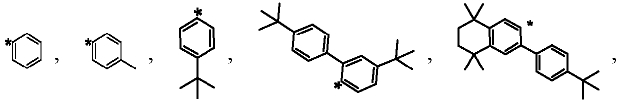 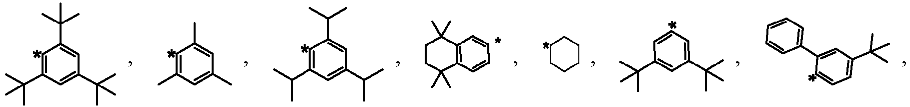 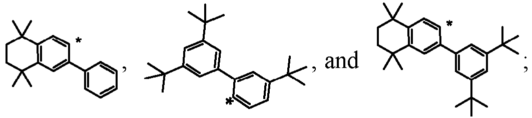
M₁ represents any one of the following ring structures: 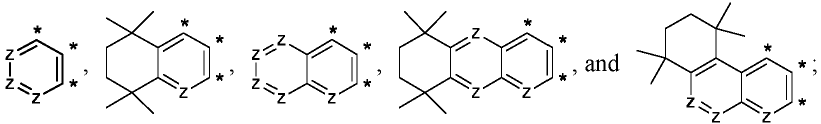
Z represents C-Rₐ;
Rₐ each time present independently represents: any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 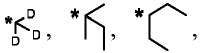 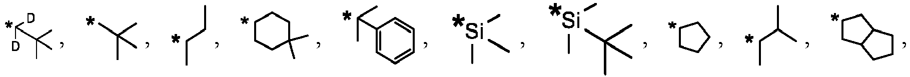 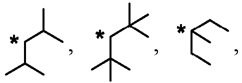 or phenyl; and
X represents C or Si.

In a preferred solution, a structure of the boron-containing organic compound is shown in any one of general formula (1-1) and general formula (1-2):

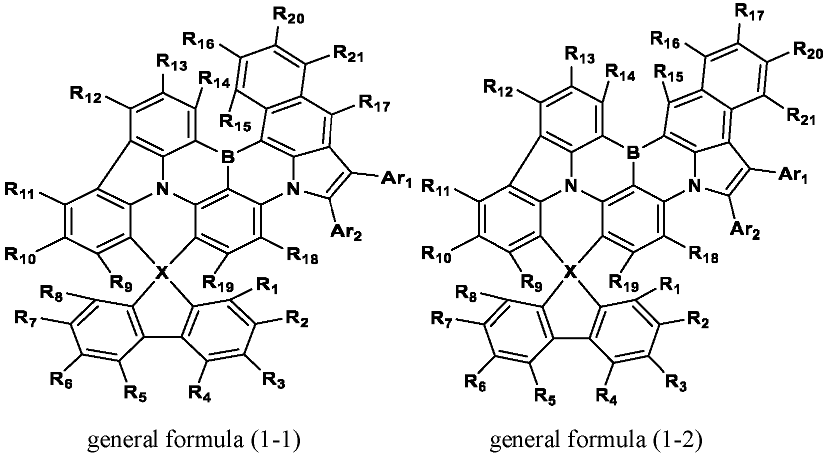

In general formula (1-1) and general formula (1-2), R₁ to R₂₁ each time present identically or differently represent one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
any adjacent two of R₁ to R₂₁ are linkable to form a ring;
Ar₁ and Ar₂ each time present identically or differently represent one of substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
X represents C or Si; and
a substituent for substituting a group is optionally selected from any one of deuterium, tritium, a halogen atom, cyano, C1-C10 alkyl, deuterium- or tritium-substituted C1-C10 alkyl, C6-C30 aryl, deuterium- or tritium-substituted C6-C30 aryl, C5-C30 heteroaryl, and deuterium- or tritium-substituted C2-C30 heteroaryl.

In a preferred solution, in general formula (1-1) and general formula (1-2), any adjacent two of R₁ to R₂₁ may be linked to form a substituted or unsubstituted C6-C30 aromatic ring, a substituted or unsubstituted C2-C30 heteroaromatic ring, or a substituted or unsubstituted C6-C30 aliphatic ring.

In a preferred solution, in general formula (1-1) and general formula (1-2), R₁ to R₂₁ each time present identically or differently represent:
any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 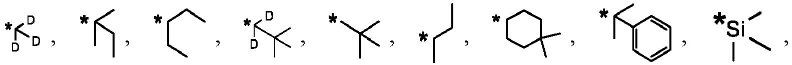 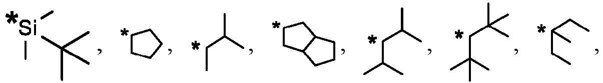 or phenyl;
Ar₁ and Ar₂ each time present identically or differently represent:
any one of methyl, 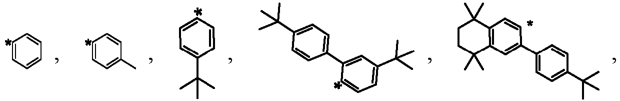 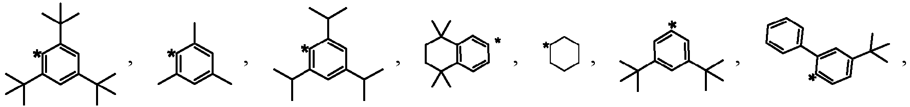 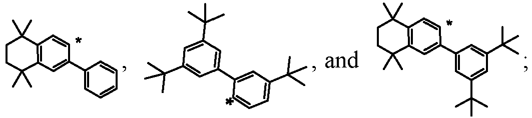 and
X represents C or Si.

In a preferred solution, a structure of the boron-containing organic compound is shown in any one of general formula (1-3) and general formula (1-4):

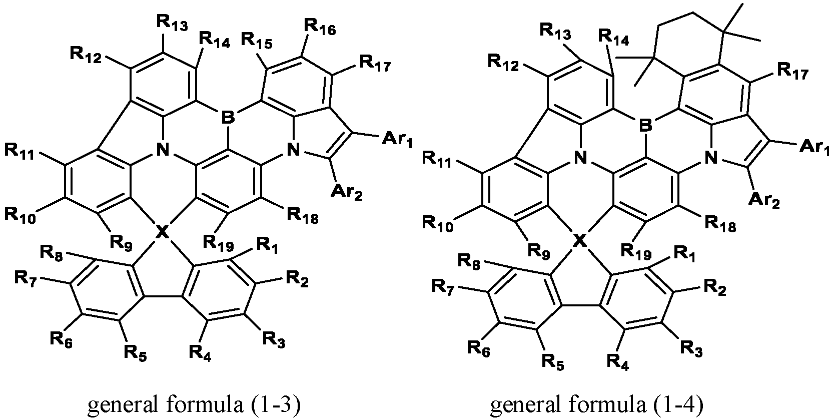

In general formula (1-3) and general formula (1-4), R₁ to R₁₉ each time present identically or differently represent one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkenyl, substituted or unsubstituted C1-C10 alkynyl, substituted or unsubstituted silanyl, substituted or unsubstituted boranyl, substituted or unsubstituted C1-C10 alkoxy, substituted or unsubstituted C6-C30 aryloxy, substituted or unsubstituted arylamido, substituted or unsubstituted C6-C30 aryl, and substituted or unsubstituted C2-C30 heteroaryl;
any adjacent two of R₁ to R₁₉ are linkable to form a ring;
Ar₁ and Ar₂ each time present identically or differently represent one of substituted or unsubstituted C1-C10 alkyl, substituted or unsubstituted C3-C10 cycloalkyl, substituted or unsubstituted C1-C10 alkenyl, substituted or unsubstituted C1-C10 alkynyl, substituted or unsubstituted silanyl, substituted or unsubstituted boranyl, substituted or unsubstituted C1-C10 alkoxy, substituted or unsubstituted C6-C30 aryloxy, substituted or unsubstituted arylamido, substituted or unsubstituted C6-C30 aryl, and substituted or unsubstituted C2-C30 heteroaryl;
X represents C or Si; and
a substituent for substituting a group is optionally selected from any one of deuterium, tritium, a halogen atom, cyano, C1-C10 alkyl, deuterium- or tritium-substituted C1-C10 alkyl, C6-C30 aryl, deuterium- or tritium-substituted C6-C30 aryl, C2-C30 heteroaryl, and deuterium- or tritium-substituted C2-C30 heteroaryl.

In a preferred solution, in general formula (1-3) and general formula (1-4), any adjacent two of R₁ to R₁₉ may be linked to form a substituted or unsubstituted C6-C30 aromatic ring, a substituted or unsubstituted C2-C30 heteroaromatic ring, or a substituted or unsubstituted C6-C30 aliphatic ring.

In a preferred solution, in general formula (1-3) and general formula (1-4), R₁ to R₁₉ each time present identically or differently represent:
any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 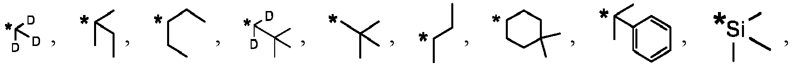 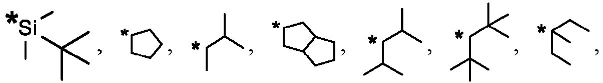 or phenyl;
Ar₁ and Ar₂ each time present identically or differently represent:
any one of methyl, 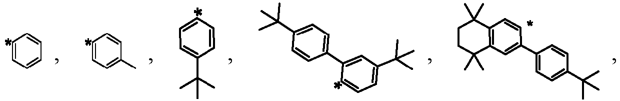 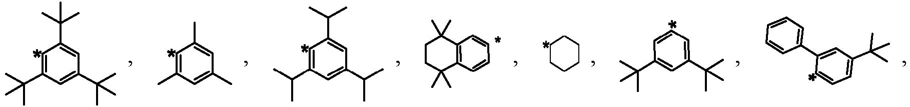 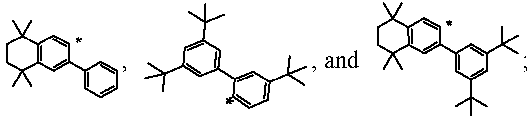 and
X represents C or Si.

In a preferred solution, a structure of the boron-containing organic compound is shown in general formula (2):

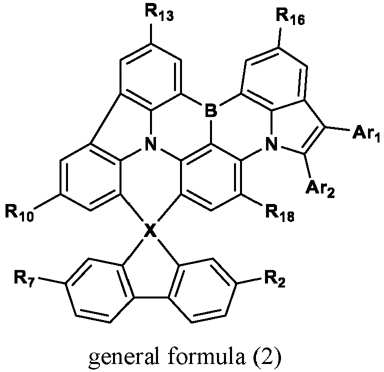

In general formula (2), meanings of R₂, R₇, R₁₀, R₁₃, R₁₆, R₁₈, Ar₁, Ar₂, and X are the same as those defined in general formula (A).

In a preferred solution, in general formula (2), R₂, R₇, R₁₀, R₁₃, R₁₆, and R₁₈ each independently represent:
any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 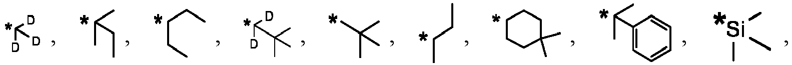 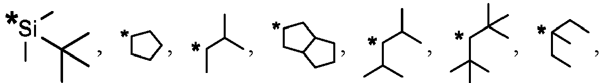 or phenyl;
Ar₁ and Ar₂ each time present identically or differently represent:
any one of methyl, 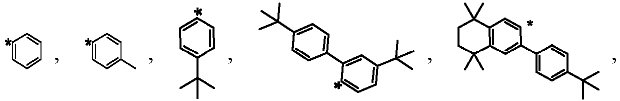 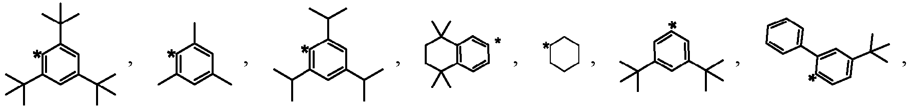 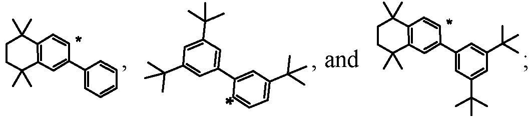 and
X represents C or Si.

In a preferred solution, a structure of the boron-containing organic compound is shown in any one of general formula (2-1) and general formula (2-2):

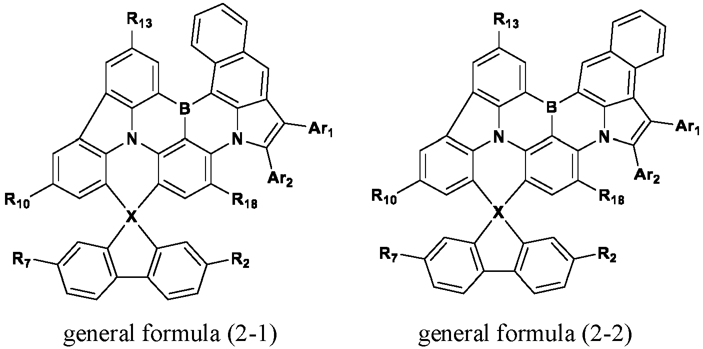

In general formula (2-1) and general formula (2-2), meanings of R₂, R₇, R₁₀, R₁₃, R₁₈, Ar₁, Ar₂, and X are the same as those defined in general formula (A).

In a preferred solution, in general formula (2-1) and general formula (2-2), R₂, R₇, R₁₀, R₁₃, and R₁₈ each independently represent:
any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 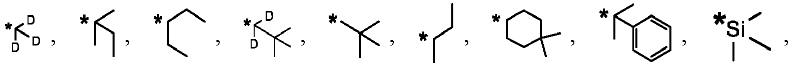 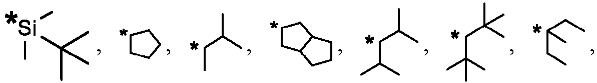 or phenyl;
Ar₁ and Ar₂ each time present identically or differently represent:
any one of methyl, 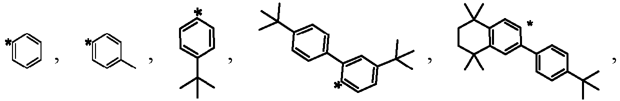 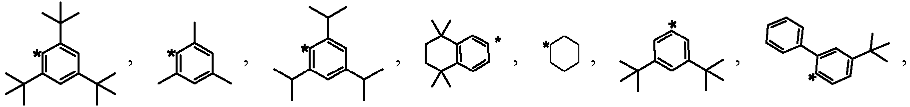 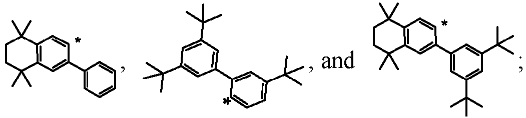 and
X represents C or Si.

In a preferred solution, a structure of the boron-containing organic compound is shown in general formula (3-1):

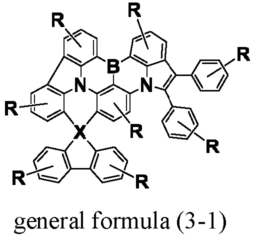

In general formula (3-1), R each time present identically or differently represents one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
X represents C or Si; and
a substituent for substituting a group is optionally selected from any one of deuterium, tritium, a halogen atom, cyano, C1-C10 alkyl, deuterium- or tritium-substituted C1-C10 alkyl, C6-C30 aryl, deuterium- or tritium-substituted C6-C30 aryl, C5-C30 heteroaryl, and deuterium- or tritium-substituted C2-C30 heteroaryl.

In a preferred solution, in general formula (3-1), R each time present identically or differently independently represents:
any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 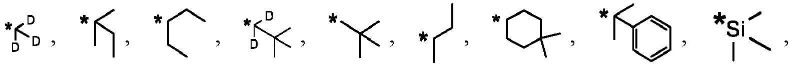 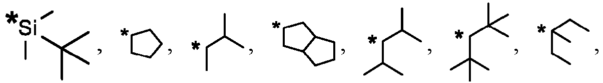 or phenyl.

In a preferred solution, R and R₁ to R₂₁ each independently represent one of a hydrogen atom, a deuterium atom, a tritium atom, a fluorine atom, cyano, adamantyl, methyl, deuterated methyl, tritiated methyl, trifluoromethyl, ethyl, deuterated ethyl, tritiated ethyl, isopropyl, deuterated isopropyl, tritiated isopropyl, tert-butyl, deuterated tert-butyl, tritiated tert-butyl, cyclopentyl, deuterated cyclopentyl, tritiated cyclopentyl, methyl-substituted cyclopentyl, cyclohexyl, phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, tert-butyl-substituted dibenzofuryl, phenyl-substituted tert-butyl, xanthone, phenyl-substituted triazinyl, phenyl-substituted boranyl, methoxy, and tert-butoxy.

Ar₁ and Ar₂ each independently represent one of phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, phenyl-substituted amino, tert-butylbenzene-substituted amino, tert-butyl-substituted dibenzofuryl, phenyl-substituted tert-butyl, xanthone, phenyl-substituted triazinyl, phenyl-substituted boranyl, methoxy, and tert-butoxy.

M₁, M₂, M₃, M₄, and M₅ represent one of phenyl, deuterated phenyl, diphenyl, deuterated diphenyl, triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, phenyl-substituted amino, tert-butyl-substituted dibenzofuryl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, and xanthone.

A substituent for substituting a substitutable group is optionally selected from one or more of a deuterium atom, a chlorine atom, a fluorine atom, trifluoromethyl, adamantyl, cyano, methyl, ethyl, propyl, isopropyl, tert-pentyl, tert-butyl, butyl, methoxy, phenyl, diphenyl, naphthyl, anthryl, phenanthryl, pyridinyl, pyrimidinyl, pyrazinyl, pyridazinyl, benzoxazolyl, benzothiazolyl, quinoxalinyl, quinolyl, isoquinolyl, furyl, thienyl, indolyl, pyrrolyl, dibenzofuryl, dibenzothienyl, 9,9-dimethylfluorenyl, spirofluorenyl, carbazolyl, N-phenylcarbazolyl, carbazolinyl, and azaphenanthryl.

In a preferred solution, R and R₁ to R₂₁ each independently represent the following structures:
any one of a hydrogen atom, cyano, 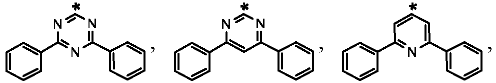 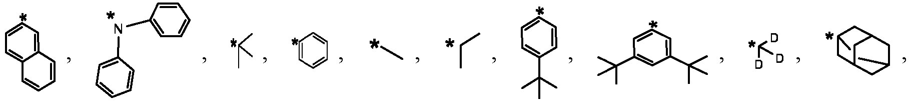 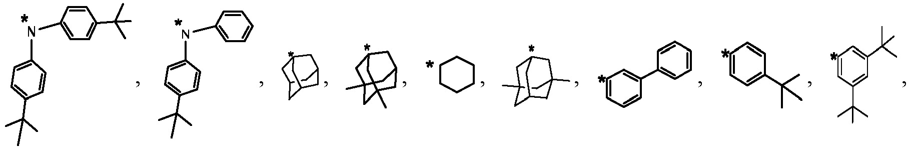 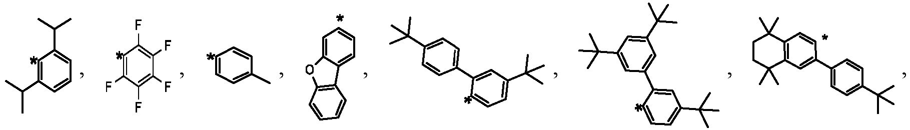 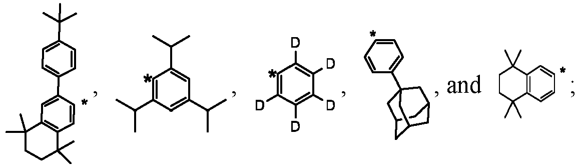
Ar₁ and Ar₂ represent the following structures:
any one of 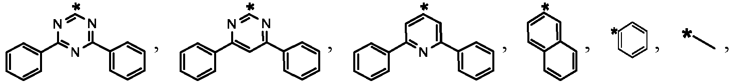 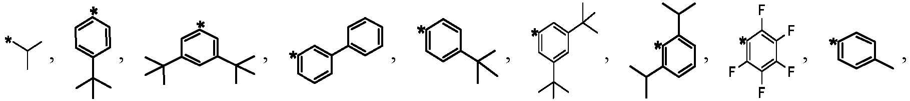 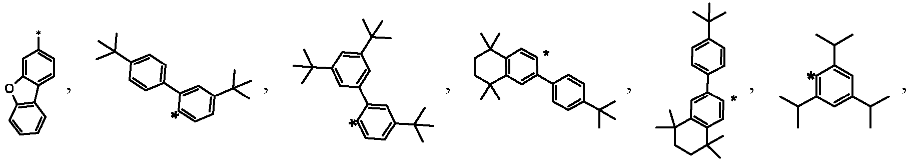 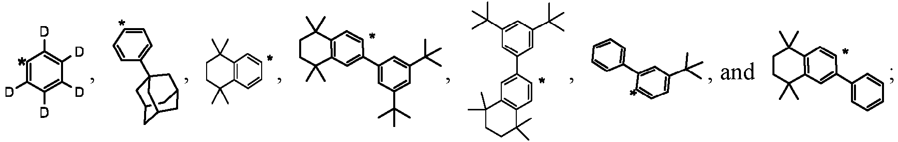
M₁, M₂, and M₃ represent any one of the following ring structures: 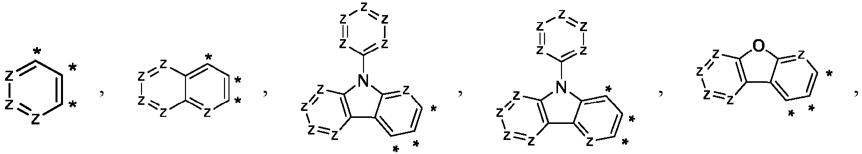 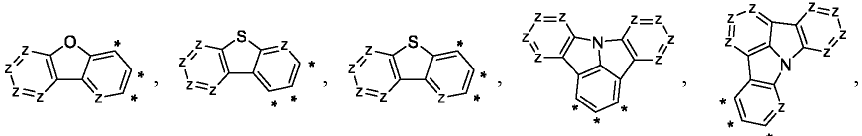 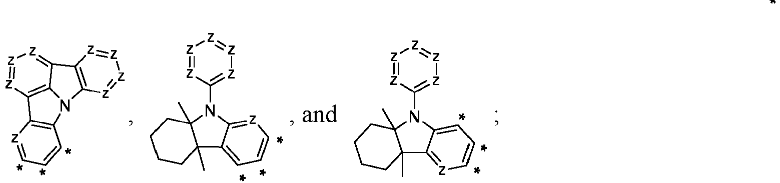
M₄ and M₅ represent any one of the following ring structures: 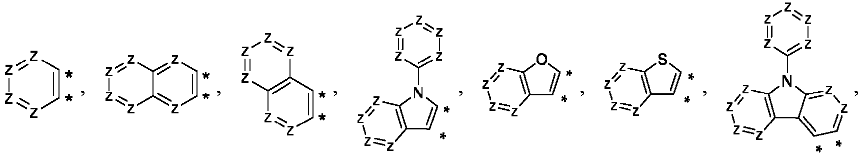 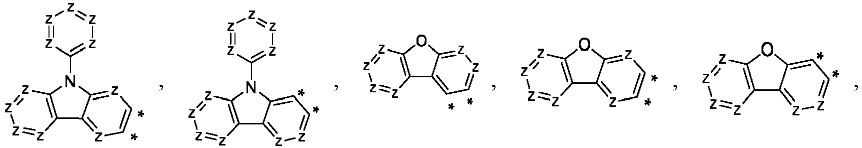 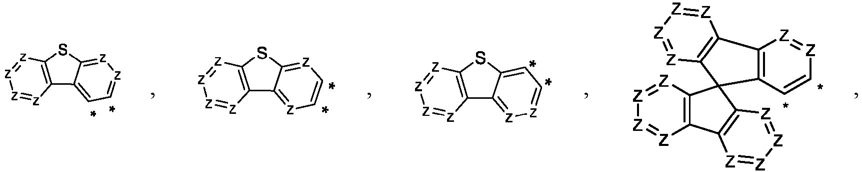 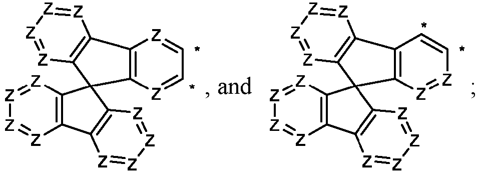
Z represents C-Rₐ; and
Rₐ each time present independently represents one of a hydrogen atom, a deuterium atom, a tritium atom, a halogen atom, cyano, adamantyl, methyl, deuterated methyl, tritiated methyl, trifluoromethyl, ethyl, deuterated ethyl, tritiated ethyl, isopropyl, deuterated isopropyl, tritiated isopropyl, tert-butyl, deuterated tert-butyl, tritiated tert-butyl, cyclopentyl, deuterated cyclopentyl, tritiated cyclopentyl, methyl-substituted cyclopentyl, cyclohexyl, phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, phenyl-substituted amino, tert-butylbenzene-substituted amino, tert-butyl-substituted dibenzofuryl, phenyl-substituted tert-butyl, xanthone, phenyl-substituted triazinyl, phenyl-substituted boranyl, methoxy, and tert-butoxy.

In a preferred solution, R and R₁ to R₂₁ each independently represent the following structures:
any one of a hydrogen atom, cyano, methyl, ethyl, isopropyl, tert-butyl, trifluoromethyl, 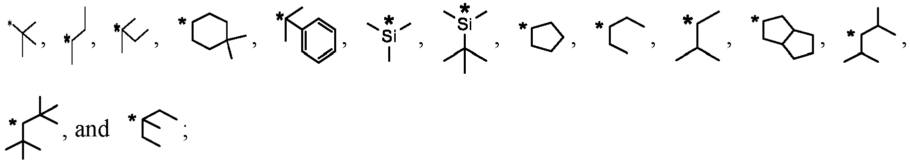
Ar₁ and Ar₂ represent the following structures:
any one of methyl, 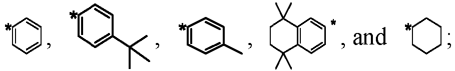
M₁, M₂, and M₃ represent the following ring structures: 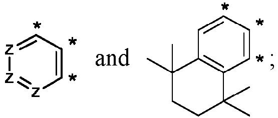
M₄ and M₅ represent the following ring structure: 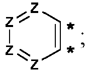
Z represents C-Rₐ; and
Rₐ each time present independently represents any one of a hydrogen atom, cyano, methyl, ethyl, isopropyl, tert-butyl, trifluoromethyl,

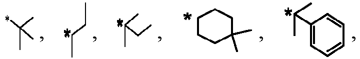

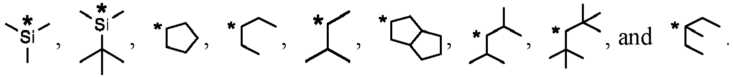

In a preferred solution, a specific structural formula of the boron-containing organic compound is any one of the following structures:

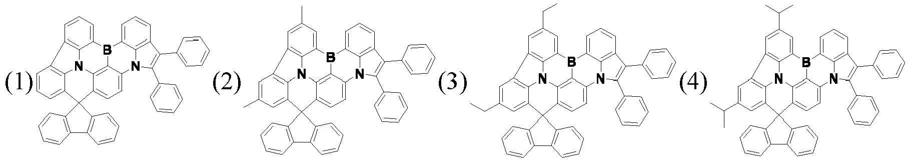

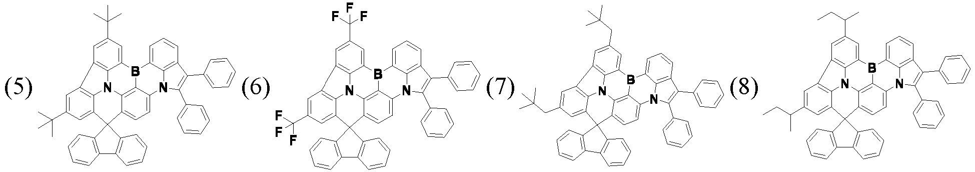

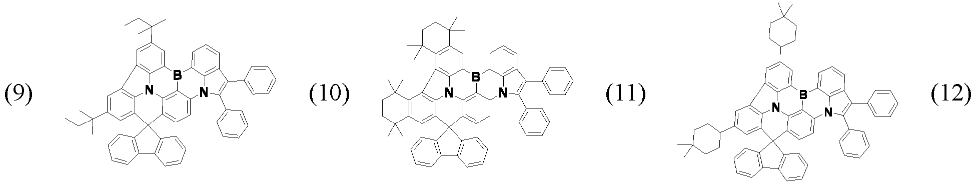

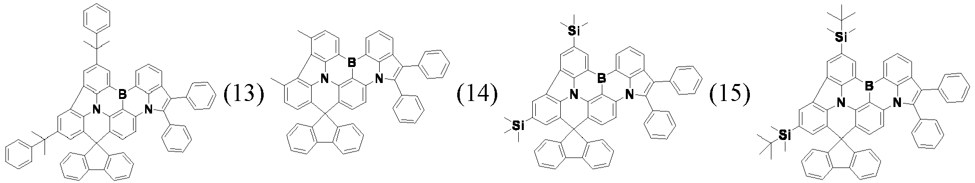

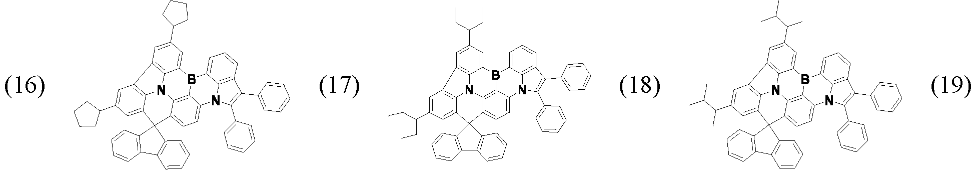

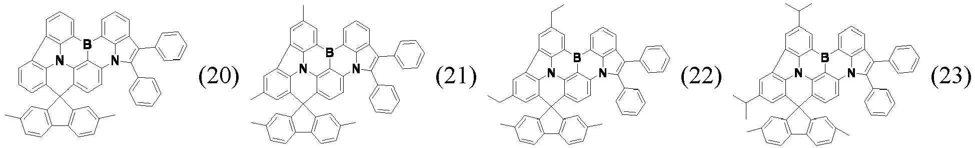

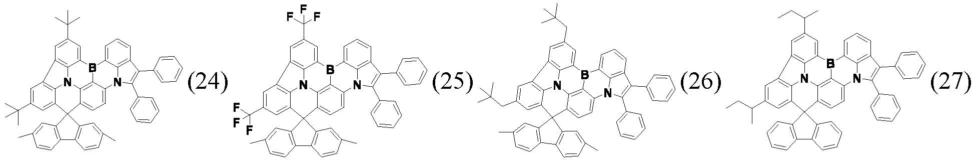

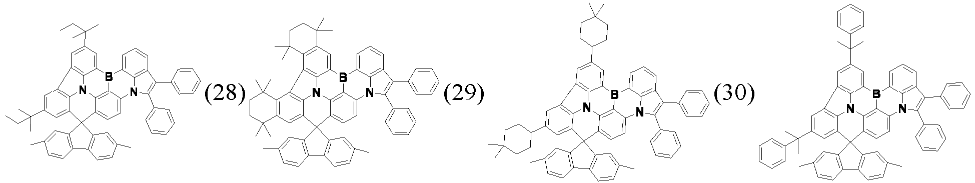

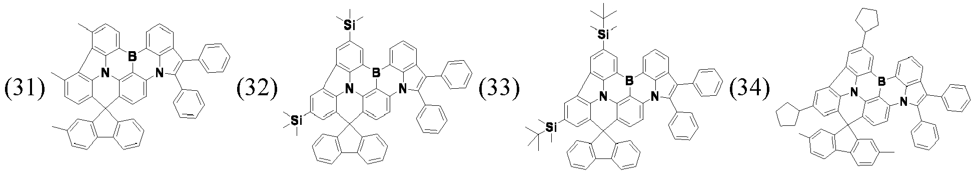

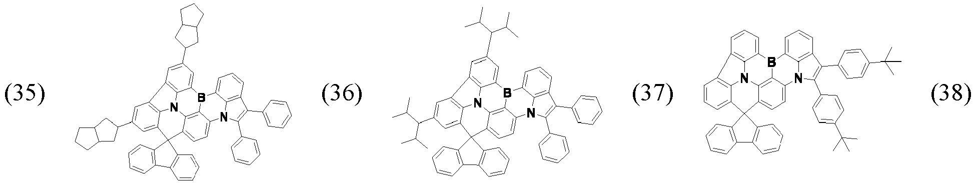

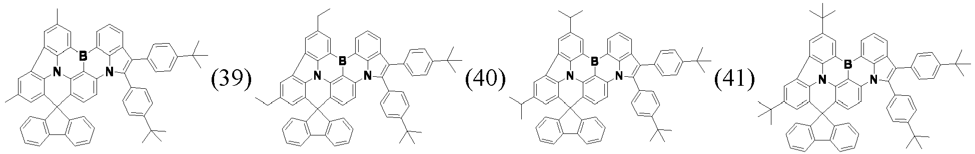

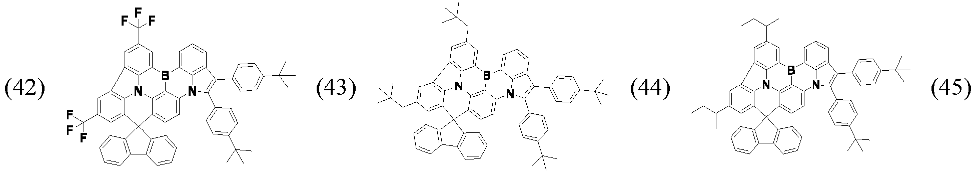

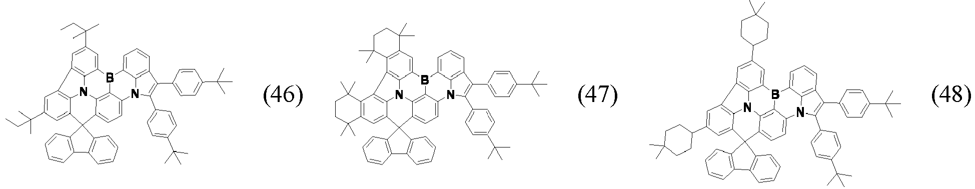

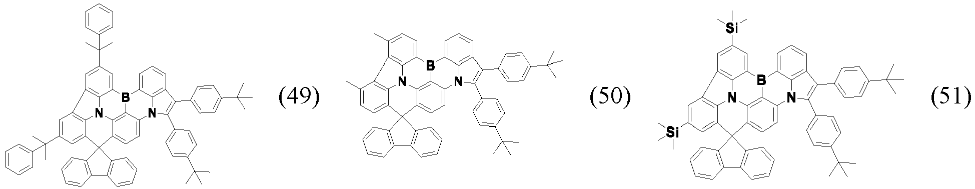

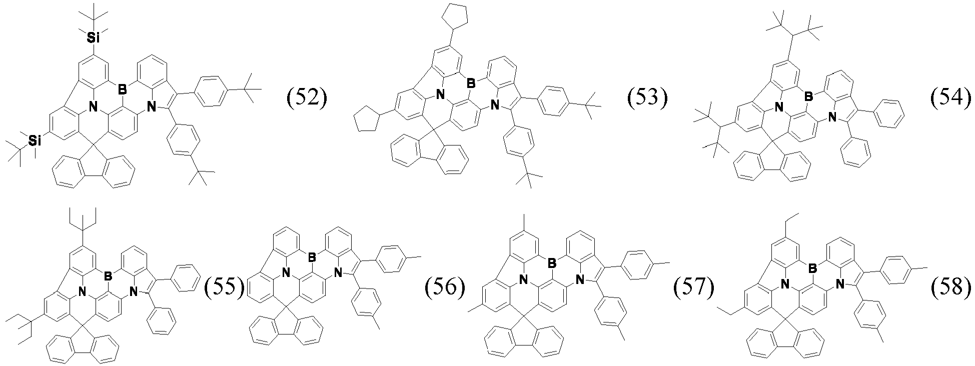

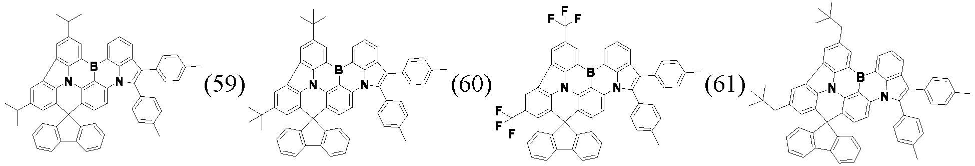

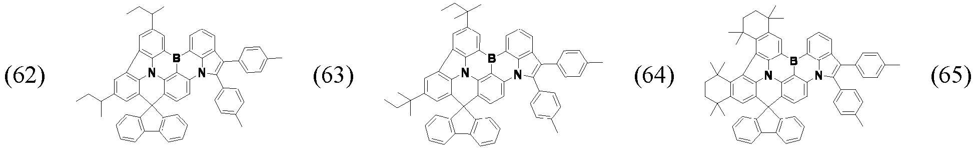

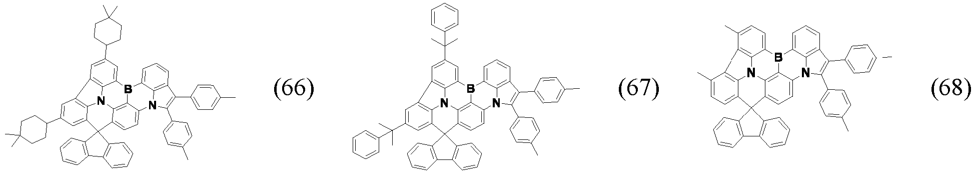

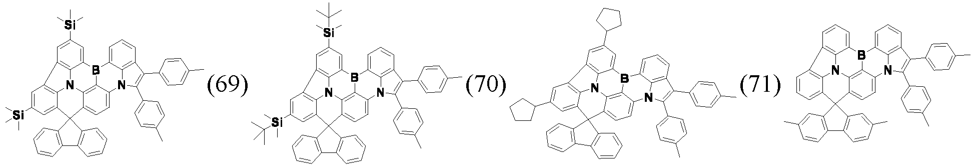

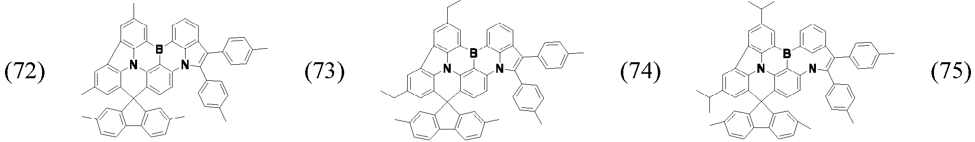

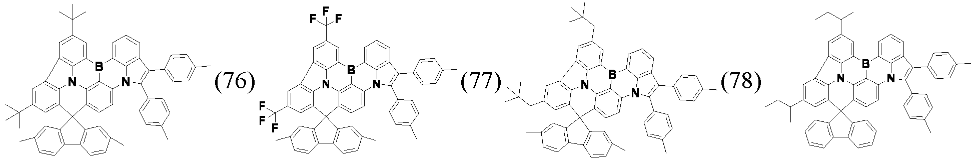

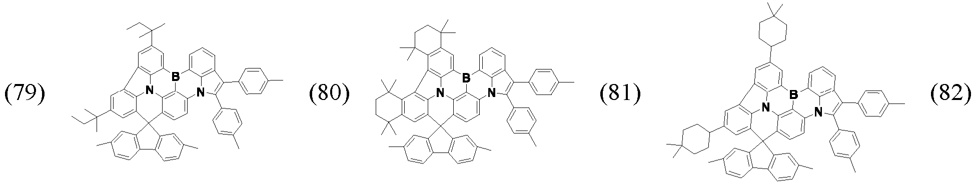

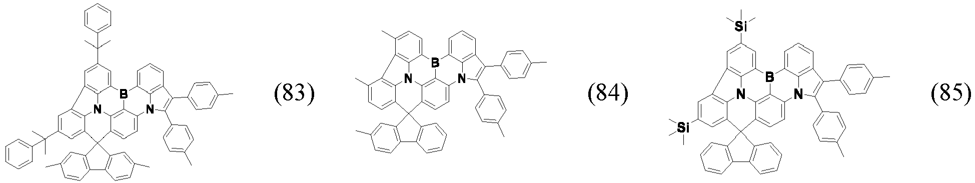

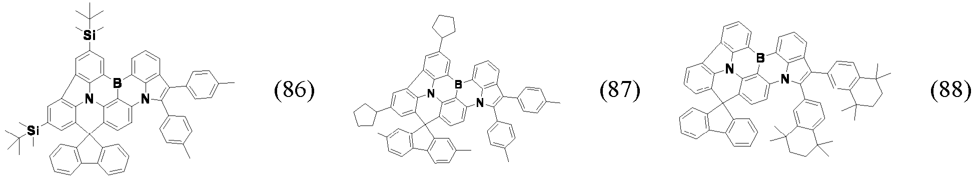

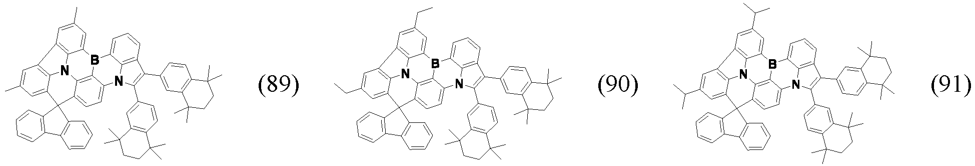

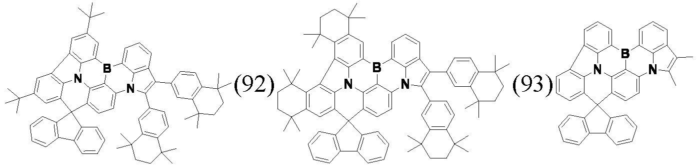

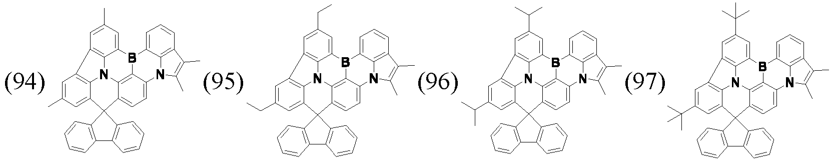

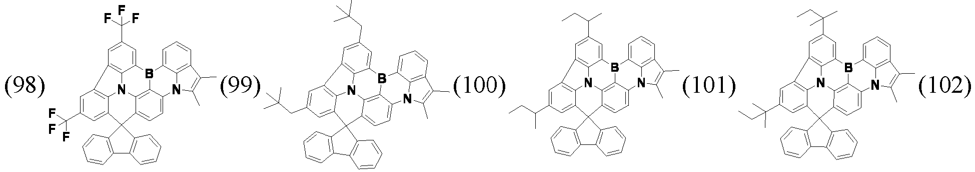

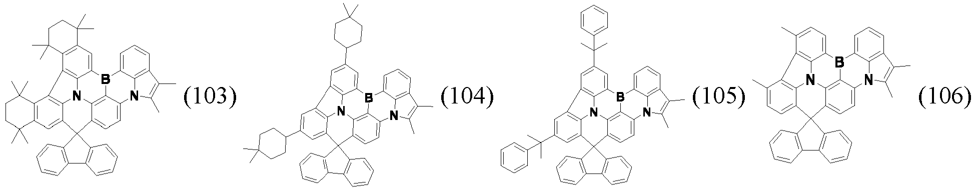

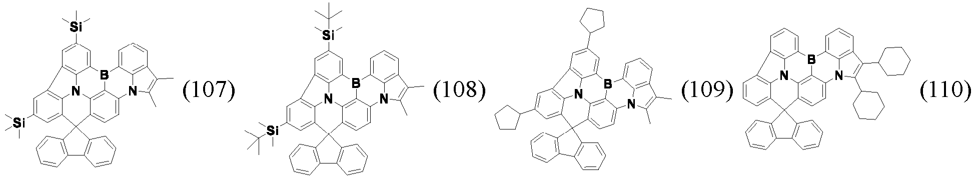

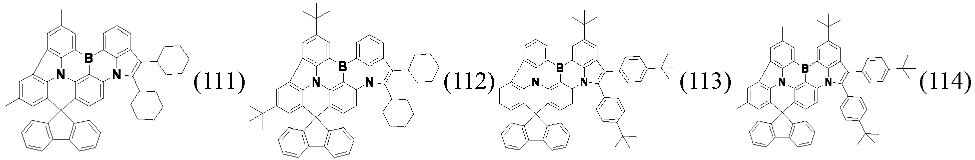

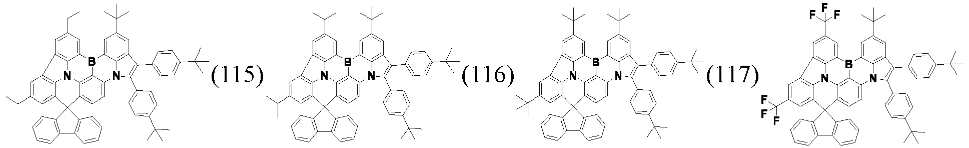

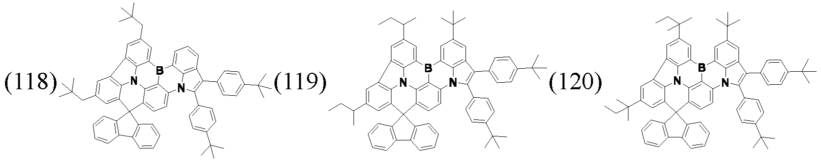

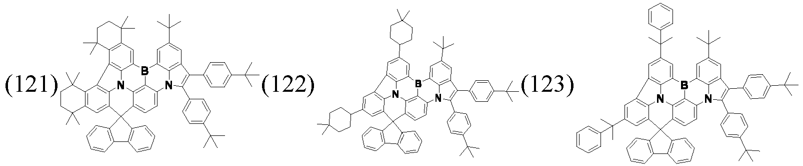

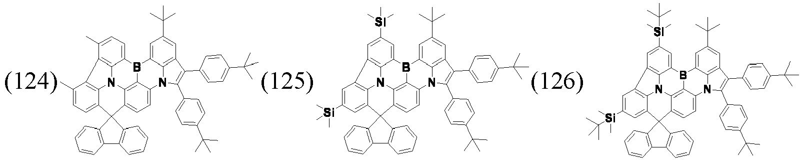

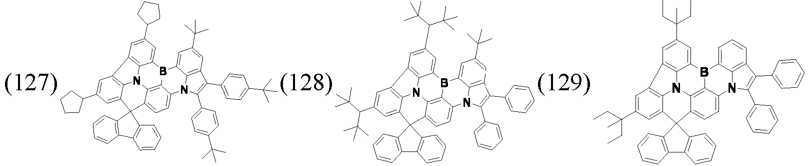

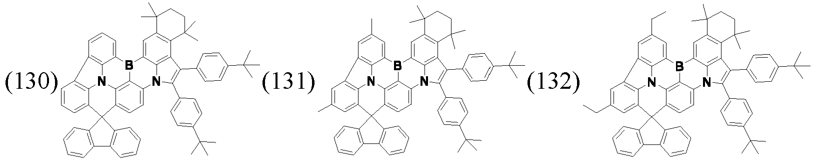

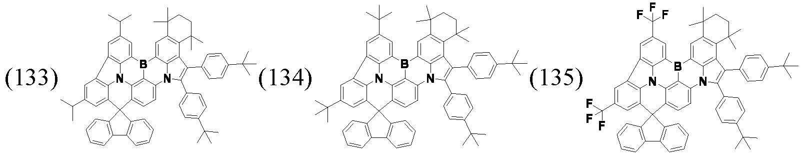

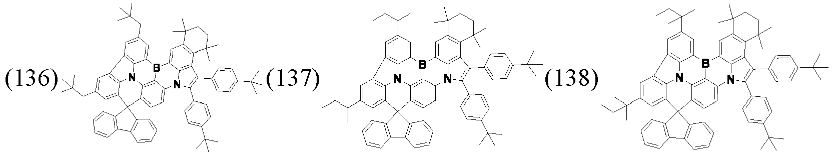

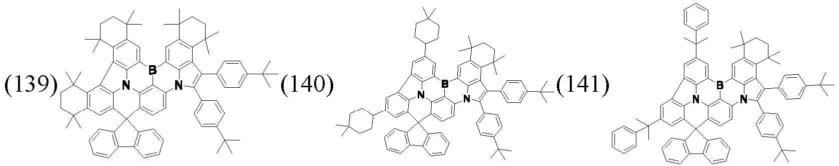

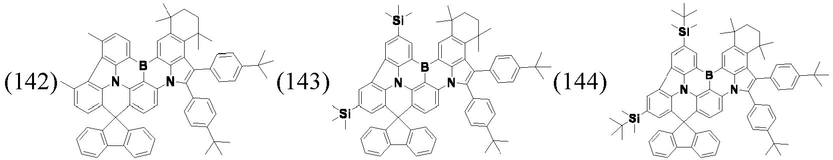

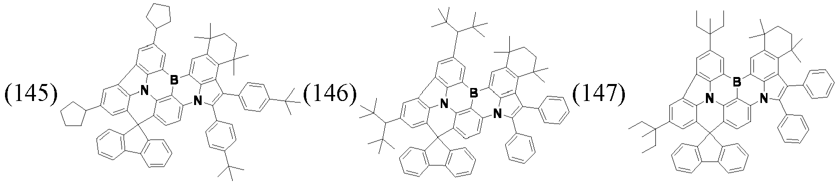

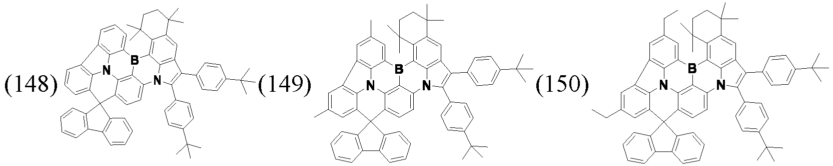

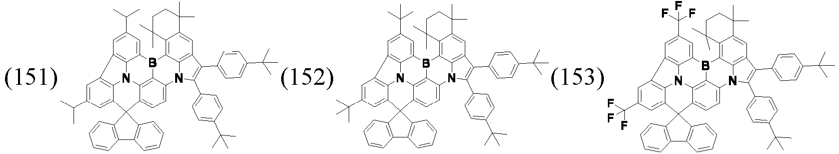

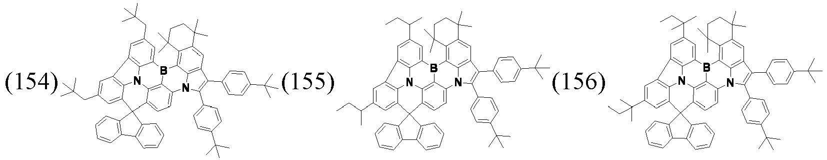

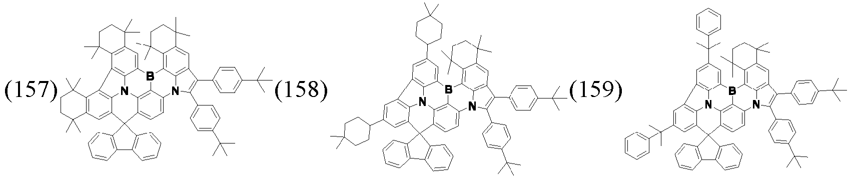

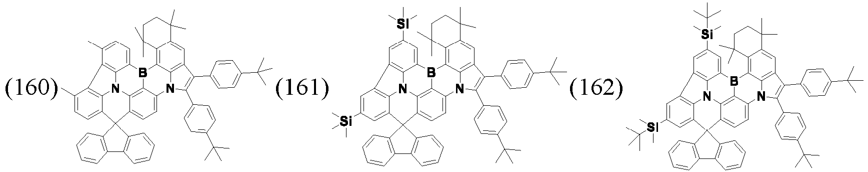

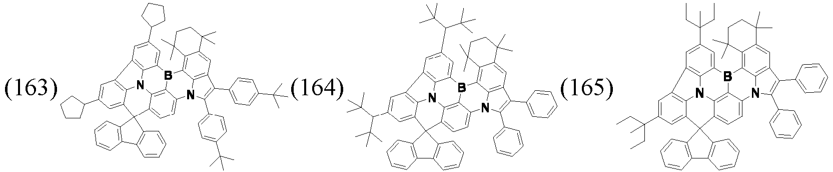

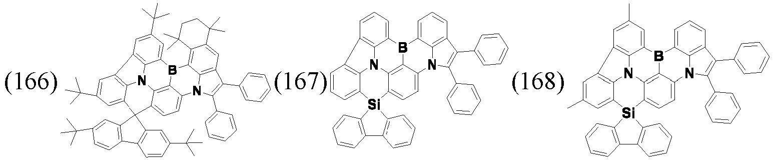

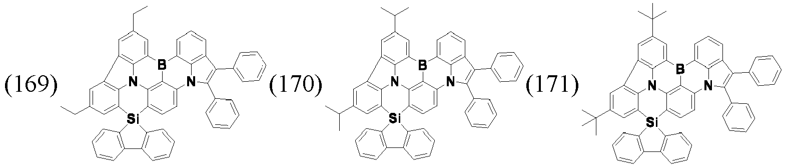

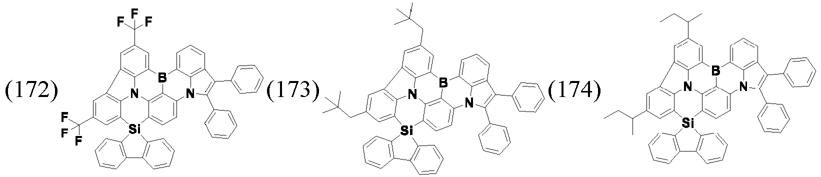

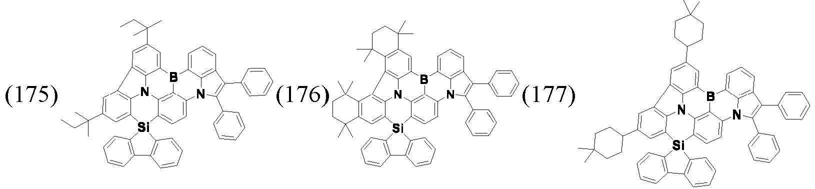

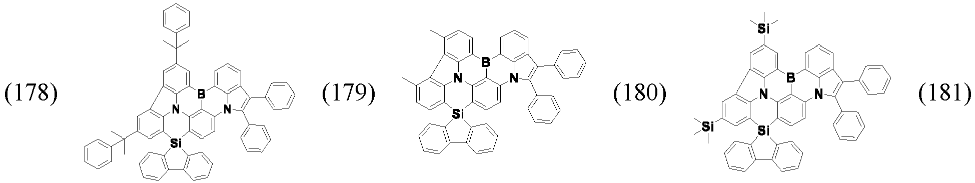

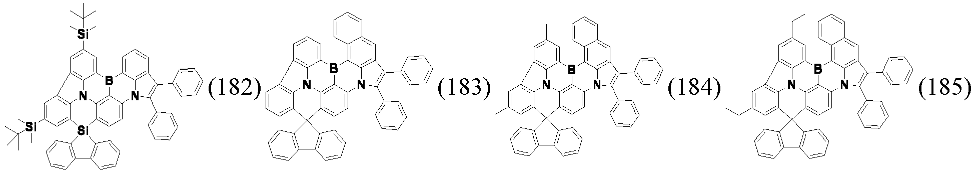

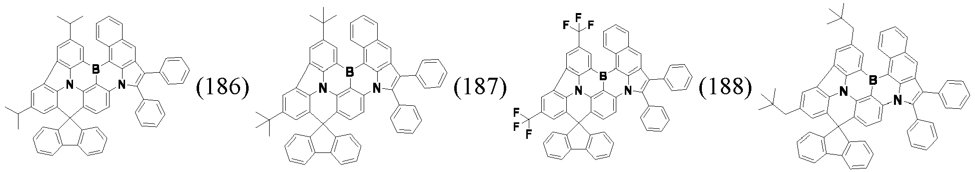

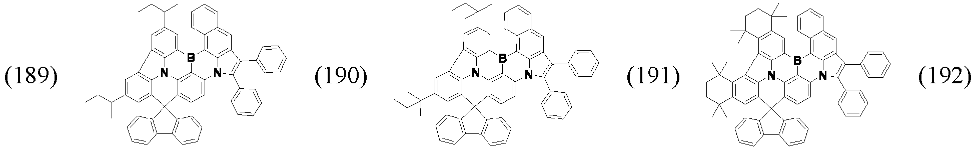

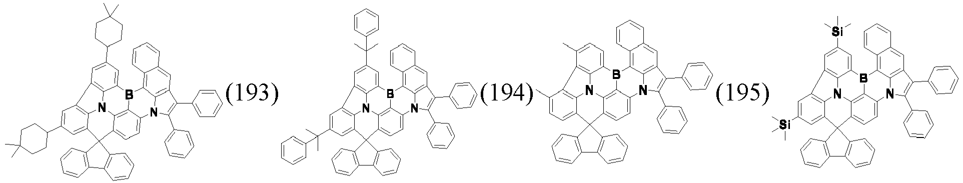

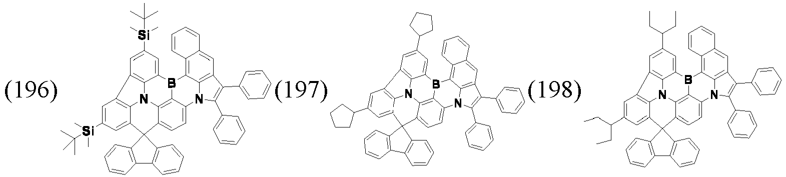

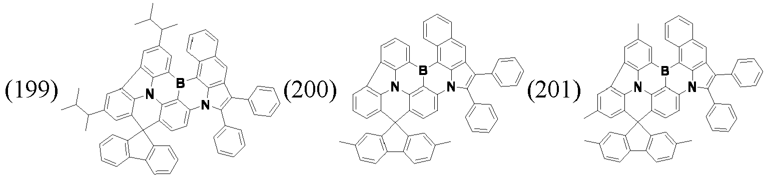

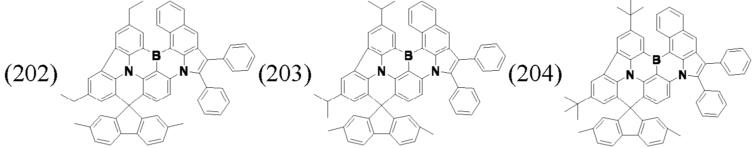

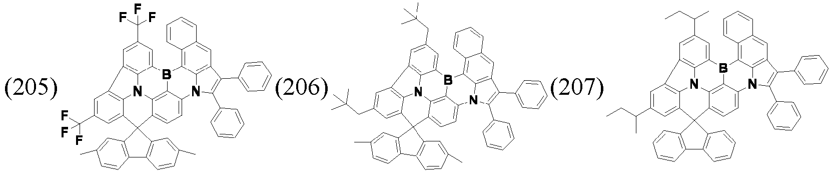

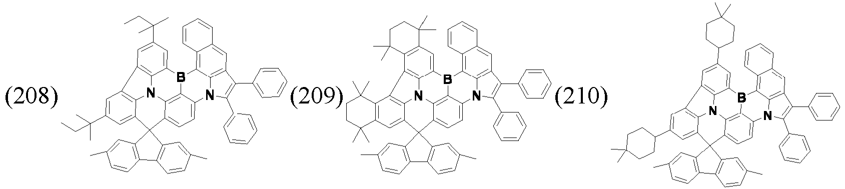

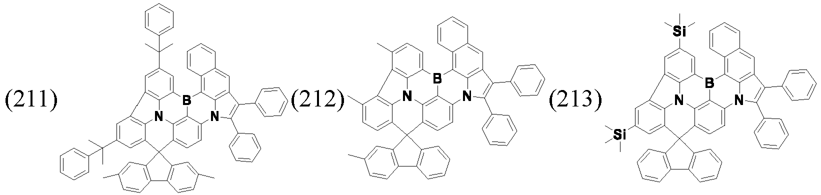

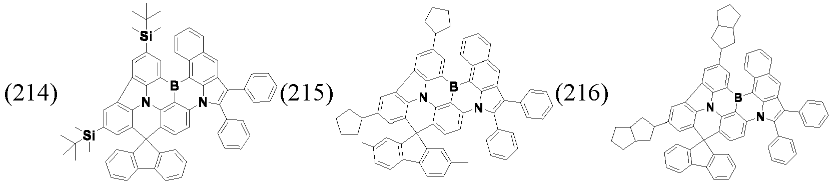

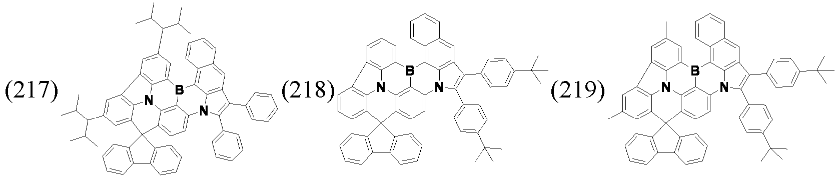

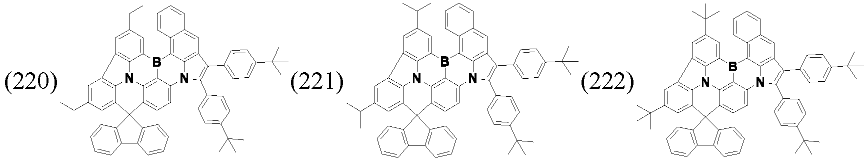

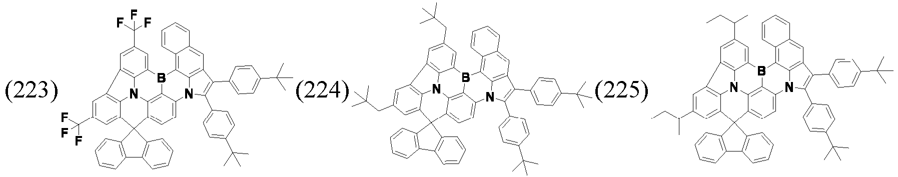

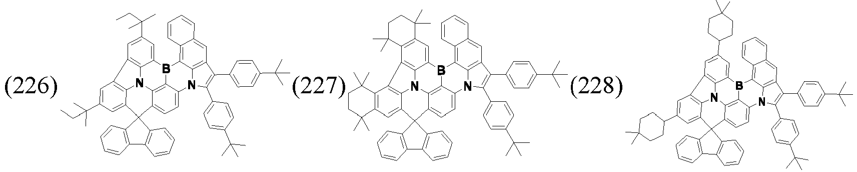

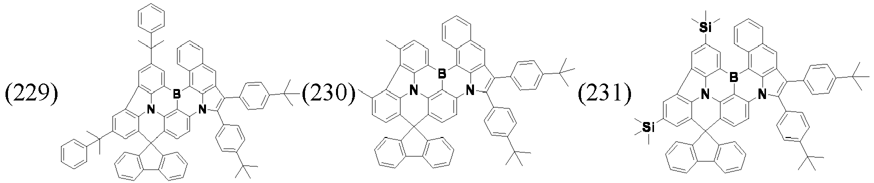

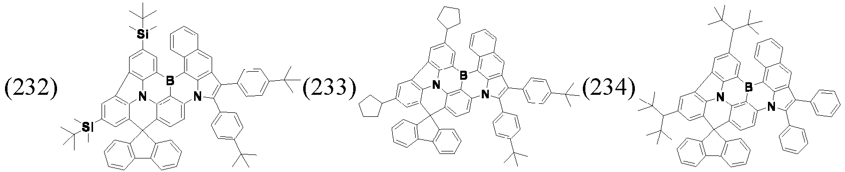

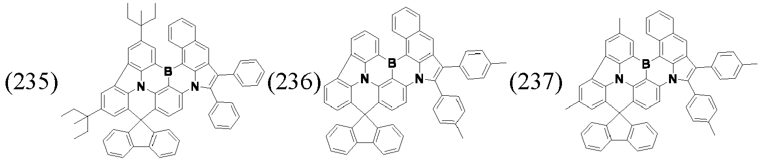

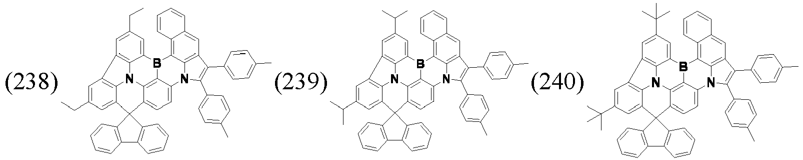

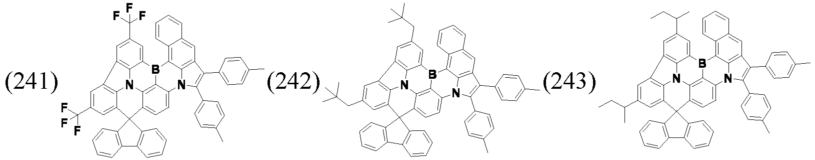

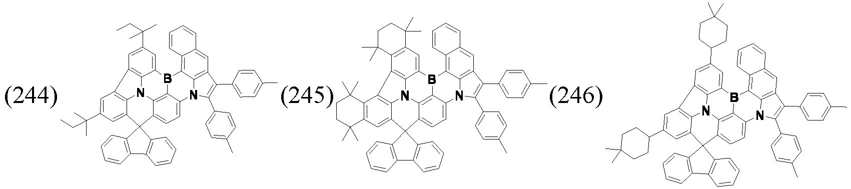

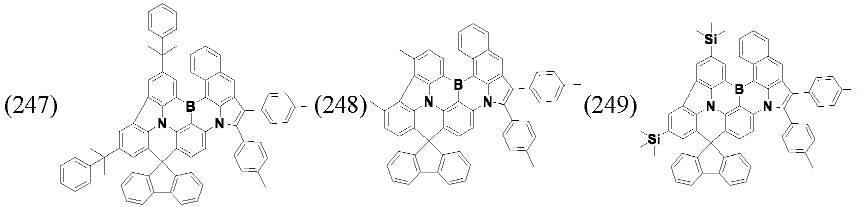

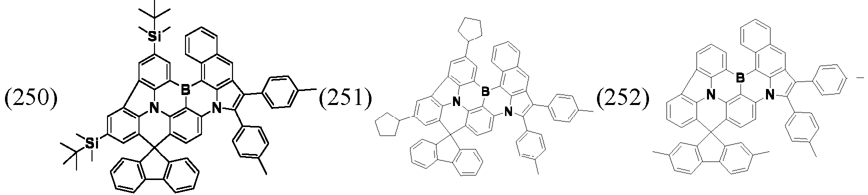

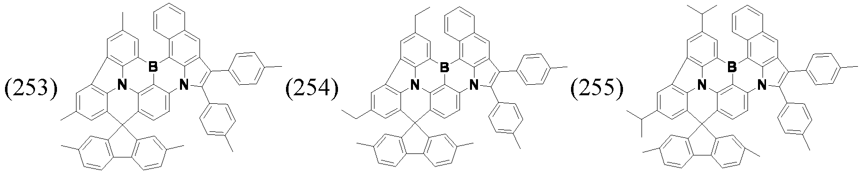

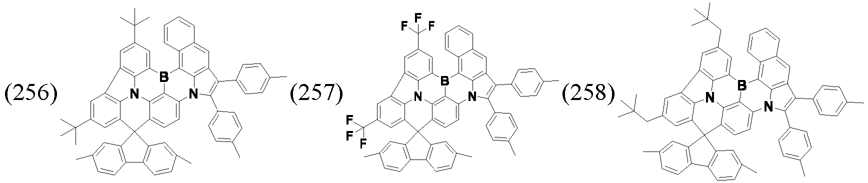

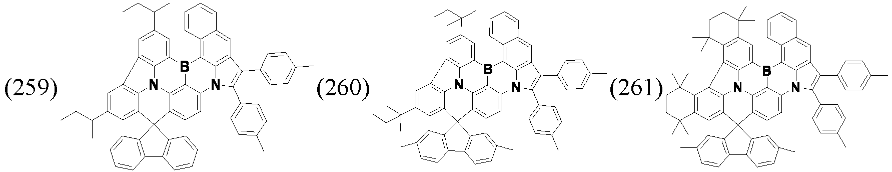

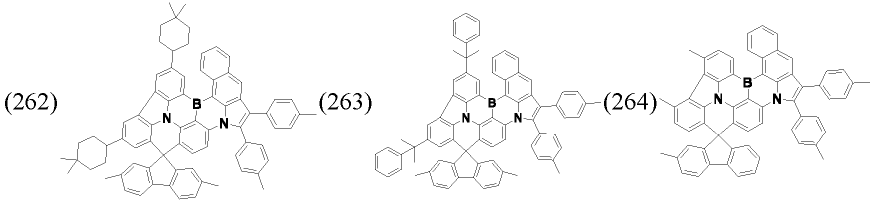

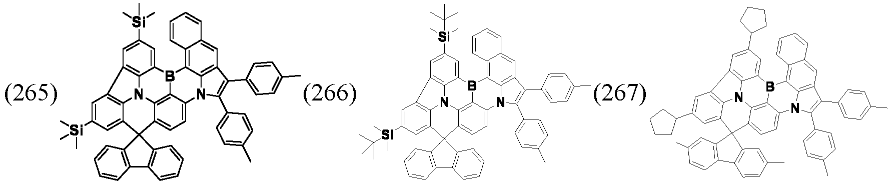

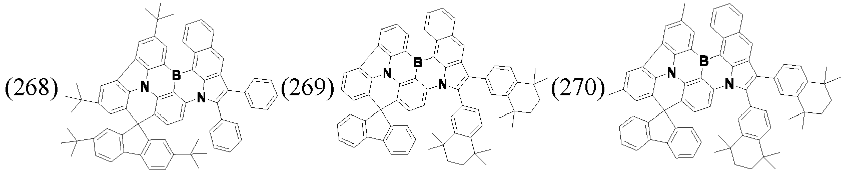

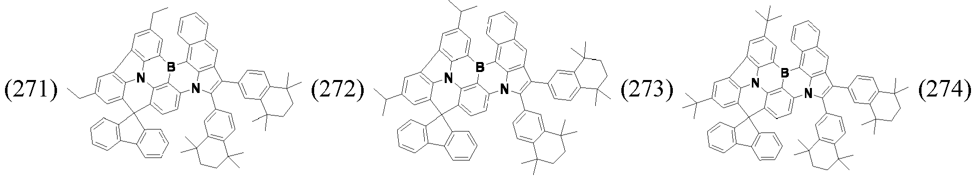

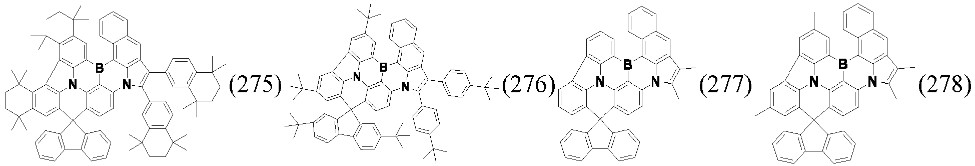

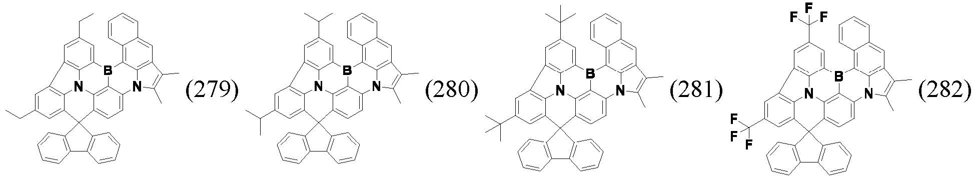

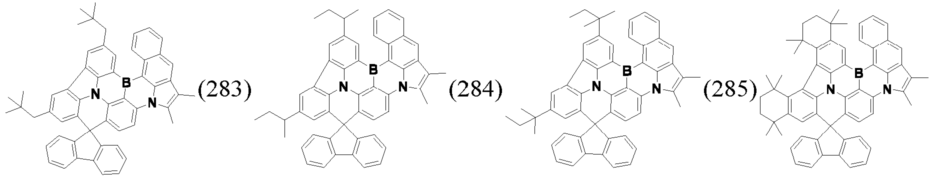

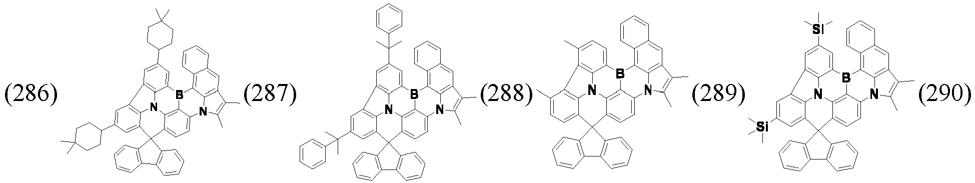

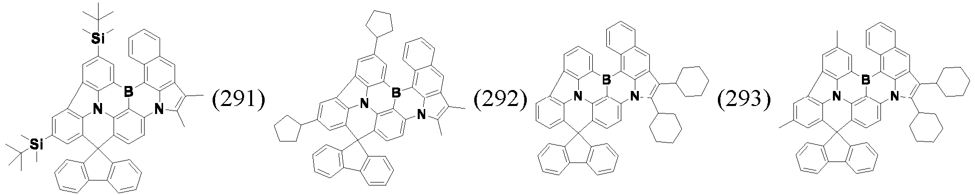

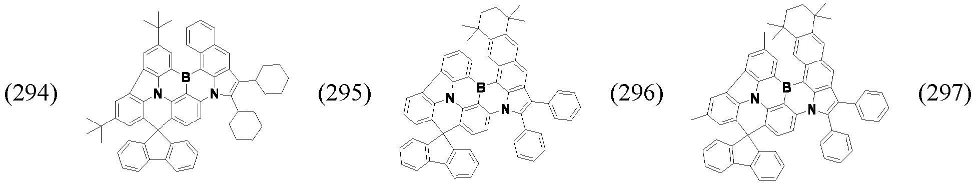

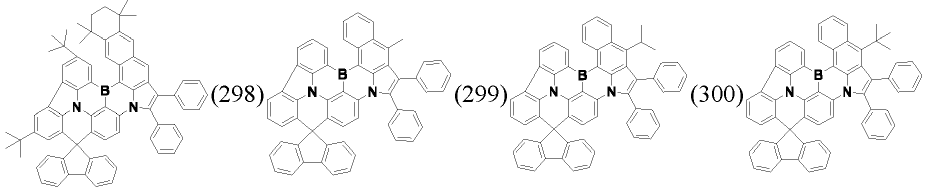

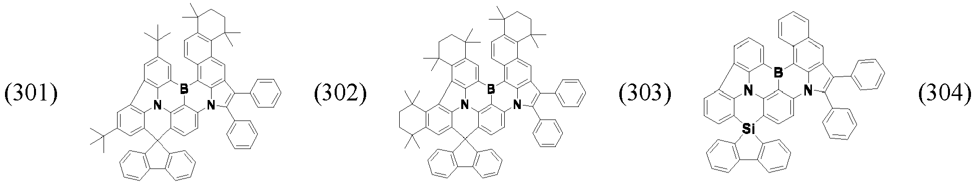

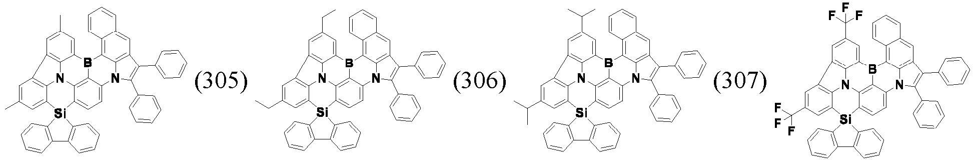

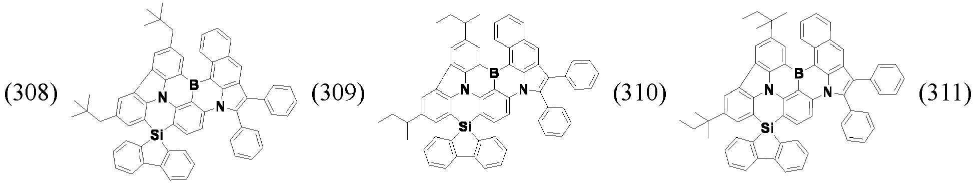

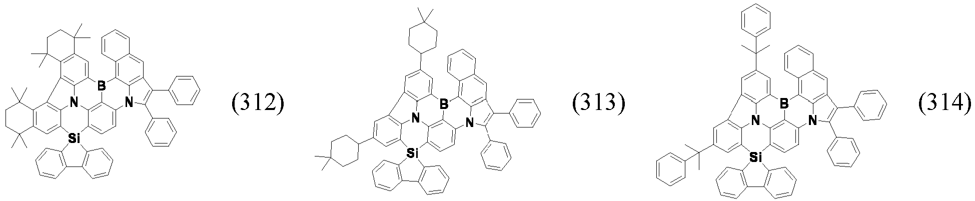

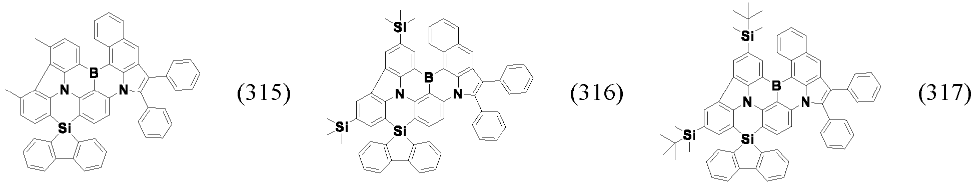

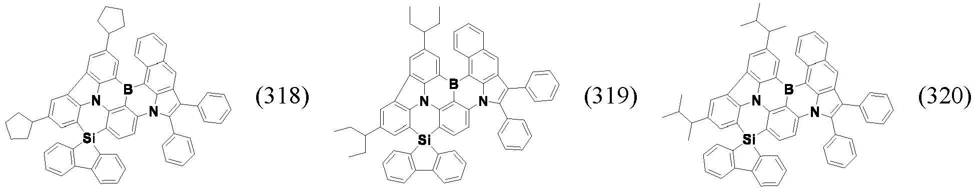

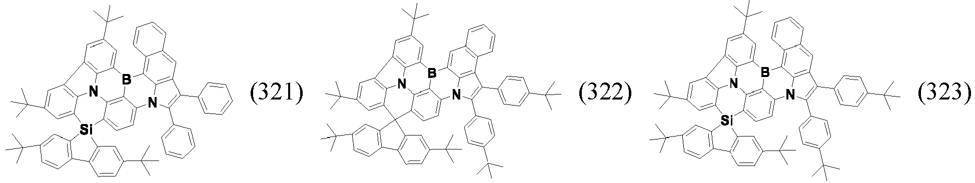

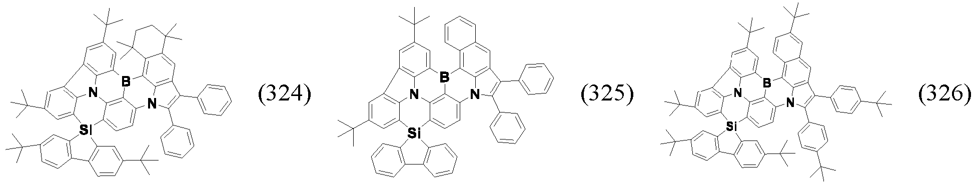

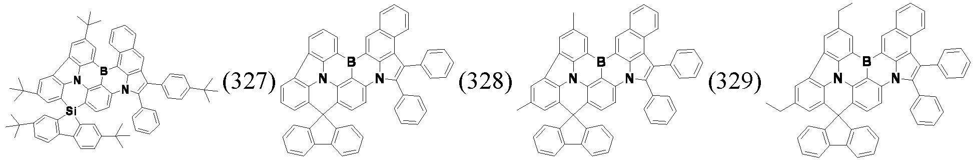

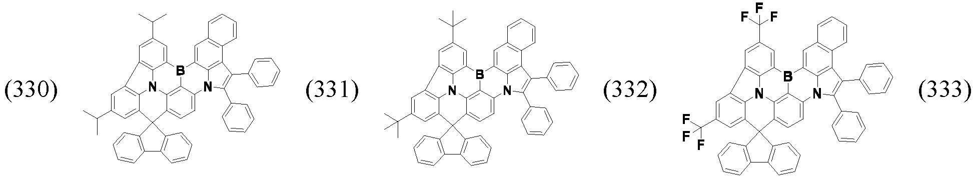

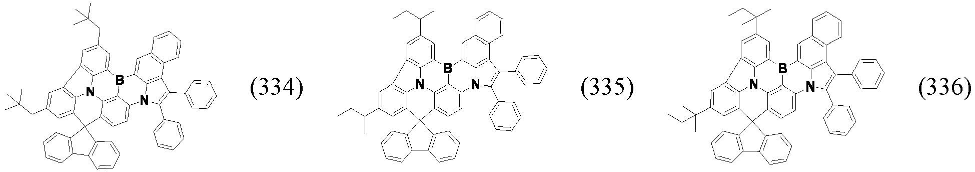

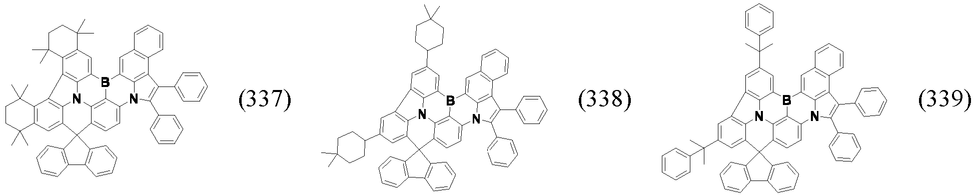

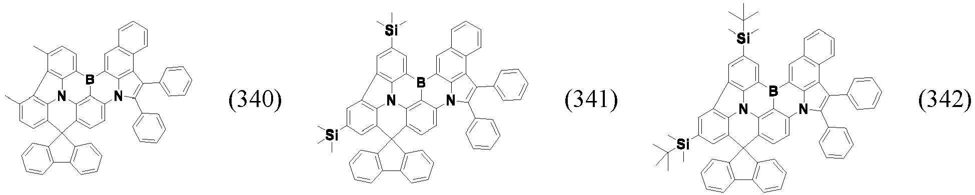

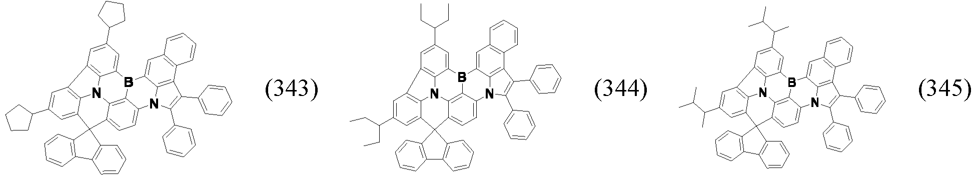

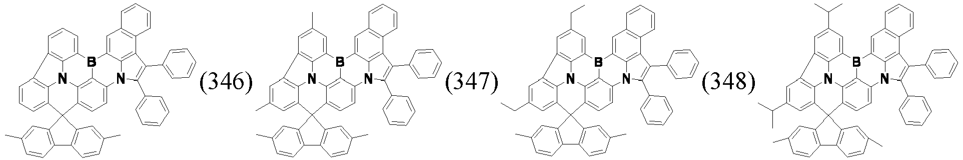

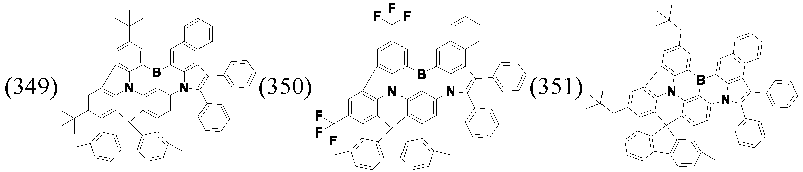

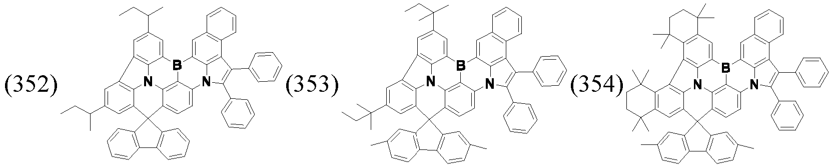

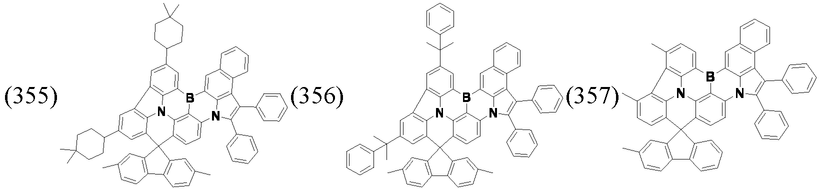

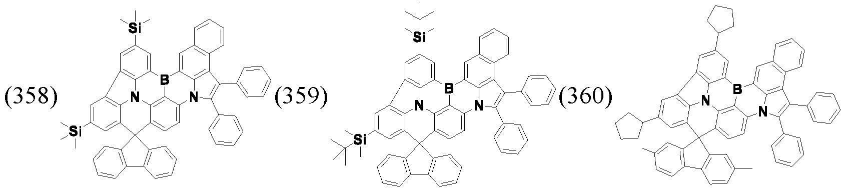

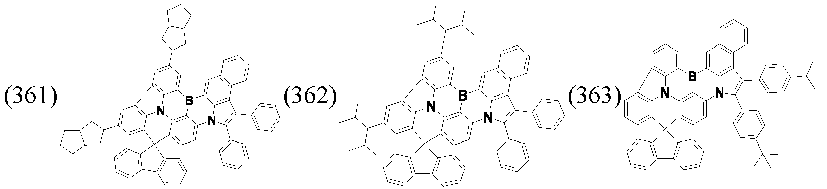

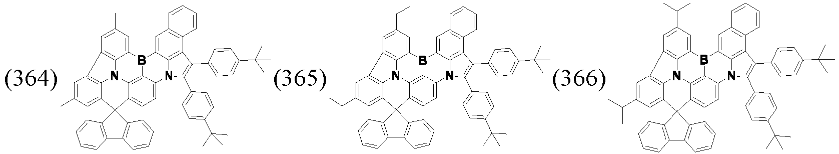

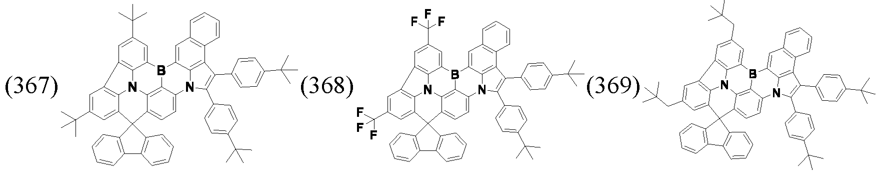

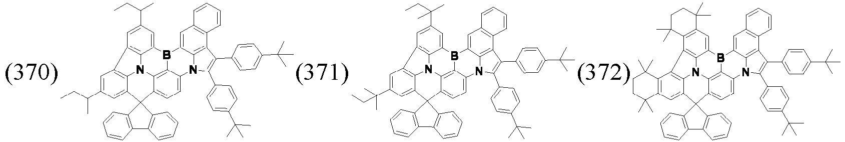

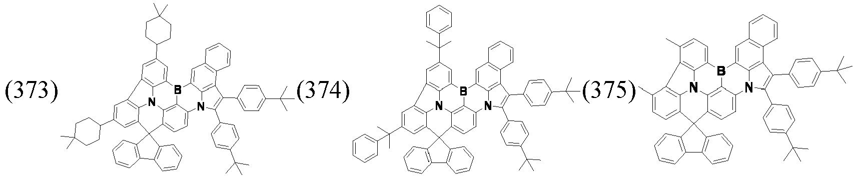

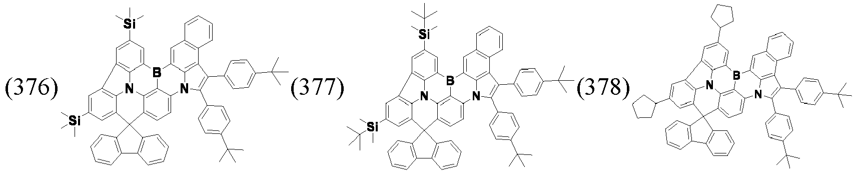

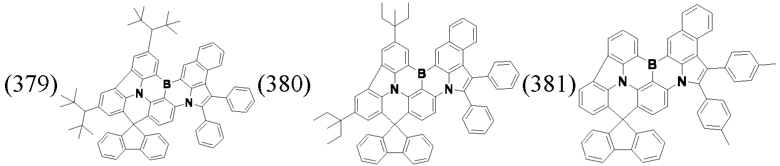

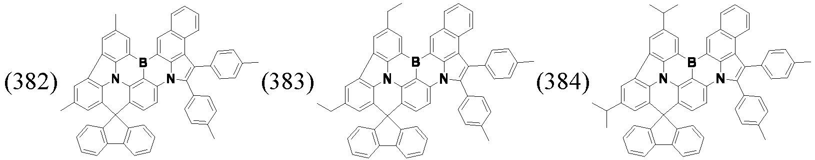

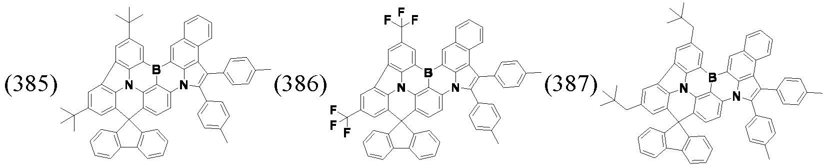

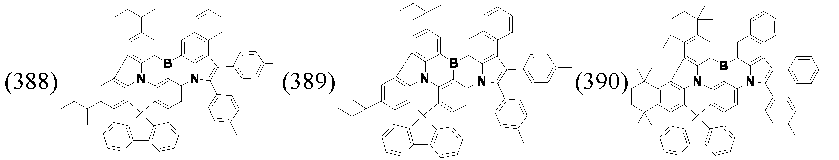

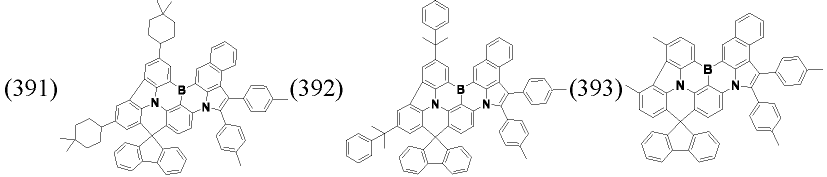

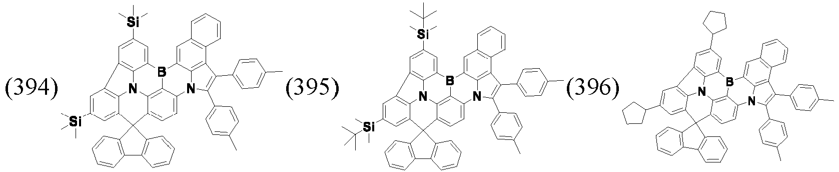

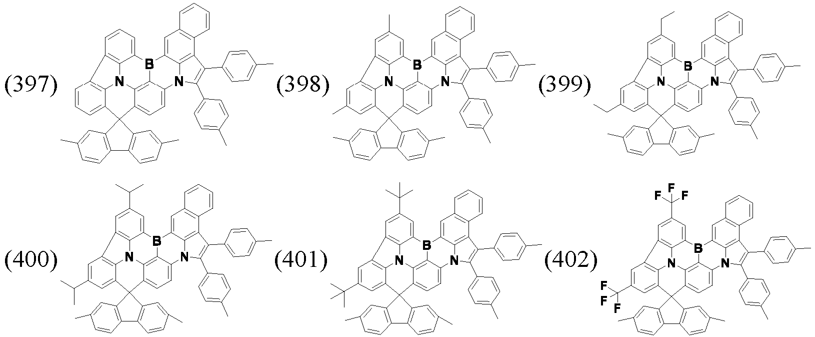

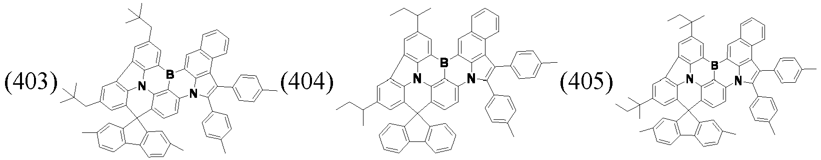

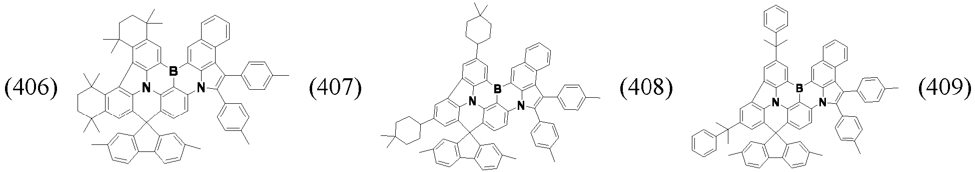

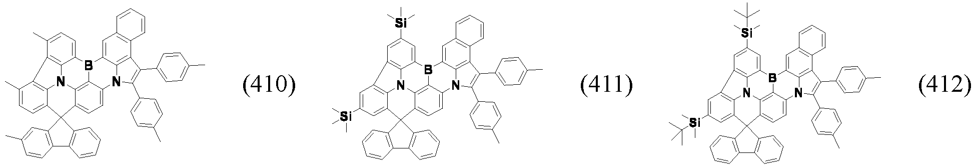

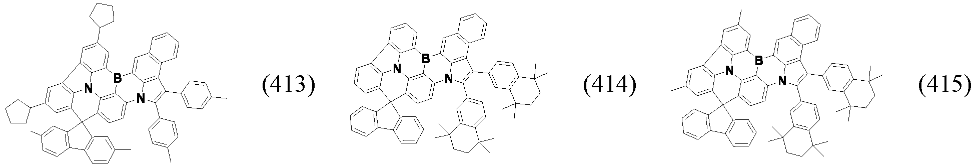

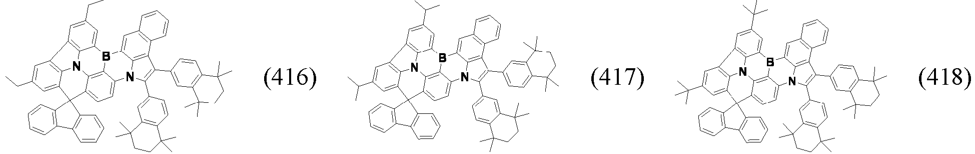

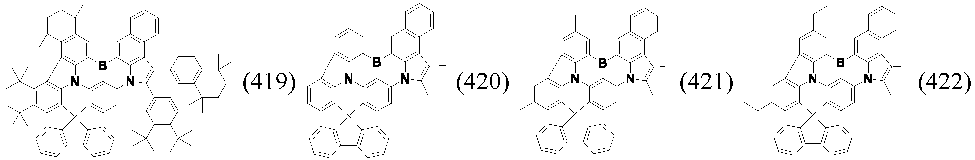

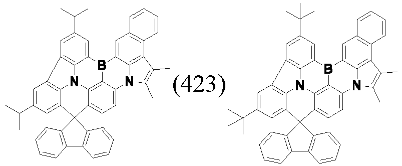

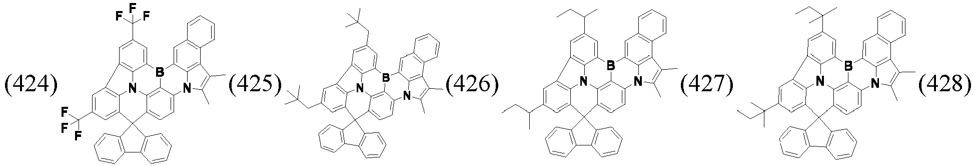

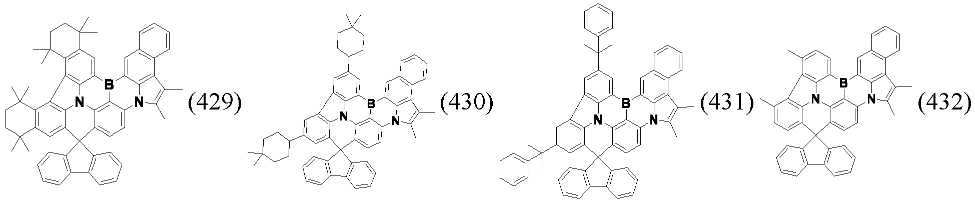

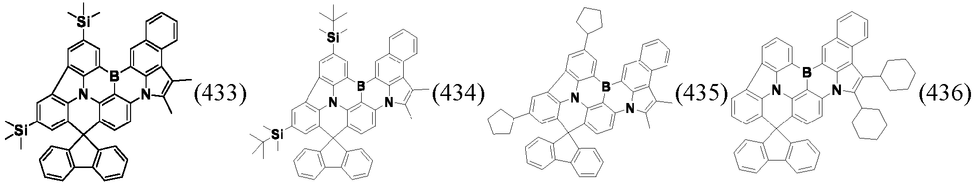

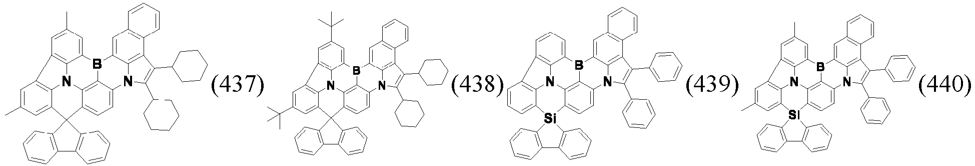

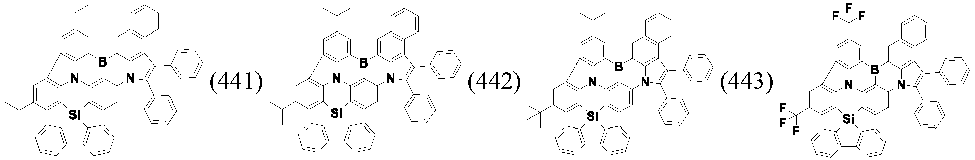

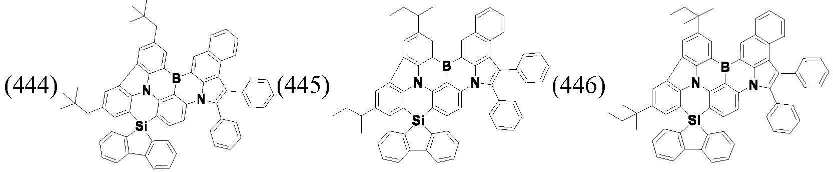

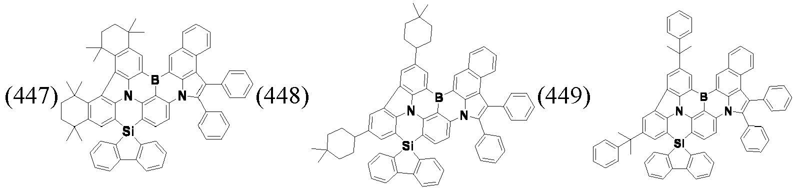

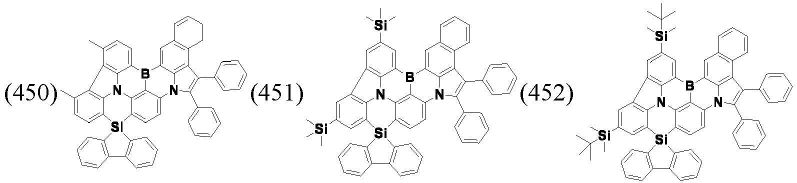

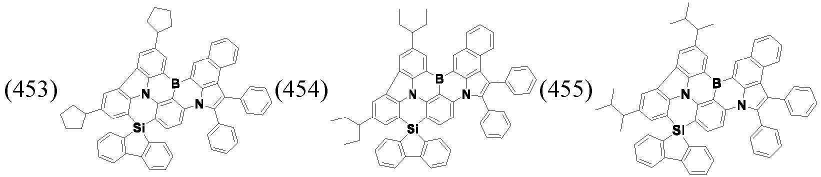

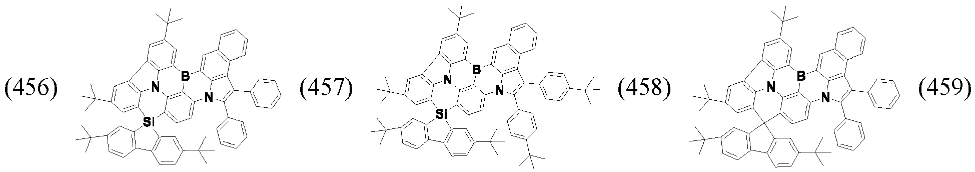

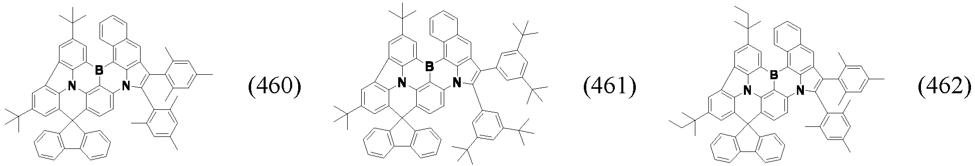

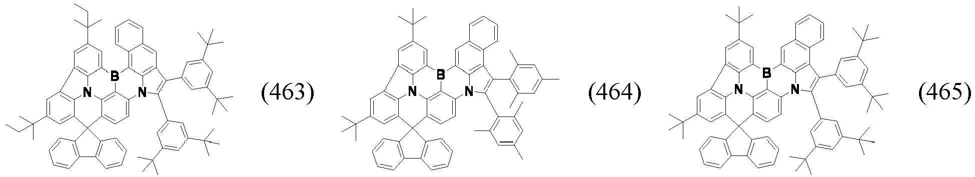

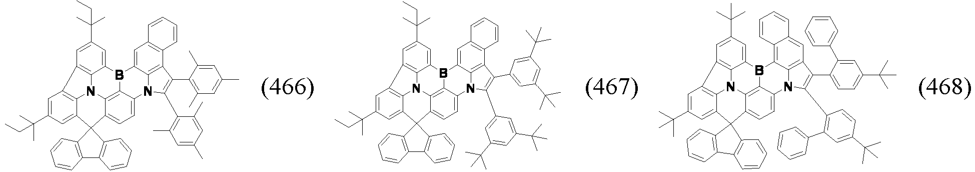

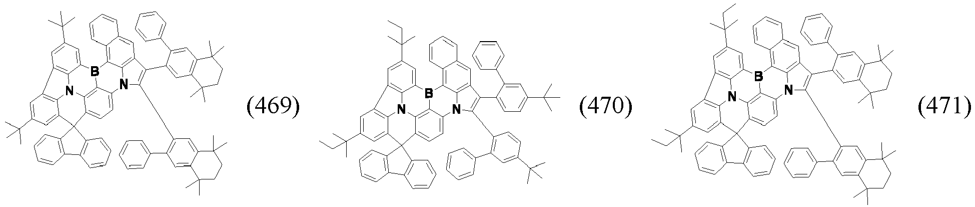

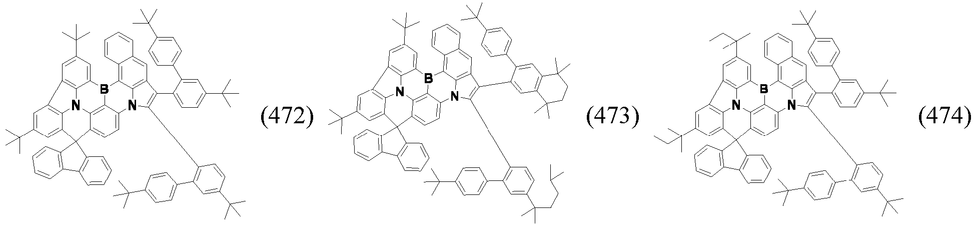

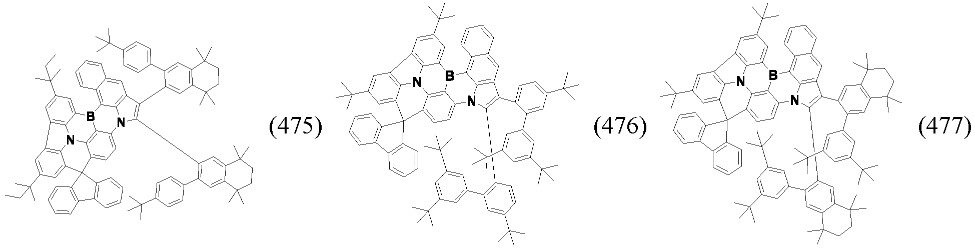

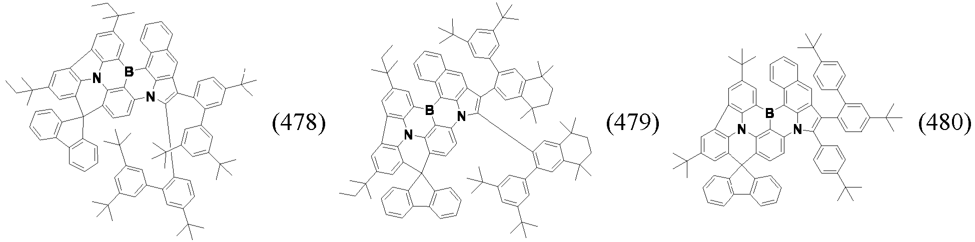

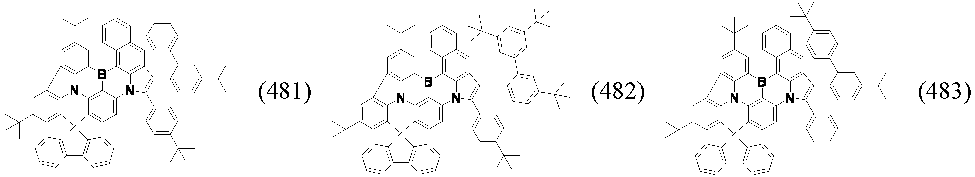

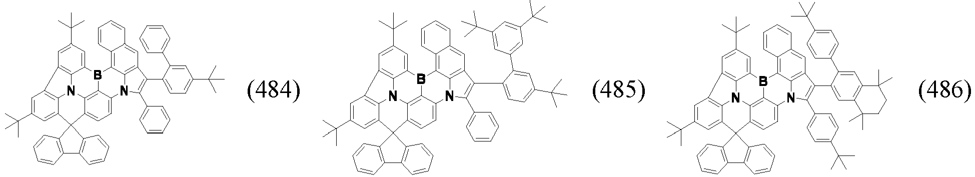

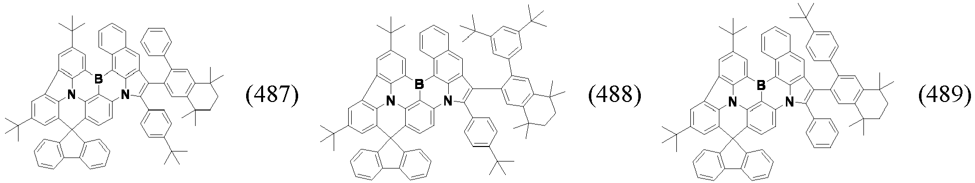

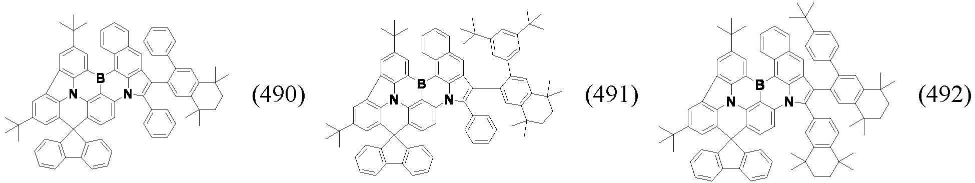

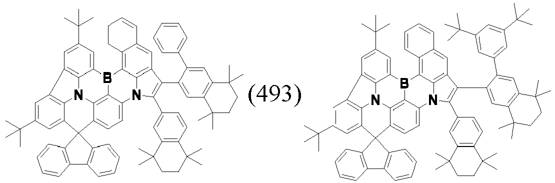

In a preferred solution, a specific structural formula of the boron-containing organic compound is any one of the following structures:

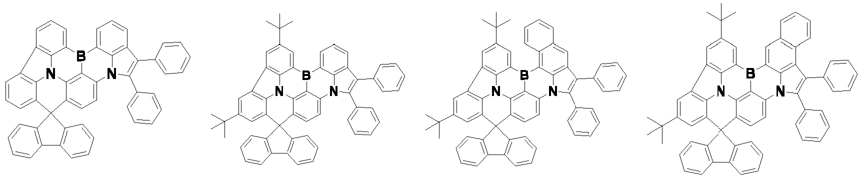

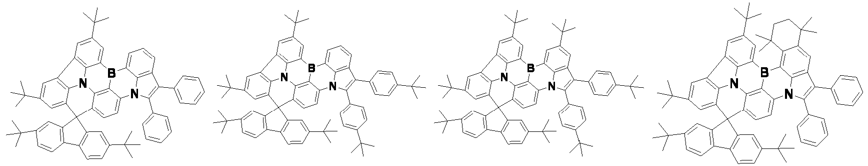

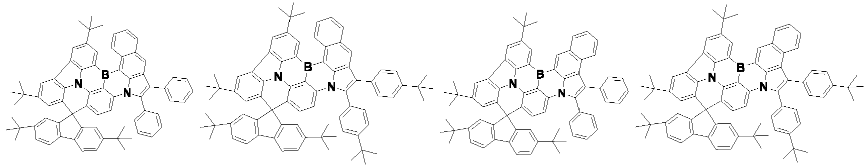

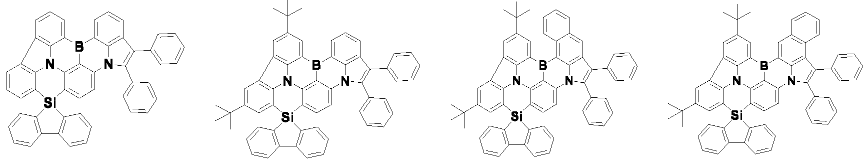

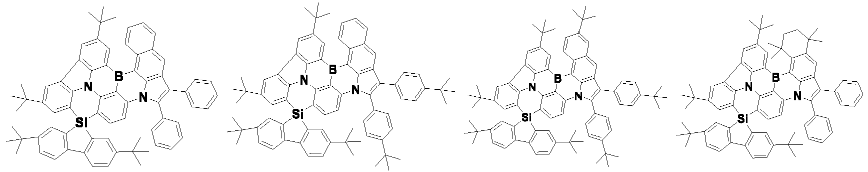

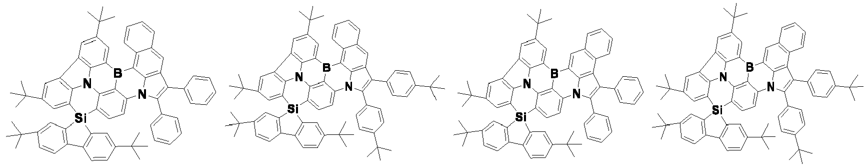

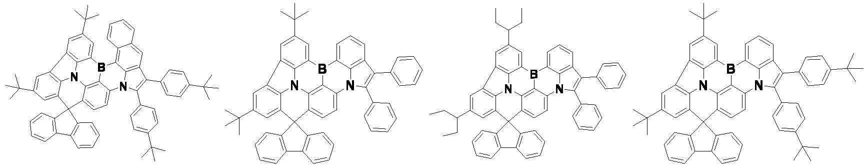

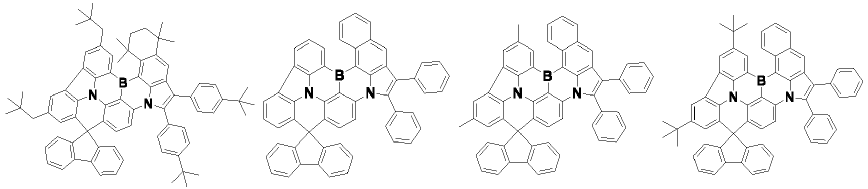

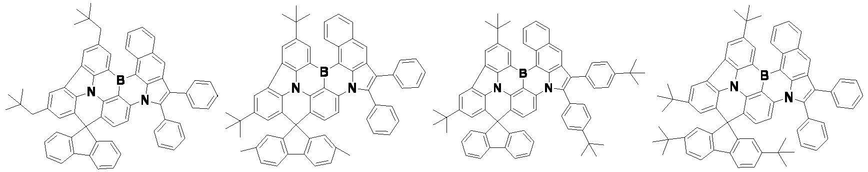

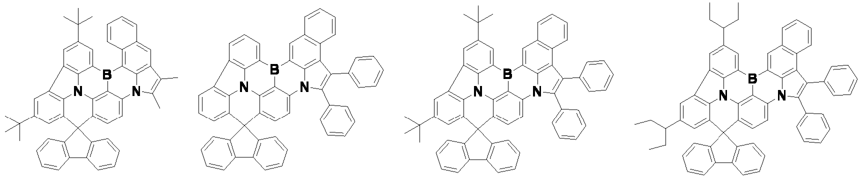

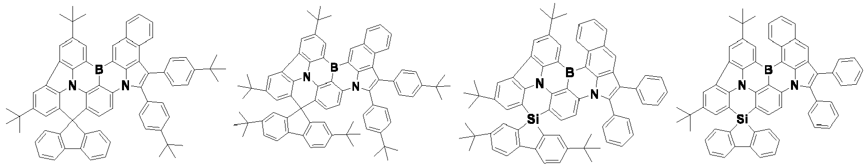

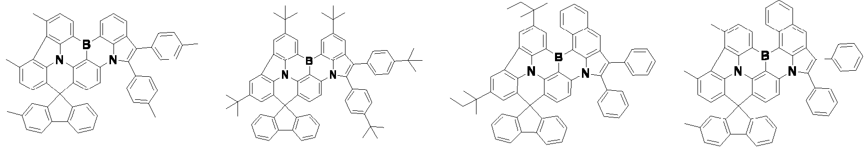

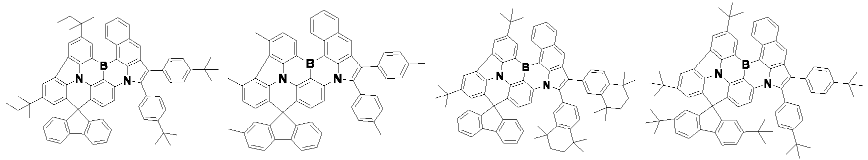

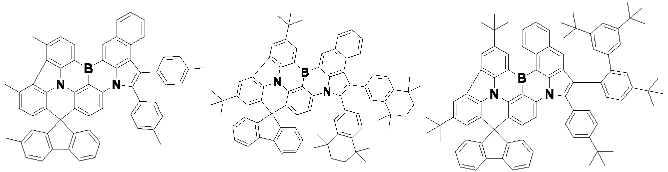

The present invention provides an organic electroluminescent device, including a cathode, an anode, and an organic light-emitting functional layer between the cathode and the anode, where the organic light-emitting functional layer includes a light-emitting layer, and the light-emitting layer includes the boron-containing organic compound.

In a preferred solution, the organic electroluminescent device sequentially includes a substrate, an anode, an organic light-emitting functional layer, and a cathode, where the organic light-emitting functional layer includes a light-emitting layer, and the light-emitting layer includes the boron-containing organic compound.

In a preferred solution, the organic electroluminescent device sequentially includes a substrate, a cathode, an organic light-emitting functional layer, and an anode, where the organic light-emitting functional layer includes a light-emitting layer, and the light-emitting layer includes the boron-containing organic compound.

In a preferred solution, the light-emitting layer includes a host material and a doping material, and the doping material includes the boron-containing organic compound.

In a preferred solution, the light-emitting layer includes a first host material, a second host material, and a doping material, at least one of the first host material and the second host material is a TADF material, and the doping material is the boron-containing organic compound.

In a preferred solution, the light-emitting layer includes a host material, an exciton-sensitizing material, and a doping material, the exciton-sensitizing material is a complex containing a metal element, and the doping material is the boron-containing organic compound.

Provided is a material for an organic electroluminescent device, including the boron-containing organic compound described above in the present invention.

Provided is use of the boron-containing organic compound in an organic electroluminescent device.

In a preferred solution, an organic light-emitting functional layer includes a light-emitting layer, and the boron-containing organic compound in the present invention is used in the light-emitting layer.

Provided is a display component, including the organic electroluminescent device in the present invention.

Provided is a lighting apparatus, including the organic electroluminescent device in the present invention.

Provided is an electronic device, carrying the organic electroluminescent device in the present invention.

The present invention has the following beneficial technical effects:
(1) The compound of the present invention can be used as a doping material for a light-emitting layer material when used in an OLED device, can exhibit green fluorescence under the action of an electric field, and can be used in the field of OLED lighting or OLED display.
(2) The compound of the present invention, as a doping material, can significantly improve a lifetime of a device.

### BRIEF DESCRIPTION OF DRAWINGS

FIG. 1 is a diagram of a structure of materials that are listed in the present invention and that are used in an OLED device, where
   1 is a transparent substrate layer, 2 is an anode layer, 3 is a hole injection layer, 4 is a hole transport layer, 5 is an electron blocking layer, 6 is a light-emitting layer, 7 is hole blocking layer, 8 is an electron transport layer, 9 is an electron injection layer, and 10 is a cathode layer;
FIG. 2 shows a spectrum of compound 222;
FIG. 3 shows a nuclear magnetic resonance spectrum of compound 222;
FIG. 4 shows a spectrum of compound 186;
FIG. 5 shows a nuclear magnetic resonance spectrum of compound 186;
FIG. 6 shows a spectrum of compound 226;
FIG. 7 shows a nuclear magnetic resonance spectrum of compound 226;
FIG. 8 shows a nuclear magnetic resonance spectrum of compound 273;
FIG. 9 shows a mass spectrum of compound 273;
FIG. 10 shows a nuclear magnetic resonance spectrum of compound 116;
FIG. 11 shows a nuclear magnetic resonance spectrum of compound 190;
FIG. 12 shows a nuclear magnetic resonance spectrum of compound 275;
FIG. 13 shows a nuclear magnetic resonance spectrum of compound 331; and
FIG. 14 shows a nuclear magnetic resonance spectrum of compound 367.

### DESCRIPTION OF EMBODIMENTS

The following clearly and completely describes the technical solutions in embodiments of the present invention with reference to the accompanying drawings in embodiments of the present invention. Embodiments of the present invention and features in embodiments may be mutually combined in the case of no conflict. The following further describes the present invention with reference to the accompanying drawings and specific embodiments, but is not intended to limit the present invention.

In the present invention, when an electrode, an organic electroluminescent device, and another structure are described, words such as "upper", "lower", "top", and "bottom" that are used to represent orientations only represent orientations in a particular state, but do not mean that a related structure can only exist according to the orientations. On the contrary, if the structure can change in position, for example, be inverted, the orientations of the structure change correspondingly. Specifically, in the present invention, a "bottom" or "lower" side of an electrode is a side that is of the electrode and that is close to a substrate in a preparation process, and an opposite side that is away from the substrate is a "top" or "upper" side.

In the present invention, substituted or unsubstituted C₆-C₃₀ aryl is substituted or unsubstituted phenyl, substituted or unsubstituted naphthyl, substituted or unsubstituted anthryl, substituted or unsubstituted fluorenyl, substituted or unsubstituted dimethylfluorenyl, substituted or unsubstituted diphenylfluorenyl, substituted or unsubstituted spirofluorenyl, substituted or unsubstituted phenanthryl, substituted or unsubstituted fused tetraphenyl, substituted or unsubstituted pyrenyl, substituted or unsubstituted diphenyl, substituted or unsubstituted p-terphenyl, substituted or unsubstituted m-terphenyl, substituted or unsubstituted chrysenyl, substituted or unsubstituted diphenylphenyl, substituted or unsubstituted perylenyl, or substituted or unsubstituted indenyl, but is not limited thereto.

In the present invention, substituted or unsubstituted C₂-C₃₀ heteroaryl is substituted or unsubstituted furyl, substituted or unsubstituted thienyl, substituted or unsubstituted pyrrolyl, substituted or unsubstituted pyrazolyl, substituted or unsubstituted imidazolyl, substituted or unsubstituted triazolyl, substituted or unsubstituted oxazolyl, substituted or unsubstituted thiazolyl, substituted or unsubstituted oxadiazolyl, substituted or unsubstituted thiadiazolyl, substituted or unsubstituted pyridinyl, substituted or unsubstituted pyrimidinyl, substituted or unsubstituted pyrazinyl, substituted or unsubstituted triazinyl, substituted or unsubstituted benzofuryl, substituted or unsubstituted benzothienyl, substituted or unsubstituted benzimidazolyl, substituted or unsubstituted indolyl, substituted or unsubstituted quinolyl, substituted or unsubstituted isoquinolyl, substituted or unsubstituted quinazolinyl, substituted or unsubstituted quinoxalinyl, substituted or unsubstituted naphthyridinyl, substituted or unsubstituted benzoxazinyl, substituted or unsubstituted benzothiazinyl, substituted or unsubstituted acridinyl, substituted or unsubstituted phenazinyl, substituted or unsubstituted phenothiazinyl, substituted or unsubstituted phenoxazinyl, substituted or unsubstituted fluorenyl, substituted or unsubstituted dibenzofuryl, substituted or unsubstituted dibenzothienyl, substituted or unsubstituted carbazolyl, a combination thereof, or a fused ring of a combination of the foregoing groups, but is not limited thereto.

The C₁-C₁₀ alkyl (including linear alkyl and branched alkyl) in the present invention is methyl, ethyl, propyl, isopropyl, butyl, tert-butyl, isobutyl, sec-butyl, neo-pentyl, n-pentyl, isopentyl, octyl, heptyl, n-decyl, 1-methylpentyl, 2-methylpentyl, 3-methylpentyl, or 1-butylpentyl, but is not limited thereto.

The C₃-C₁₀ cycloalkyl in the present invention is a monovalent monocyclic saturated hydrocarbyl group containing 3 to 10 carbon atoms as ring-forming atoms. In this specification, C₄-C₉ cycloalkyl is preferred, more preferably C₅-C₈ cycloalkyl, particularly preferably C₅-C₇ cycloalkyl. Non-limiting examples thereof may include cyclopropyl, cyclobutyl, cyclopentyl, cyclohexyl, 4-methylcyclohexyl, 4,4-dimethylcyclohexyl, adamantyl, and cycloheptyl, but are not limited thereto.

In the present invention, substituted or unsubstituted C₅-C₃₀ heteroaryl is substituted or unsubstituted pyridinyl, substituted or unsubstituted pyrimidinyl, substituted or unsubstituted pyrazinyl, substituted or unsubstituted triazinyl, substituted or unsubstituted benzofuryl, substituted or unsubstituted benzothienyl, substituted or unsubstituted benzimidazolyl, substituted or unsubstituted indolyl, substituted or unsubstituted quinolyl, substituted or unsubstituted isoquinolyl, substituted or unsubstituted quinazolinyl, substituted or unsubstituted quinoxalinyl, substituted or unsubstituted naphthyridinyl, substituted or unsubstituted benzoxazinyl, substituted or unsubstituted benzothiazinyl, substituted or unsubstituted acridinyl, substituted or unsubstituted phenazinyl, substituted or unsubstituted phenothiazinyl, substituted or unsubstituted phenoxazinyl, substituted or unsubstituted fluorenyl, substituted or unsubstituted dibenzofuryl, substituted or unsubstituted dibenzothienyl, substituted or unsubstituted carbazolyl, a combination thereof, or a fused ring of a combination of the foregoing groups, but is not limited thereto.

The C1-C10 alkenyl in the present invention is preferably C2-C8 alkenyl, more preferably C2-C5 alkenyl. Non-limiting examples thereof may include ethenyl, propenyl, isobutenyl, n-pentenyl, isopentenyl, neo-pentenyl, 1-butenyl, 2-butenyl, 3-butenyl, 1,3-butadienyl, 1-methylethenyl, styryl, 2,2-diphenylethenyl, 1,2-diphenylethenyl, 1,1-dimethylallyl, 1-methylallyl, 2-methylallyl, 1-phenylallyl, 2-phenylallyl, 3,3-diphenylallyl, 1,2-dimethylallyl, 1-phenyl-1-butenyl, and 3-phenyl-1-butenyl, but are not limited thereto.

The C1-C10 alkynyl in the present invention is preferably C2-C8 alkynyl, more preferably C2-C5 alkynyl. Non-limiting examples thereof may include ethynyl, propynyl, n-butynyl, isobutynyl, n-pentynyl, isopentynyl, and neo-pentynyl, but are not limited thereto.

The "linkable to form a ring" in the present invention means that two adjacent groups do not form a ring or are linked to each other to form a ring.

Preferably, the two adjacent groups may be linked to form a substituted or unsubstituted 6-membered to 30-membered aromatic ring, a substituted or unsubstituted 5-membered to 30-membered heteroaromatic ring, or a substituted or unsubstituted 5-membered to 30-membered aliphatic ring.

In the present invention, the substituted or unsubstituted arylamido in the present invention is 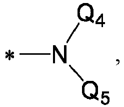 where Q₄ and Q₅ each represent a substituted or unsubstituted aromatic group, and Q₄ and Q₅ each preferably represent substituted or unsubstituted C₆-C₃₀ aryl or substituted or unsubstituted C₂-C₃₀ heteroaryl.

The halogen atom in the present invention is a fluorine atom, a chlorine atom, a bromide atom, or an iodine atom.

The C₁-C₁₀ alkoxy in the present invention is methoxy, ethoxy, propoxy, butoxy, pentyloxy, hexyloxy, or isopropoxy, but is not limited thereto.

In the present invention, a substituted or unsubstituted C₆-C₃₀ aromatic ring is substituted or unsubstituted phenyl, substituted or unsubstituted naphthyl, substituted or unsubstituted anthryl, substituted or unsubstituted fluorenyl, substituted or unsubstituted dimethylfluorenyl, substituted or unsubstituted diphenylfluorenyl, substituted or unsubstituted spirofluorenyl, substituted or unsubstituted phenanthryl, substituted or unsubstituted fused tetraphenyl, substituted or unsubstituted pyrenyl, substituted or unsubstituted diphenyl, substituted or unsubstituted p-terphenyl, substituted or unsubstituted m-terphenyl, substituted or unsubstituted chrysenyl, substituted or unsubstituted diphenylphenyl, substituted or unsubstituted perylenyl, or substituted or unsubstituted indenyl, but is not limited thereto.

In the present invention, a substituted or unsubstituted 5-membered to 30-membered heteroaromatic ring is substituted or unsubstituted furyl, substituted or unsubstituted thienyl, substituted or unsubstituted pyrrolyl, substituted or unsubstituted pyrazolyl, substituted or unsubstituted imidazolyl, substituted or unsubstituted triazolyl, substituted or unsubstituted oxazolyl, substituted or unsubstituted thiazolyl, substituted or unsubstituted oxadiazolyl, substituted or unsubstituted thiadiazolyl, substituted or unsubstituted pyridinyl, substituted or unsubstituted pyrimidinyl, substituted or unsubstituted pyrazinyl, substituted or unsubstituted triazinyl, substituted or unsubstituted benzofuryl, substituted or unsubstituted benzothienyl, substituted or unsubstituted benzimidazolyl, substituted or unsubstituted indolyl, substituted or unsubstituted quinolyl, substituted or unsubstituted isoquinolyl, substituted or unsubstituted quinazolinyl, substituted or unsubstituted quinoxalinyl, substituted or unsubstituted naphthyridinyl, substituted or unsubstituted benzoxazinyl, substituted or unsubstituted benzothiazinyl, substituted or unsubstituted acridinyl, substituted or unsubstituted phenazinyl, substituted or unsubstituted phenothiazinyl, substituted or unsubstituted phenoxazinyl, substituted or unsubstituted fluorenyl, substituted or unsubstituted dibenzofuryl, substituted or unsubstituted dibenzothienyl, substituted or unsubstituted carbazolyl, a combination thereof, or a fused ring of a combination of the foregoing groups, but is not limited thereto.

The present invention provides a boron-containing organic compound and an organic electroluminescent device prepared from same. The compound in the present invention can be used as a green light doping material of a light-emitting layer for the organic electroluminescent device, thereby greatly improving a lifetime of the device.

The organic electroluminescent device in the present invention may be a bottom-emitting organic electroluminescent device, a top-emitting organic electroluminescent device, or a tandem organic electroluminescent device. This is not specifically limited.

The organic electroluminescent device in the present invention includes a substrate, a first electrode, an organic light-emitting functional layer, and a second electrode. The organic light-emitting functional layer includes a hole transport region, a light-emitting layer, and an electron transport region. The hole transport region includes a hole injection layer, a hole transport layer, and an electron blocking layer. The electron transport region includes a hole blocking layer, an electron transport layer, and an electron injection layer. In addition, a CPL layer may be further provided on the second electrode.

Any substrate commonly used in the organic electroluminescent device may be used as the substrate of the organic electroluminescent device in the present invention, for example, a transparent substrate such as a glass or transparent plastic substrate, or an opaque substrate such as a silicon substrate. Different substrates have different mechanical strength, thermal stability, transparency, surface smoothness, and waterproofness. A direction in which the substrate is used varies based on different properties of the substrate. In the present invention, a transparent PI film substrate is preferably used. A thickness of the substrate is not specifically limited.

The first electrode is formed on the substrate. The first electrode and the second electrode may be opposite to each other. The first electrode may be an anode. The first electrode may be a transmissive electrode, a semi-transmissive electrode, or a reflective electrode. When the first electrode is a transmissive electrode, the first electrode may be formed by using a transparent metal oxide, such as an indium-tin oxide (ITO), an indium-zinc oxide (IZO), zinc oxide (ZnO), or an indium-tin-zinc oxide (ITZO). When the first electrode is a semi-transmissive electrode or a reflective electrode, the first electrode may include Ag, Mg, Al, Pt, Pd, Au, Ni, Nd, Ir, Cr, or a metal mixture. A thickness of the first electrode depends on a material used, and is usually 50 nm to 500 nm, preferably 70 nm to 300 nm, more preferably 100 nm to 200 nm.

An organic functional material layer provided between the first electrode and the second electrode sequentially includes, from bottom to top, a hole transport region, a light-emitting layer, and an electron transport region.

In this specification, the hole transport region of the organic electroluminescent device may be listed as a hole injection layer, a hole transport layer, an electron blocking layer, and the like.

Any material may be selected from known related materials for OLED apparatuses to be used as a material of the hole injection layer, the hole transport layer, and the electron blocking layer.

Examples of the foregoing materials may be a phthalocyanine derivative, a triazole derivative, a triarylmethane derivative, a triarylamine derivative, an oxazole derivative, an oxadiazole derivative, a hydrazone derivative, a stilbene derivative, a pyridinoline derivative, a polysilane derivative, an imidazole derivative, a phenylenediamine derivative, an amino-substituted quinoxalinol derivative, a styrene compound such as a styrylanthracene derivative or a styrylamine derivative, a fluorene derivative, a spirofluorene derivative, a silazane derivative, an aniline copolymer, a porphyrin compound, a carbazole derivative, a polyarylalkane derivative, polyphenylenevinylene and a derivative thereof, polythiophene and a derivative thereof, a poly(N-vinylcarbazole) derivative, a thiophene oligomer and another electrically conductive macromolecular oligomer, an aromatic tertiary amine compound, a styrylamine compound, triamine, tetramine, benzidine, an aminomethylacetylene derivative, a p-phenylenediamine derivative, an m-phenylenediamine derivative, 1,1'-bis(4-diarylaminophenyl)cyclohexane, 4,4'-bis(diarylamine)biphenyl, bis[4-(diarylamino)phenyl]methane, 4,4'-bis(diarylamino)terphenyl, 4,4'-bis(diarylamino)quaterphenyl, 4,4'-bis(diarylamino)diphenyl ether, 4,4'-bis(diarylamino)diphenylsulfane, bis[4-(diarylamino)phenyl]dimethylmethane, bis[4-(diarylamino)phenyl]-bis(trifluoromethyl)methane, a 2,2-diphenylethenyl compound, or the like.

Further, based on a requirement for device matching, the hole transport film layer between the electron blocking layer and the hole injection layer of the organic electroluminescent device may be a single film layer, or may be a stacked structure of a plurality of hole transport materials. In this specification, thicknesses of the foregoing hole carrier conduction film layers with different functions are not specifically limited.

The hole injection layer includes a host organic material that can conduct holes, and also includes a P-type doping material with a deep HOMO energy level (a corresponding LUMO energy level is also very deep). Based on an empirical summary, to implement smooth injection of holes from the anode to an organic film layer, as long as a HOMO energy level of a host organic material used for a buffer layer on an interface of the anode to conduct holes has specific characteristics with that of the P-type doping material, a charge transfer state between the host material and the doping material can be generated, and ohmic contact between the buffer layer and the anode can be formed, implementing efficient injection from the electrode to hole injection conduction layer.

In view of the foregoing empirical summary, different P-type doping materials are required to match hole host materials with different HOMO energy levels, so that ohmic contact on the interface can be formed, improving hole injection effect.

Therefore, in an implementation of the present invention, to better inject holes, the hole injection layer further includes a charge-conductive P-type doping material selected from the following: quinone derivatives such as tetracyanoquinodimethane (TCNQ) and 2,3,5,6-tetrafluoro-tetracyano-1,4-benzoquinodimethane (F4-TCNQ); or hexaazatriphenylene derivatives such as 2,3,6,7,10,11-hexacyano-1,4,5,8,9,12-hexaazatriphenylene (HAT-CN); or cyclopropane derivatives such as 2-(7-dicyanomethylene-1,3,4,5,6,8,9, 10-octafluoro-7H-pyrene-2-ylidene)-malononitrile; or metal oxides such as tungsten oxide and molybdenum oxide, but not limited thereto.

In the hole injection layer of the present invention, a ratio of the used hole transport material to the P-type doping material is 99:1 to 95:5, preferably 99:1 to 97:3, by mass.

A thickness of the hole injection layer of the present invention may be 5 nm to 100 nm, preferably 5 nm to 50 nm, more preferably 5 nm to 20 nm, but the thickness is not limited to this range.

A thickness of the hole transport layer of the present invention may be 5 nm to 200 nm, preferably 10 nm to 150 nm, more preferably 20 nm to 100 nm, but the thickness is not limited to this range.

A thickness of the electron blocking layer of the present invention may be 1 nm to 50 nm, preferably 5 nm to 40 nm, but the thickness is not limited to this range.

After the hole injection layer, the hole transport layer, and the electron blocking layer are formed, a corresponding light-emitting layer is formed on the electron blocking layer.

The light-emitting layer may include a host material and a doping material. A green light host material common in the art may be used for the host material. The boron-containing organic compound shown in general formula (1) in the present invention is used for the doping material.

The light-emitting layer may include a single-host material or a double-host material.

The double-host material includes a first host material and a second host material. Preferably, at least one of the first host material and the second host material is a TADF material.

The TADF material is a material with thermally activated delayed fluorescence properties, characterized by a small energy gap between a first excited singlet state and a first excited triplet state. In this case, both generated singlet excitons and triplet excitons can be used in the device, so that a utilization rate of excitons generated by excitation inside the device can be as close to 100% as possible. Compared with a conventional fluorescent material, the TADF material has a higher exciton utilization rate.

The light-emitting layer may include a host material, an exciton-sensitizing material, and a doping material.

The exciton-sensitizing material is a material that enables a light-emitting material in the light-emitting layer to make full use of excitons, so that the light-emitting layer exhibits an emission spectrum of a sensitized material. An exciton sensitizer may provide functions such as exciton capture, exciton conversion, and exciton transfer in the electroluminescent device. The combination of the boron-containing organic compound shown in general formula (1) of the present invention and the exciton-sensitizing material significantly improves device efficiency and resolves problems such as exciton annihilation in the device and efficiency reduction.

In the light-emitting layer of the present invention, a ratio of the used host material to the doping material is 99:1 to 70:30, preferably 99:1 to 85:15, more preferably 97:3 to 87:13, by mass.

A thickness of the light-emitting layer may be adjusted to optimize light-emitting efficiency and a drive voltage. A preferred thickness range is 5 nm to 50 nm, further preferably 10 nm to 50 nm, more preferably 15 nm to 40 nm, but the thickness is not limited to this range.

In the present invention, the electron transport region may sequentially include, from bottom to top, a hole blocking layer, an electron transport layer, and an electron injection layer that are provided on the light-emitting layer, but is not limited thereto.

The hole blocking layer is a layer that blocks holes injected from the anode to pass through the light-emitting layer to enter the cathode, thereby prolonging a lifetime of the device and improving efficiency of the device. The hole blocking layer of the present invention may be provided on the light-emitting layer. A compound known in the conventional technology with a hole blocking function may be used for a material of the hole blocking layer of the organic electroluminescent device of the present invention, such as bathocuproine (BCP) and other phenanthroline derivatives, aluminum(III)bis(2-methyl-8-quinoline)-4-phenylphenolate (BAlq) and other metal complexes of hydroxyquinoline derivatives, various rare-earth complexes, oxazole derivatives, triazole derivatives, triazine derivatives, and 9,9'-(5-(6-([1,1'-biphenyl]-4-yl)-2-phenylpyrimidin-4-yl)-1,3-phenylene)bis(9H-carbazole) and other pyrimidine derivatives. A thickness of the hole blocking layer of the present invention may be 2 nm to 200 nm, preferably 5 nm to 150 nm, but the thickness is not limited to this range.

The electron transport layer may be provided on the light-emitting layer or the hole blocking layer (if present). A material of the electron transport layer is a material that can easily receive electrons from the cathode and transfer the received electrons to the light-emitting layer. A material with high electron mobility is preferred. A material known in the conventional technology for an electron transport layer of an organic electroluminescent device may be used for the electron transport layer of the organic electroluminescent device of the present invention, such as metal complexes of hydroxyquinoline derivatives represented by Alq3, BAlq, and Liq, various rare-earth metal complexes, triazole derivatives, 2,4-bis(9,9-dimethyl-9H-fluoren-2-yl)-6-(2-naphthalenyl)-1,3,5-triazine (CAS number: 1459162-51-6) and other triazine derivatives, 2-(4-(9,10-di(naphthalen-2-yl)anthracen-2-yl)phenyl)-1-phenyl-1H-benzo[d]imidazole (CAS number: 561064-11-7, LG201) and other imidazole derivatives, oxadiazole derivatives, thiadiazole derivatives, carbodiimide derivatives, quinoxaline derivatives, phenanthroline derivatives, and silicon-based compound derivatives. A thickness of the electron transport layer of the present invention may be 10 nm to 80 nm, preferably 20 nm to 60 nm, more preferably 25 nm to 45 nm, but the thickness is not limited to this range.

The electron injection layer may be provided on the electron transport layer. Usually, a material of the electron injection layer is preferably a material with a low work function, so that electrons are easily injected into the organic functional material layer. A material known in the conventional technology for an electron injection layer of an organic electroluminescent device may be used for the material of the electron injection layer of the organic electroluminescent device of the present invention, for example, lithium; a lithium salt such as 8-hydroxyquinolinolato-lithium, lithium fluoride, lithium carbonate, or lithium azide; or a cesium salt such as cesium fluoride, cesium carbonate, or cesium azide. A thickness of the electron injection layer of the present invention may be 0.1 nm to 5 nm, preferably 0.5 nm to 3 nm, more preferably 0.8 nm to 1.5 nm, but the thickness is not limited to this range.

The second electrode may be provided on the electron transport region. The second electrode may be a cathode. The second electrode may be a transmissive electrode, a semi-transmissive electrode, or a reflective electrode. When the second electrode is a transmissive electrode, the second electrode may include, for example, Li, Yb, Ca, LiF/Ca, LiF/Al, Al, Mg, BaF, Ba, Ag, or a compound or mixture thereof. When the second electrode is a semi-transmissive electrode or a reflective electrode, the second electrode may include Ag, Mg, Yb, Al, Pt, Pd, Au, Ni, Nd, Ir, Cr, Li, Ca, LiF/Ca, LiF/Al, Mo, Ti, or a compound or mixture thereof, but is not limited thereto. A thickness of the cathode depends on a material used.

The organic electroluminescent device of the present invention may further include a packaging structure. The packaging structure may be a protective structure that prevents external substances such as moisture and oxygen from entering the organic layer of the organic electroluminescent device. The packaging structure may be, for example, a can, such as a glass can or a metal can; or a film covering the entire surface of the organic layer.

A method for preparing the organic electroluminescent device in the present invention includes laminating an anode, a hole injection layer, a hole transport layer, an electron blocking layer, an organic film layer, an electron transport layer, an electron injection layer, a cathode, and an optional cover layer successively on a substrate. For this method, vacuum deposition, vacuum evaporation, spin coating, casting, an LB method, inkjet printing, laser printing, LITI, or another method may be used, but are not limited thereto. In the present invention, the layers are formed preferably by using a vacuum evaporation method. A person skilled in the art may generally select process conditions for the vacuum evaporation method according to an actual requirement.

All raw materials in synthesis embodiments of the present invention may be purchased from the market or prepared by using a preparation method conventional in the art.

### Synthesis of intermediates:

### Synthesis of an intermediate A series:

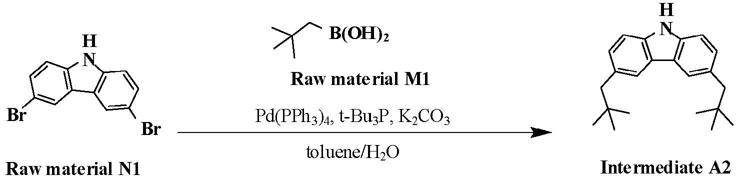

Synthesis of intermediate A2: Raw material N1 (2.05 g, 6.31 mmol), raw material M1 (1.54 g, 13.25 mmol), tetrakis(triphenylphosphine)palladium (0.22 g, 0.19 mmol), tri-tert-butylphosphine (0.12 g, 0.57 mmol), potassium carbonate (0.17 g, 1.23 mmol), 50 mL of toluene, and 10 mL of water are added to a two-neck flask to react at 110°C in a nitrogen atmosphere for 24 h and then cooled down. Then, the mixture is subject to extraction with ethyl acetate, washed with saturated brine, dried, and subject to column chromatography (PE:EA = 20:1) to obtain intermediate A2.

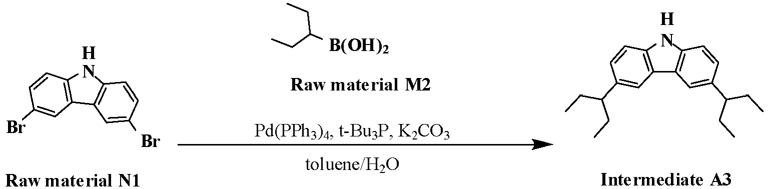

Synthesis of intermediate A3: Raw material N1 (2.05 g, 6.31 mmol), raw material M2 (1.54 g, 13.25 mmol), tetrakis(triphenylphosphine)palladium (0.22 g, 0.19 mmol), tri-tert-butylphosphine (0.12 g, 0.57 mmol), potassium carbonate (0.17 g, 1.23 mmol), 50 mL of toluene, and 10 mL of water are added to a two-neck flask to react at 110°C in a nitrogen atmosphere for 24 h and then cooled down. Then, the mixture is subject to extraction with ethyl acetate, washed with saturated brine, dried, and subject to column chromatography (PE:EA = 20:1) to obtain intermediate A3.

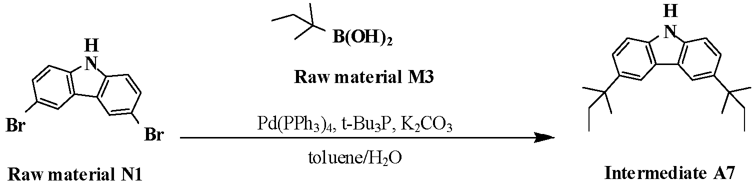

### Synthesis of intermediate A7: Refer to the synthesis of intermediate A2. The difference lies in that raw material M1 is replaced with raw material M3.

### Synthesis of an intermediate R series:

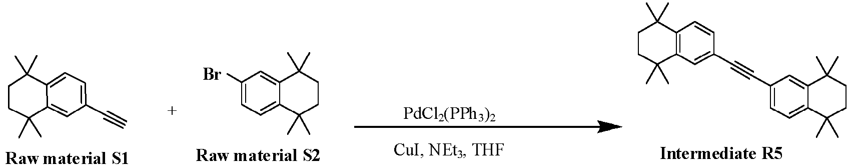

Synthesis of intermediate R5: Raw material S1 (0.76 g, 3.6 mmol) and raw material S2 (1.15 g, 4.3 mmol) are dissolved in THF (80 mL), and PdCl₂(PPh₃)₂ (0.11 g, 0.15 mmol), CuI (0.07 g, 0.36 mmol), and triethylamine (40 mL) are added in sequence. The mixture is purged with nitrogen for three times, and then heated slowly to 80°C and kept at the same temperature for 12 h. Then, the reaction mixture is cooled down to room temperature, then filtered to remove inorganic salts, and then subject to rotary evaporation to remove triethylamine. The product is poured into acidic water. The precipitate is washed with deionized water five times, and dried at 80°C under vacuum overnight. The crude product is subject to silica gel column chromatography with petroleum ether as an eluent to obtain a crude product. The crude product is recrystallized to obtain intermediate R5.

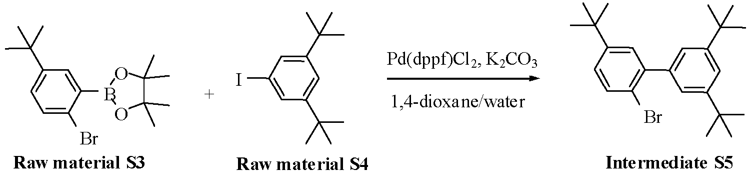

Synthesis of intermediate S5: Raw material S3 (10 mmol, 3.39 g) and raw material S4 (10 mmol, 3.16 g) are added to a three-neck flask and dissolved with a mixed solvent (70 mL of 1,4-dioxane/water (volume ratio: 4:1), 35 mL of ethanol), and then Pd(dppf)Cl₂ (0.10 mmol, 0.07 g) and 15 mL of 3 mol/L aqueous K₂CO₃ solution are added. The mixture is heated and refluxed under nitrogen protection to react for 4 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate S5.

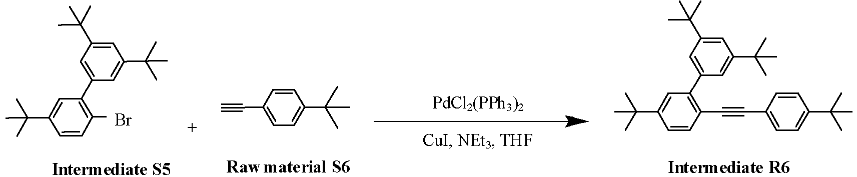

Synthesis of intermediate R6: For preparation and synthesis of intermediate R6, refer to those of intermediate R5, with same reaction conditions and same reactant equivalents. The difference lies in that raw material S1 and raw material S2 as the reactants are respectively replaced with raw material S6 and intermediate S5.

### Synthesis of an intermediate G series:

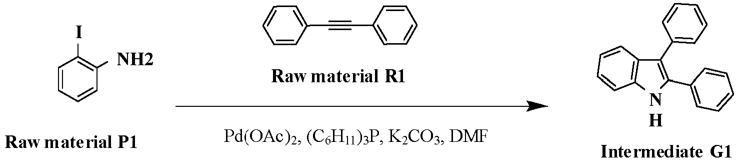

Synthesis of intermediate G1: Raw material R1 (4.46 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P1 (5.54 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G1.

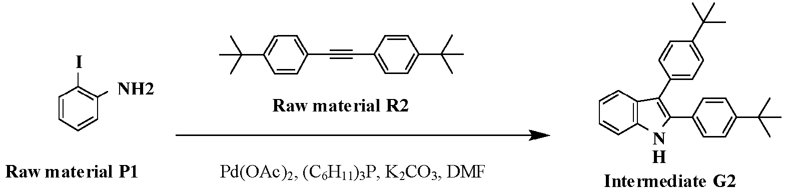

Synthesis of intermediate G2: Raw material R2 (7.26 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P1 (5.54 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G2.

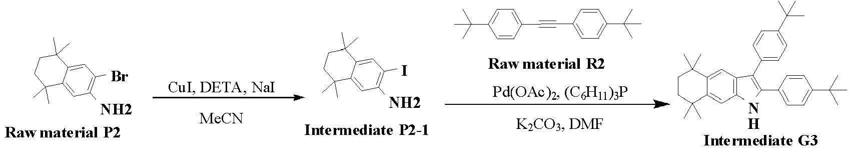

Synthesis of intermediate P2-1: Raw material P2 (8.69 g, 30.80 mmol), copper iodide (0.29 g, 1.54 mmol), diethylenetriamine (0.32 g, 3.08 mmol), sodium iodide (9.02 g, 60.16 mmol), and 300 mL of anhydrous acetonitrile are added to a two-neck flask, and heated and refluxed for 24 h. After cooled down, the mixture is subject to extraction with ethyl acetate, and washed with saturated brine to remove acetonitrile. The organic phase is dried over anhydrous sodium sulfate. After the solvent is removed by spin-drying, trituration is performed with methanol. The solid is recrystallized with dichloromethane-methanol to obtain intermediate P2-1.

Synthesis of intermediate G3: Raw material R2 (7.26 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Intermediate P2-1 (8.23 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G3.

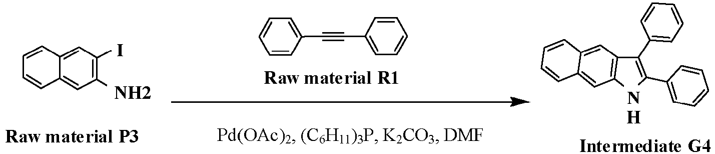

Synthesis of intermediate G4: Raw material R1 (4.46 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P3 (6.73 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G4.

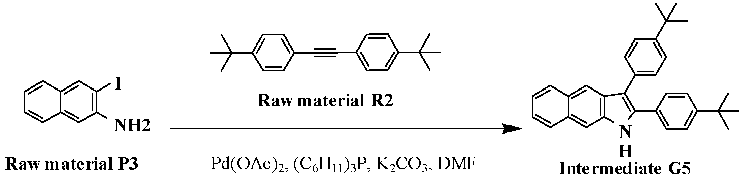

Synthesis of intermediate G5: Raw material R2 (7.26 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P3 (6.73 g, 25 mmol) is added under nitrogen protection. The mixture is stirred at 140°C under nitrogen protection for 12 h, and then filtered, washed, dried, and subject to column chromatography (PE:EA = 20:1) to obtain intermediate G5.

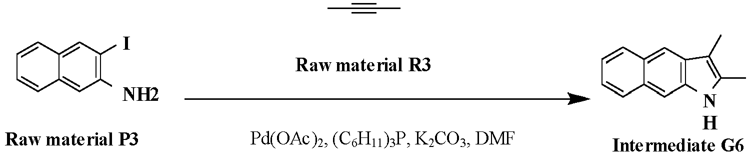

Synthesis of intermediate G6: Raw material R3 (1.35 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P3 (6.73 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G6.

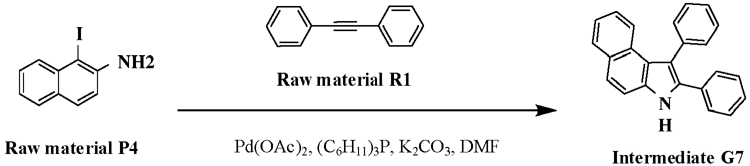

Synthesis of intermediate G7: Raw material R1 (4.46 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P4 (6.73 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G7.

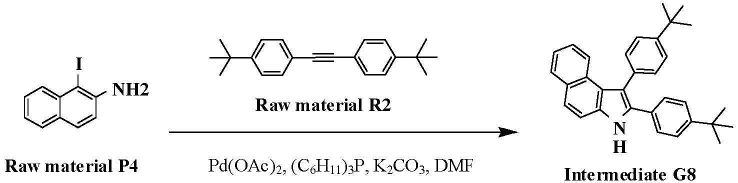

Synthesis of intermediate G8: Raw material R2 (7.26 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P4 (6.73 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G8.

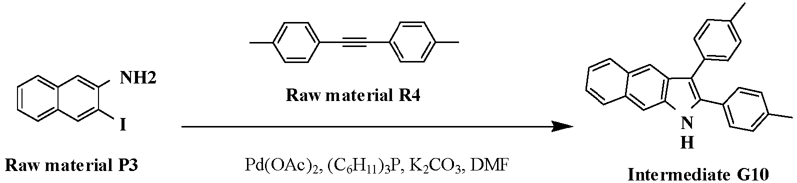

Synthesis of intermediate G10: Raw material R4 (5.16 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P3 (6.73 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G10.

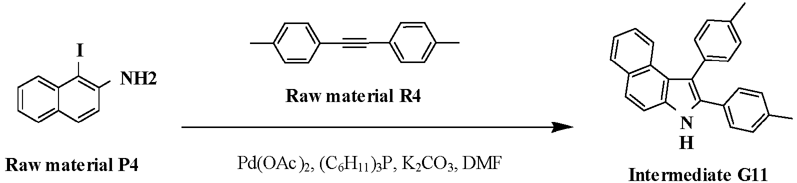

Synthesis of intermediate G11: Raw material R4 (5.16 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P4 (6.73 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G11.

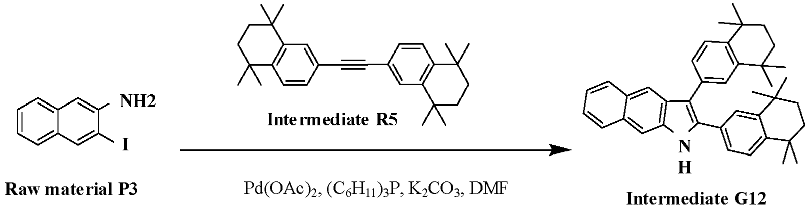

Synthesis of intermediate G12: Intermediate R5 (9.97 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P3 (6.73 g, 25 mmol) is added under nitrogen protection. The mixture is stirred at 140°C under nitrogen protection for 12 h, and then filtered, washed, dried, and subject to column chromatography (PE:EA = 20: 1) to obtain intermediate G12.

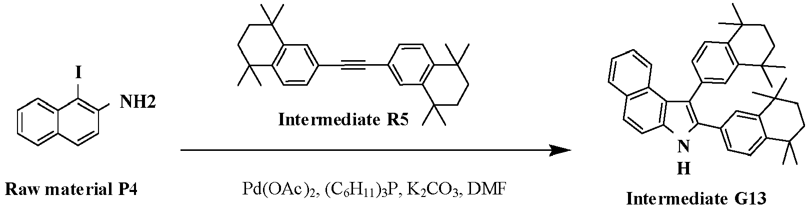

Synthesis of intermediate G13: Intermediate R5 (9.97 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P4 (6.73 g, 25 mmol) is added under nitrogen protection. The mixture is stirred at 140°C under nitrogen protection for 12 h, and then filtered, washed, dried, and subject to column chromatography (PE:EA = 20:1) to obtain intermediate G13.

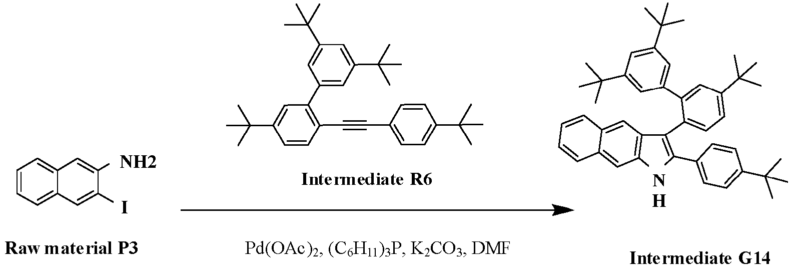

Synthesis of intermediate G14: Intermediate R6 (11.97 g, 25 mmol), potassium carbonate (8.64 g, 62.5 mmol), tricyclohexylphosphine (0.35 g, 1.25 mmol), and palladium acetate (0.09 g, 0.4 mmol) are added to a two-neck flask, and 100 mL of anhydrous DMF is added under nitrogen protection. The mixture is stirred at room temperature for 30 min. Raw material P3 (6.73 g, 25 mmol) is added under nitrogen protection. The mixture is stirred at 140°C under nitrogen protection for 12 h, and then filtered, washed, dried, and subject to column chromatography (PE:EA = 20:1) to obtain intermediate G14.

### Embodiment 1: Synthesis of compound 5:

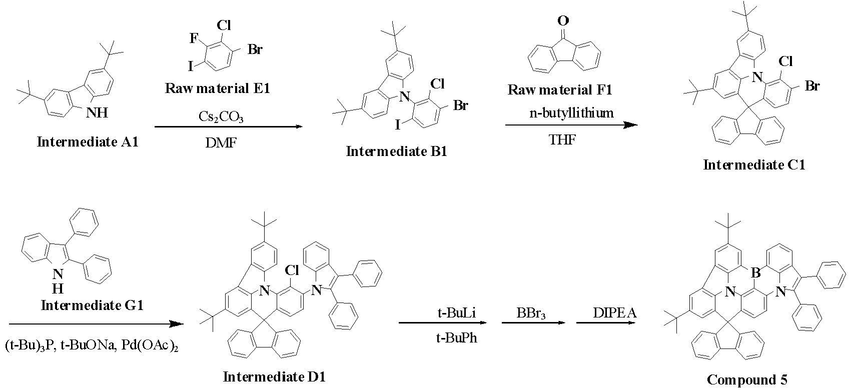

Synthesis of intermediate B1: Raw material E1 (1.68 g, 5 mmol) and cesium carbonate (4.07 g, 12.5 mmol) are added to a two-neck flask, and 50 mL of anhydrous DMF is added under nitrogen protection. The mixture is stirred at room temperature for 30 min. Intermediate A1 (1.4 g, 5 mmol) is added under nitrogen protection. The mixture is stirred at 140°C under nitrogen protection for 12 h, and then filtered, washed, dried, and subject to column chromatography (PE:EA = 20: 1) to obtain intermediate B1.

Synthesis of intermediate C1: Intermediate B1 (3.03 g, 5.1 mmol) is dissolved in 50 mL of tetrahydrofuran (THF) solution. 3.8 mL of solution of n-butyllithium (1.6 M) in n-hexane is slowly added at 0°C with nitrogen introduced. The mixture is stirred at 0°C for 2 h. Then, 10 mL of solution of raw material F1 (0.99 g, 5.5 mmol) in tetrahydrofuran is slowly added. Then, the reaction mixture is warmed slowly to room temperature and stirred overnight. A dilute hydrochloric acid solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate C1.

Synthesis of intermediate D1: Under nitrogen protection, intermediate C1 (1.58 g, 2.5 mmol) is dissolved in 50 mL of toluene solution, and intermediate G1 (0.67 g, 2.5 mmol), tri-tert-butylphosphine (0.025 g, 0.125 mmol), sodium tert-butoxide (0.62 g, 6.5 mmol), and palladium acetate (0.01 g, 0.04 mmol) are added. The mixture is stirred vigorously. The resulting mixture is refluxed at 105°C for 10 h and then cooled down to room temperature. Then, ethyl acetate (100 mL) is added. The mixture is washed with deionized water (100 mL) three times, and dried over anhydrous magnesium sulfate overnight. Then, ethyl acetate is evaporated under reduced pressure. The remaining mixture is poured into 100 mL of petroleum ether under stirring. The mixture is filtered to obtain intermediate D1.

Synthesis of compound 5: Intermediate D1 (10.24 g, 12.5 mmol) is dissolved in 300 mL of tert-butylbenzene, and 10 mL of solution of tert-butyllithium (1.6 M) in n-pentane is slowly added at 0°C in a nitrogen atmosphere. The mixture is stirred at 60°C for 2 h. Then, boron tribromide (6.26 g, 25 mmol) is added at 0°C. Then, the reaction mixture is stirred at room temperature for 1 h. N,N-diisopropylethylamine (DIPEA) (3.25 g, 25.2 mmol) is added at 0°C. After reaching room temperature, the reaction mixture is stirred at 130°C for 6 h. Then, the reaction mixture is cooled down to room temperature. Methanol is added to the reaction mixture to remove residual BBr₃. The mixture is separated and subject to extraction with water and dichloromethane. The organic layers are combined, condensed under vacuum, and subject to column chromatography, to obtain compound 5.

Embodiments 2, 3, 4, 5, 6, 7, 8, 9, 10, 11, 12, 13, 14, 15, 16, and 17: Synthesis of corresponding compounds 17, 41, 154, 182, 183, 186, 188, 204, 222, 268, 280, 327, 331, 343, 367, and 321:

The following target compounds are synthesized with reference to the preparation process of compound 5 in Embodiment 1, with same reaction conditions and same raw material E1. The difference lies in that intermediates/raw materials A, raw materials F, and intermediates G listed in Table 2-1 are used.

**Table 2-1**

| Embodiment number | Intermediate/Raw material A | Raw material F | Intermediate G | Target compound |
|---|---|---|---|---|
| 2 | 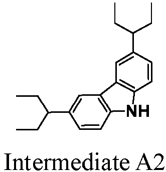 | 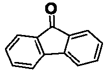 Raw material F1 | 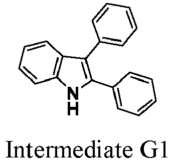 | 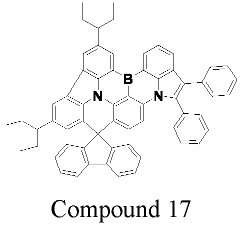 |
| 3 | 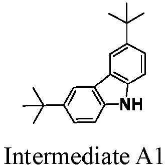 | 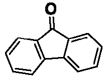 Raw material F1 | 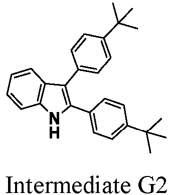 | 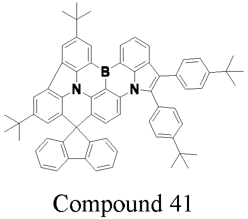 |
| 4 | 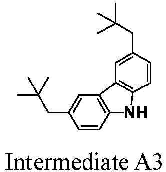 | 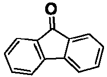 Raw material F1 | 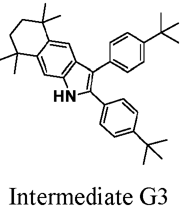 | 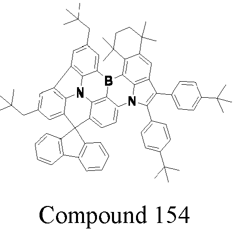 |
| 5 | 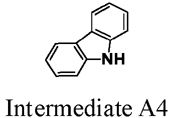 | 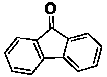 Raw material F1 | 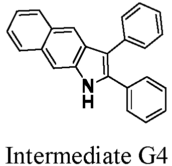 | 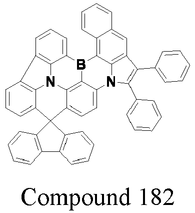 |
| 6 | 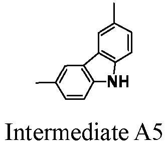 | 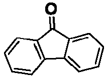 Raw material F1 | 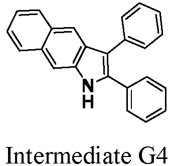 | 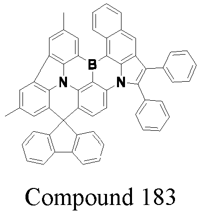 |
| 7 | 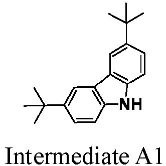 | 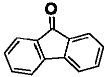 Raw material F1 | 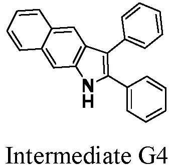 | 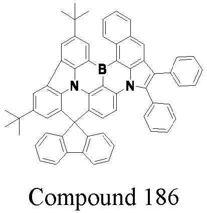 |
| 8 | 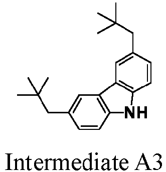 | 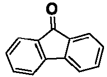 Raw material F1 | 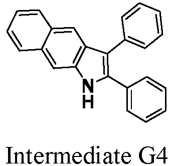 | 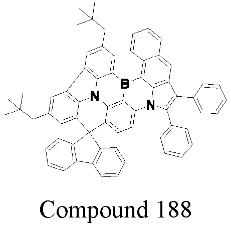 |
| 9 | 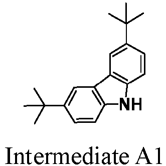 | 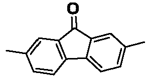 Raw material F4 | 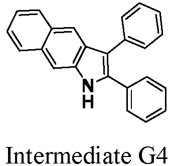 | 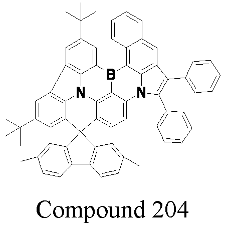 |
| 10 | 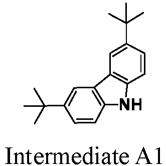 | 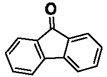 Raw material F1 | 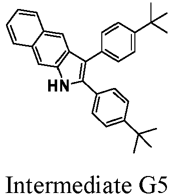 | 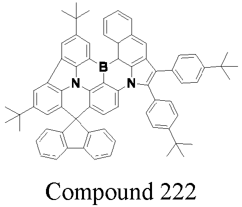 |
| 11 | 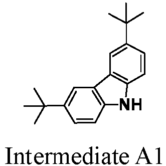 | 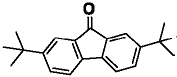 Raw material F2 | 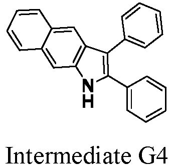 | 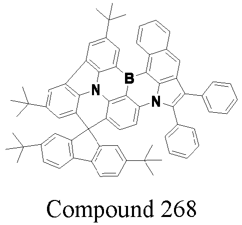 |
| 12 | 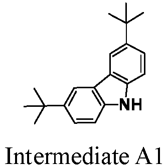 | 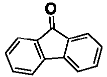 Raw material F1 | 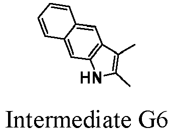 | 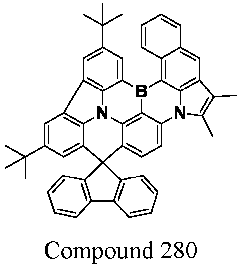 |
| 13 | 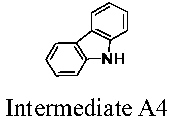 | 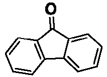 Raw material F1 | 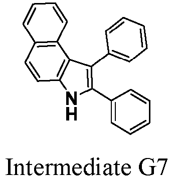 | 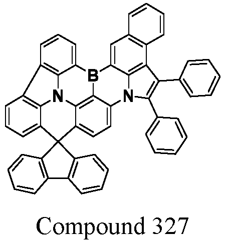 |
| 14 | 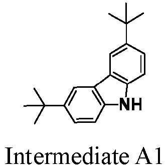 | 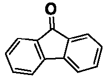 Raw material F1 | 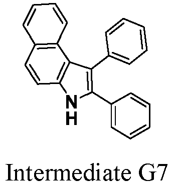 | 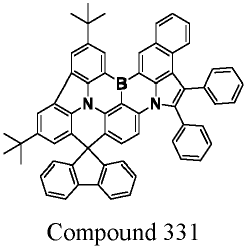 |
| 15 | 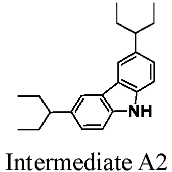 | 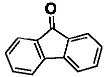 Raw material F1 | 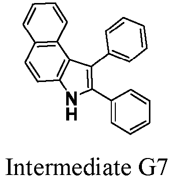 | 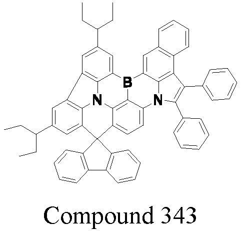 |
| 16 | 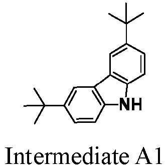 | 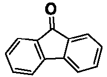 Raw material F1 | 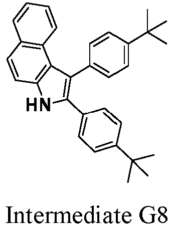 | 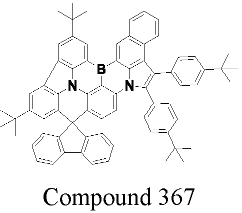 |
| 17 | 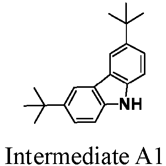 | 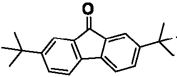 Raw material F2 | 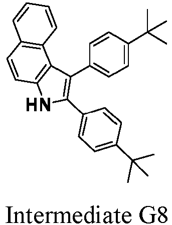 | 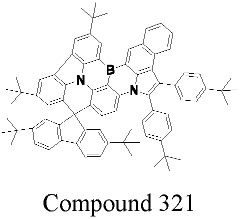 |

### Embodiment 18: Synthesis of compound 320:

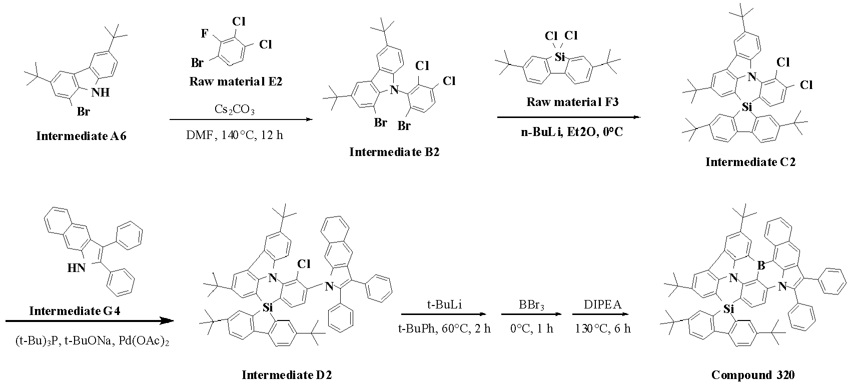

Synthesis of intermediate B2: Raw material E2 (1.22 g, 5 mmol) and cesium carbonate (4.07 g, 12.5 mmol) are added to a two-neck flask, and 50 mL of anhydrous DMF is added under nitrogen protection. The mixture is stirred at room temperature for 30 min. Intermediate A6 (1.79 g, 5 mmol) is added under nitrogen protection. The mixture is stirred at 140°C under nitrogen protection for 12 h, and then filtered, washed, dried, and subject to column chromatography (PE:EA = 20: 1) to obtain intermediate B2.

Synthesis of intermediate C2: Intermediate B2 (4.19 g, 7.2 mmol) is dissolved in 30 mL of anhydrous ether, and 10 mL of solution of n-butyllithium (1.6 M) in hexane is added dropwise at 0°C in a N₂ atmosphere. The mixture is stirred at 0°C for 1 h. Then, 100 mL of solution of raw material F3 (2.91 g, 8.00 mmol) in anhydrous toluene is added dropwise. The reaction mixture is stirred at 35°C for 2 h and then cooled down to room temperature. With water added, the reaction mixture is subject to extraction with ethyl acetate to obtain a product. The organic layers are combined, washed with brine, dried over anhydrous Na₂SO₄, filtered, evaporated, and subject to column chromatography, to obtain intermediate C2.

Synthesis of intermediate D2: Under nitrogen protection, intermediate C2 (3.50 g, 4.9 mmol) is dissolved in 50 mL of toluene solution, and intermediate G4 (1.60 g, 5 mmol), tri-tert-butylphosphine (0.051 g, 0.25 mmol), sodium tert-butoxide (1.25 g, 13 mmol), and palladium acetate (0.018 g, 0.08 mmol) are added. The mixture is stirred vigorously. The resulting mixture is refluxed at 105°C for 9 h and then cooled down to room temperature. Then, ethyl acetate (100 mL) is added. The mixture is washed with deionized water (100 mL) three times, and dried over anhydrous magnesium sulfate overnight. Then, ethyl acetate is evaporated under reduced pressure. The remaining mixture is poured into 100 mL of petroleum ether under stirring. The mixture is filtered to obtain intermediate D2.

Synthesis of compound 320: Intermediate D2 (12.47 g, 12.5 mmol) is dissolved in 300 mL of tert-butylbenzene, and 9 mL of solution of tert-butyllithium (1.6 M) in n-pentane is slowly added at 0°C in a nitrogen atmosphere. The mixture is stirred at 60°C for 2 h. Then, boron tribromide (6.26 g, 25 mmol) is added at 0°C. Then, the reaction mixture is stirred at room temperature for 1 h. N,N-diisopropylethylamine (DIPEA) (3.25 g, 25.2 mmol) is added at 0°C. After reaching room temperature, the reaction mixture is stirred at 130°C for 6 h. Then, the reaction mixture is cooled down to room temperature. Methanol is added to the reaction mixture to remove residual BBr₃. The mixture is separated and subject to extraction with water and dichloromethane. The organic layers are combined, condensed under vacuum, and subject to column chromatography, to obtain compound 320.

### Embodiment 19: Synthesis of compound 324:

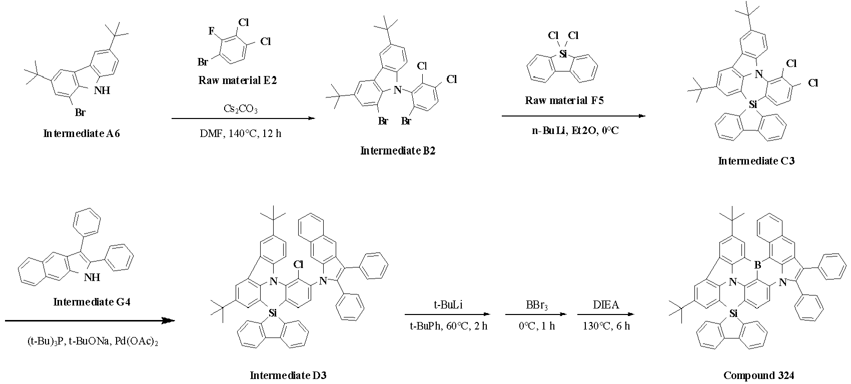

Synthesis of intermediate B2: Raw material E2 (1.22 g, 5 mmol) and cesium carbonate (4.07 g, 12.5 mmol) are added to a two-neck flask, and 50 mL of anhydrous DMF is added under nitrogen protection. The mixture is stirred at room temperature for 30 min. Intermediate A6 (1.79 g, 5 mmol) is added under nitrogen protection. The mixture is stirred at 140°C under nitrogen protection for 12 h, and then filtered, washed, dried, and subject to column chromatography (PE:EA = 20: 1) to obtain intermediate B2.

Synthesis of intermediate C3: In a N₂ atmosphere at 0°C, 10 mL of solution of n-butyllithium (1.6 M) in hexane is added dropwise to 30 mL of solution of intermediate B2 (4.19 g, 7.2 mmol) in anhydrous ether under stirring. The mixture is stirred at 0°C for 1 h. Then, 10 mL of solution of raw material F5 (2.01 g, 8.00 mmol) in anhydrous toluene is added dropwise. The reaction mixture is stirred at 35°C for 2 h and then cooled down to room temperature. With water added, the reaction mixture is subject to extraction with ethyl acetate to obtain a product. The organic layers are combined, washed with brine, dried over anhydrous Na₂SO₄, filtered, evaporated, and subject to column chromatography, to obtain intermediate C3.

Synthesis of intermediate D3: Under nitrogen protection, intermediate C3 (2.95 g, 4.9 mmol) is dissolved in 50 mL of toluene solution, and intermediate G4 (1.60 g, 5 mmol), tri-tert-butylphosphine (0.051 g, 0.25 mmol), sodium tert-butoxide (1.25 g, 13 mmol), and palladium acetate (0.018 g, 0.08 mmol) are added. The mixture is stirred vigorously. The resulting mixture is refluxed at 105°C for 9 h and then cooled down to room temperature. Then, ethyl acetate (100 mL) is added. The mixture is washed with deionized water (100 mL) three times, and dried over anhydrous magnesium sulfate overnight. Then, ethyl acetate is evaporated under reduced pressure. The remaining mixture is poured into 100 mL of petroleum ether under stirring. The mixture is filtered to obtain intermediate D3.

Synthesis of compound 324: In a nitrogen atmosphere at 0°C, 9 mL of solution of tert-butyllithium (1.6 M) in n-pentane is slowly added to 300 mL of solution of intermediate D3 (11.07 g, 12.5 mmol) in tert-butylbenzene. The mixture is stirred at 60°C for 2 h. Then, n-pentane is removed under vacuum. Boron tribromide (6.26 g, 25 mmol) is added at 0°C. Then, the reaction mixture is stirred at room temperature for 1 h. N,N-diisopropylethylamine (DIEA) (3.25 g, 25.2 mmol) is added at 0°C. After reaching room temperature, the reaction mixture is stirred at 130°C for 6 h. Then, the reaction mixture is cooled down to room temperature. Methanol is added to the reaction mixture to remove residual BBr₃. The mixture is separated and subject to extraction with water and dichloromethane. The organic layers are combined, condensed under vacuum, and subject to column chromatography, to obtain compound 324.

Embodiments 20, 21, 22, 23, 24, 25, 26, 27, 28, 29, and 30: Synthesis of corresponding compounds 83, 116, 190, 212, 226, 264, 273, 275, 409, 417, and 481:

The following target compounds are synthesized with reference to the preparation process of compound 5 in Embodiment 1, with same reaction conditions and same raw material E1. The difference lies in that intermediates/raw materials A, raw materials F, and intermediates G listed in Table 2-2 are used.

**Table 2-2**

| Embodiment number | Intermediate A | Raw material F | Intermediate G | Target compound |
|---|---|---|---|---|
| 20 | 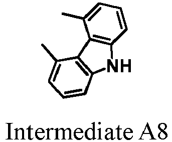 | 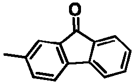 Raw material F6 | 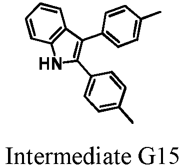 | 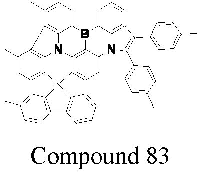 |
| 21 | 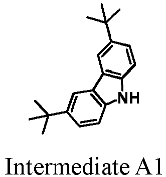 | 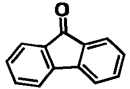 Raw material F1 | 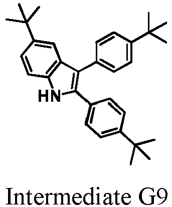 | 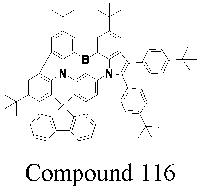 |
| 22 | 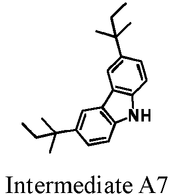 | 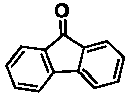 Raw material F1 | 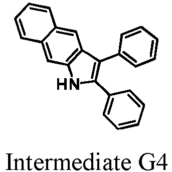 | 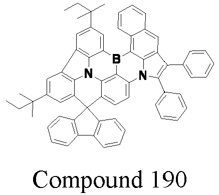 |
| 23 | 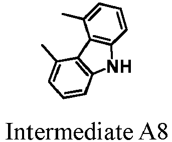 | 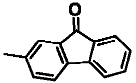 Raw material F6 | 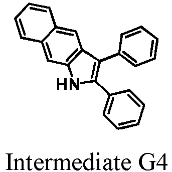 | 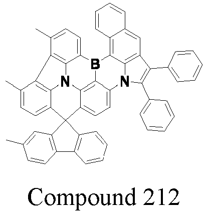 |
| 24 | 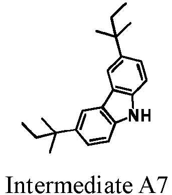 | 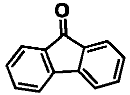 Raw material F1 | 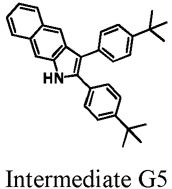 | 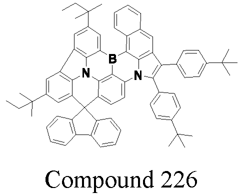 |
| 25 | 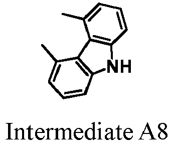 | 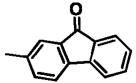 Raw material F6 | 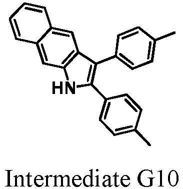 | 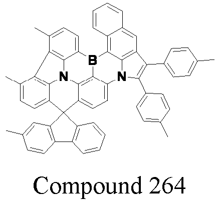 |
| 26 | 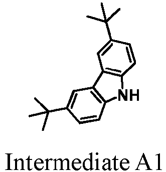 | 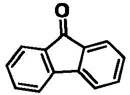 Raw material F1 | 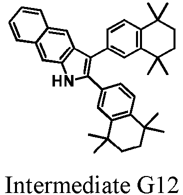 | 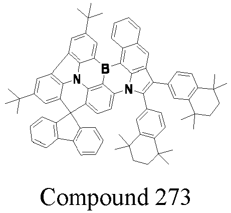 |
| 27 | 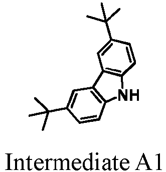 | 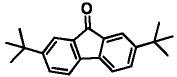 Raw material F2 | 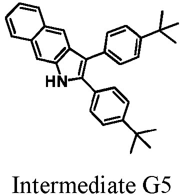 | 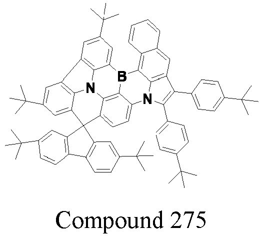 |
| 28 | 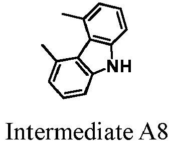 | 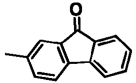 Raw material F6 | 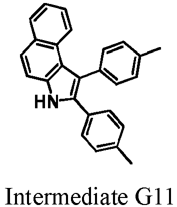 | 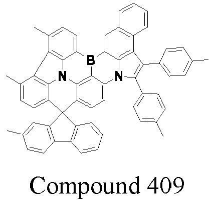 |
| 29 | 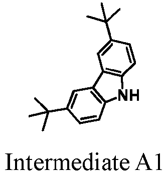 | 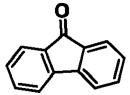 Raw material F1 | 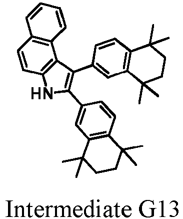 | 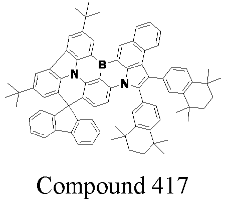 |
| 30 | 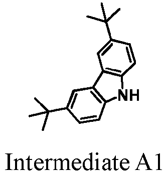 | 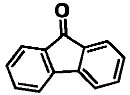 Raw material F1 | 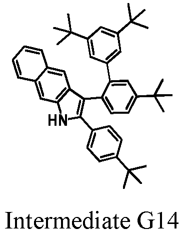 | 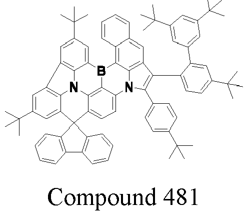 |

Test results of structural characterization, mass spectrometry, and physicochemical properties of the compounds obtained in the embodiments are as follows.

Structural formula (C₅₉H₄₅BN₂) of compound 5: theoretical value: C, 89.38; H, 5.72; N, 3.53; test value: C, 89.41; H, 5.64; N, 3.54. LC-MS: measured value: 793.25 ([M+H]⁺), exact mass: 792.37. PLQY is 98%, and FWHM is 25 nm.

Structural formula (C₆₁H₄₉BN₂) of compound 17: theoretical value: C, 89.25; H, 6.02; N, 3.41; test value: C, 89.23; H, 6.09; N, 3.37. LC-MS: measured value: 821.42 ([M+H]+), exact mass: 820.40. PLQY is 96%, and FWHM is 27 nm.

Structural formula (C₆₇H₆₁BN₂) of compound 41: theoretical value: C, 88.92; H, 6.79; N, 3.10; test value: C, 88.99; H, 6.86; N, 3.00. LC-MS: measured value: 905.46 ([M+H]+), exact mass: 904.49. PLQY is 97%, and FWHM is 28 nm.

Structural formula (C₇₇H₇₉BN₂) of compound 154: theoretical value: C, 88.65; H, 7.63; N, 2.69; test value: C, 88.57; H, 7.58; N, 2.72. LC-MS: measured value: 1043.86 ([M+H]+), exact mass: 1042.63. PLQY is 94%, and FWHM is 26 nm.

Structural formula (C₅₅H₃₁BN₂) of compound 182: theoretical value: C, 90.41; H, 4.28; N, 3.83; test value: C, 90.44; H, 4.20; N, 3.92. LC-MS: measured value: 731.16 ([M+H]+), exact mass: 730.26. PLQY is 98%, and FWHM is 27 nm.

Structural formula (C₅₇H₃₅BN₂) of compound 183: theoretical value: C, 90.23; H, 4.65; N, 3.69; test value: C, 90.19; H, 4.59; N, 3.74. LC-MS: measured value: 759.40 ([M+H]+), exact mass: 758.29. PLQY is 96%, and FWHM is 24 nm.

Structural formula (C₆₃H₄₇BN₂) of compound 186: theoretical value: C, 89.77; H, 5.62; N, 3.32; test value: C, 89.75; H, 5.52; N, 3.33. LC-MS: measured value: 843.30 ([M+H]+), exact mass: 842.38. PLQY is 94%, and FWHM is 24 nm.

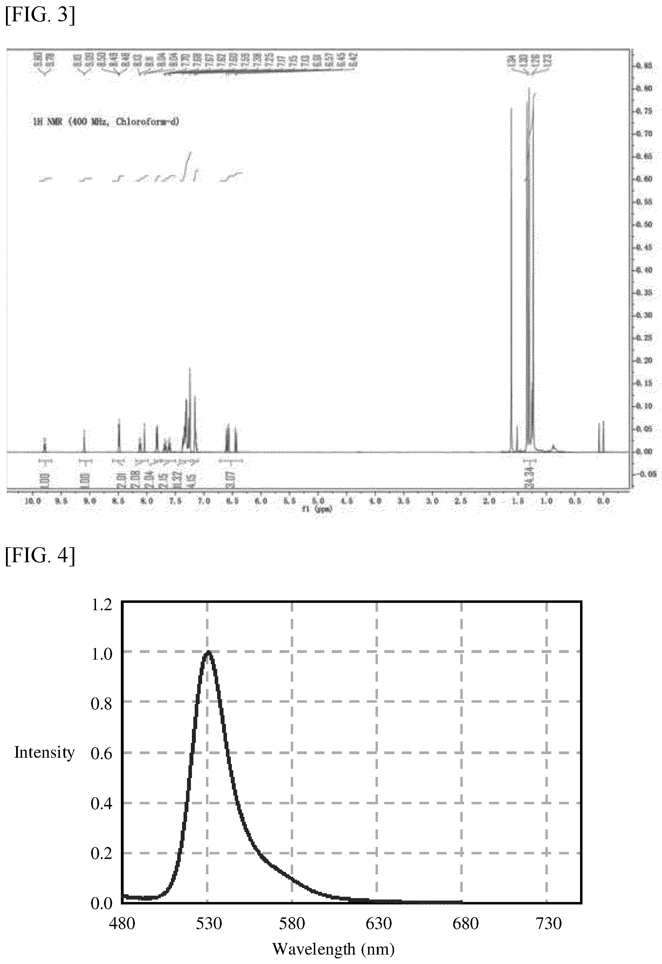

FIG. 4 shows a spectrum of compound 186. Test conditions (a toluene solution, 5×10⁻⁵ M). Test equipment: a research-grade fluorescence spectrometer Horiba Fluorolog-3.

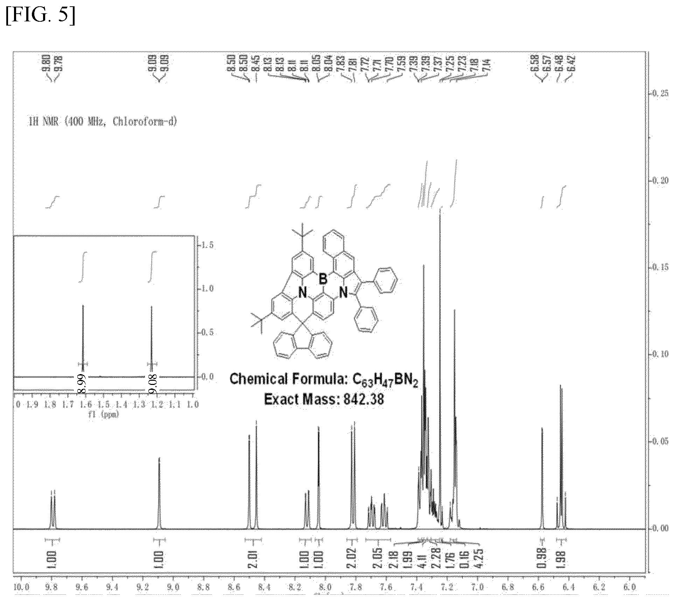

FIG. 5 shows a nuclear magnetic resonance spectrum of compound 186.

Structural formula (C₆₅H₅₁BN₂) of compound 188: theoretical value: C, 89.64; H, 5.90; N, 3.22; test value: C, 89.61; H, 5.80; N, 3.18. LC-MS: measured value: 871.29 ([M+H]+), exact mass: 870.41. PLQY is 97%, and FWHM is 26 nm.

Structural formula (C₆₅H₅₁BN₂) of compound 204: theoretical value: C, 89.64; H, 5.90; N, 3.22; test value: C, 89.60; H, 5.86; N, 3.13. LC-MS: measured value: 871.62 ([M+H]+), exact mass: 870.41. PLQY is 93%, and FWHM is 25 nm.

Structural formula (C₇₁H₆₃BN₂) of compound 222: theoretical value: C, 89.29; H, 6.65; N, 2.93; test value: C, 89.38; H, 6.75; N, 2.98. LC-MS: measured value: 955.30 ([M+H]+), exact mass: 954.51. PLQY is 97%, and FWHM is 26 nm.

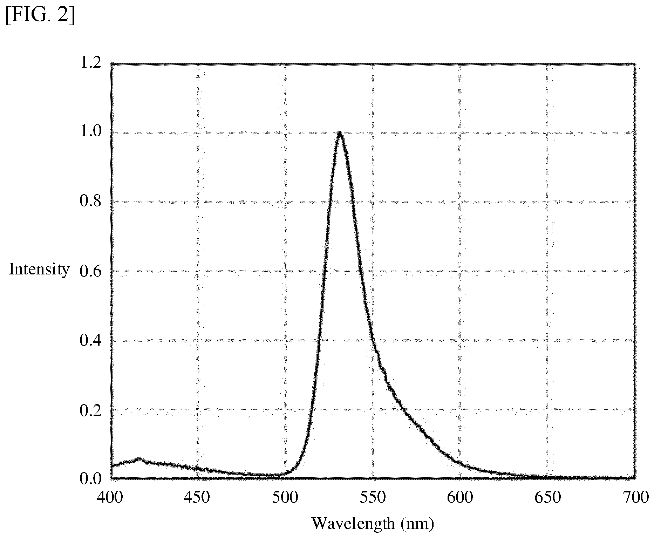

FIG. 2 shows a spectrum of compound 222. Test conditions (a toluene solution, 5×10⁻⁵ M). Test equipment: a research-grade fluorescence spectrometer Horiba Fluorolog-3.

FIG. 3 shows a nuclear magnetic resonance spectrum of compound 222.

Structural formula (C₇₁H₆₃BN₂) of compound 268: theoretical value: C, 89.29; H, 6.65; N, 2.93; test value: C, 89.30; H, 6.67; N, 2.98. LC-MS: measured value: 955.77 ([M+H]+), exact mass: 954.51. PLQY is 98%, and FWHM is 27 nm.

Structural formula (C₅₃H₄₃BN₂) of compound 280: theoretical value: C, 88.57; H, 6.03; N, 3.90; test value: C, 88.53; H, 6.11; N, 3.98. LC-MS: measured value: 719.40 ([M+H]+), exact mass: 718.35. PLQY is 97%, and FWHM is 28 nm.

Structural formula (C₇₀H₆₃BN₂Si) of compound 320: theoretical value: C, 86.57; H, 6.54; N, 2.88; test value: C, 86.48; H, 6.58; N, 2.87. LC-MS: measured value: 971.48 ([M+H]⁺), exact mass: 970.49. PLQY is 93%, and FWHM is 25 nm.

Structural formula (C₆₂H₄₇BN₂Si) of compound 324: theoretical value: C, 86.70; H, 5.52; N, 3.26; Si, 3.27; test value: C, 86.67; H, 5.43; N, 3.30; Si, 3.26. LC-MS: measured value: 859.54 ([M+H]⁺), exact mass: 858.36. PLQY is 97%, and FWHM is 29 nm.

Structural formula (C₅₅H₃₁BN₂) of compound 327: theoretical value: C, 90.41; H, 4.28; N, 3.83; test value: C, 90.47; H, 4.25; N, 3.86. LC-MS: measured value: 731.15 ([M+H]+), exact mass: 730.26. PLQY is 97%, and FWHM is 28 nm.

Structural formula (C₆₃H₄₇BN₂) of compound 331: theoretical value: C, 89.77; H, 5.62; N, 3.32; test value: C, 89.83; H, 5.56; N, 3.37. LC-MS: measured value: 843.63 ([M+H]⁺), exact mass: 842.38. PLQY is 94%, and FWHM is 25 nm.

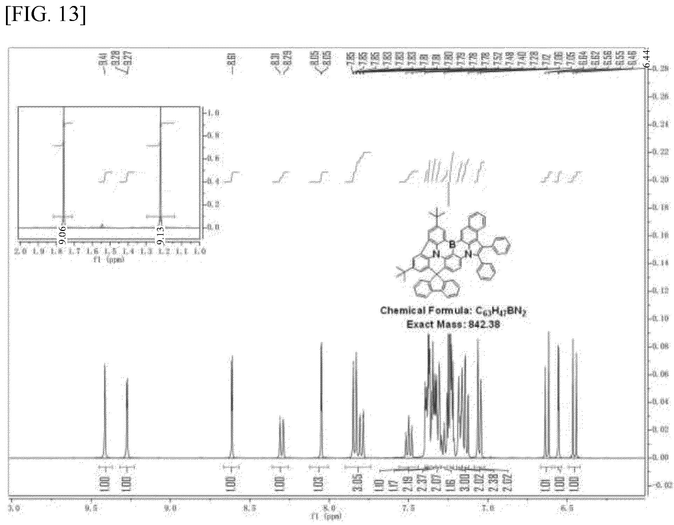

FIG. 13 shows a nuclear magnetic resonance spectrum of compound 331.

Structural formula (C₆₅H₅₁BN₂) of compound 343: theoretical value: C, 89.64; H, 5.90; N, 3.22; test value: C, 89.60; H, 5.84; N, 3.24. LC-MS: measured value: 871.38 ([M+H]+), exact mass: 870.41. PLQY is 97%, and FWHM is 25 nm.

Structural formula (C₇₁H₆₃BN₂) of compound 367: theoretical value: C, 89.29; H, 6.65; N, 2.93; test value: C, 89.27; H, 6.72; N, 3.01. LC-MS: measured value: 955.67 ([M+H]+), exact mass: 954.51. PLQY is 97%, and FWHM is 24 nm.

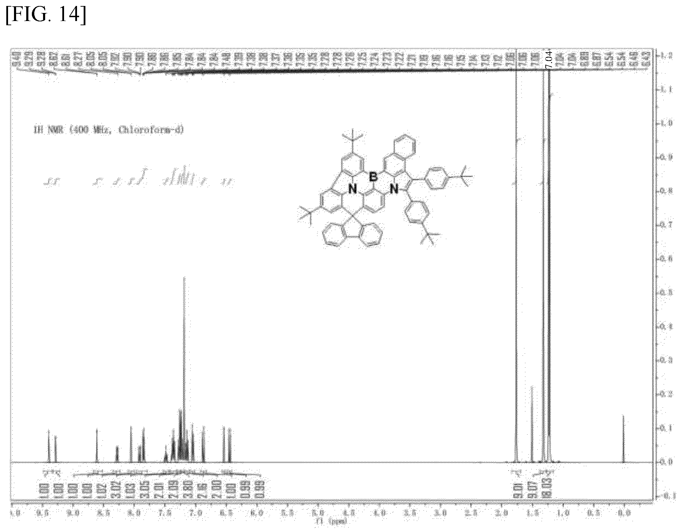

FIG. 14 shows a nuclear magnetic resonance spectrum of compound 367.

Structural formula (C₇₉H₇₉BN₂) of compound 321: theoretical value: C, 88.90; H, 7.46; N, 2.62; test value: C, 88.88; H, 7.36; N, 2.56. LC-MS: measured value: 1067.61 ([M+H]⁺), exact mass: 1066.63. PLQY is 96%, and FWHM is 28 nm.

Structural formula (C₅₆H₃₉BN₂) of compound 83: theoretical value: C, 89.59; H, 5.24; N, 3.73; test value: C, 89.56; H, 5.23; N, 3.74. LC-MS: measured value: 751.41 ([M+H]+), exact mass: 750.32.

Structural formula (C₇₁H₆₉BN₂) of compound 116: theoretical value: C, 88.72; H, 7.24; N, 2.91; test value: C, 88.71; H, 7.22; N, 2.89. LC-MS: measured value: 961.72 ([M+H]+), exact mass: 960.56.

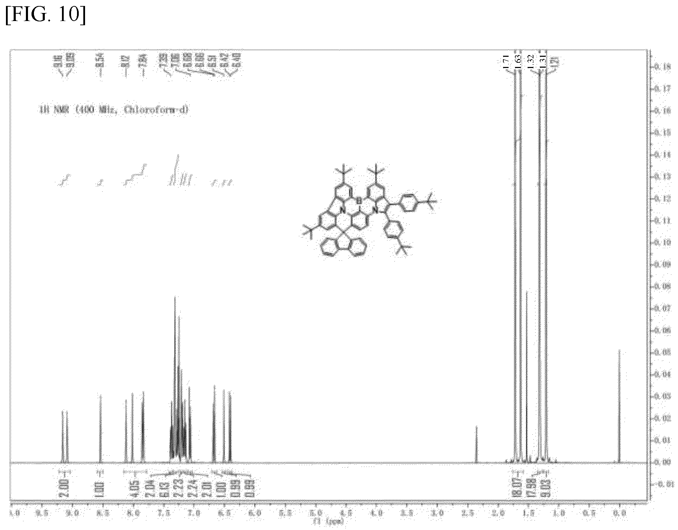

FIG. 10 shows a nuclear magnetic resonance spectrum of compound 116.

Structural formula (C₆₅H₅₁BN₂) of compound 190: theoretical value: C, 89.64; H, 5.90; N, 3.22; test value: C, 89.60; H, 5.89; N, 3.17. LC-MS: measured value: 871.28 ([M+H]+), exact mass: 870.41.

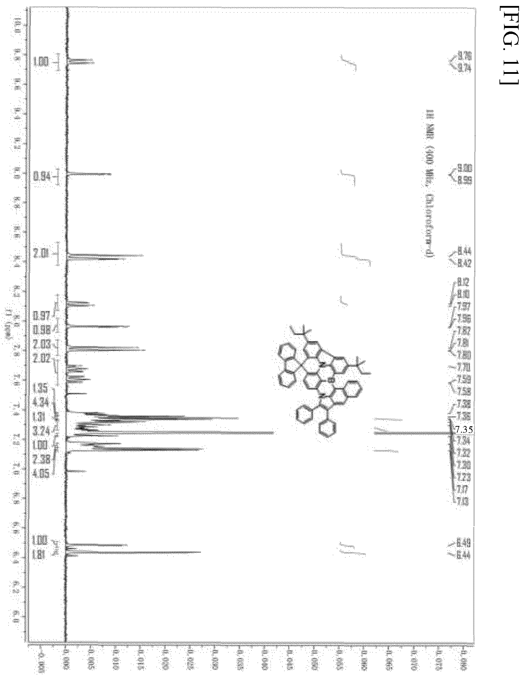

FIG. 11 shows a nuclear magnetic resonance spectrum of compound 190.

Structural formula (C₅₈H₃₇BN₂) of compound 212: theoretical value: C, 90.15; H, 4.83; N, 3.63; test value: C, 90.21; H, 4.79; N, 3.61. LC-MS: measured value: 773.33 ([M+H]+), exact mass: 772.30.

Structural formula (C₇₃H₆₇BN₂) of compound 226: theoretical value: C, 89.18; H, 6.87; N, 2.85; test value: C, 89.24; H, 6.86; N, 2.86. LC-MS: measured value: 983.66 ([M+H]+), exact mass: 982.54.

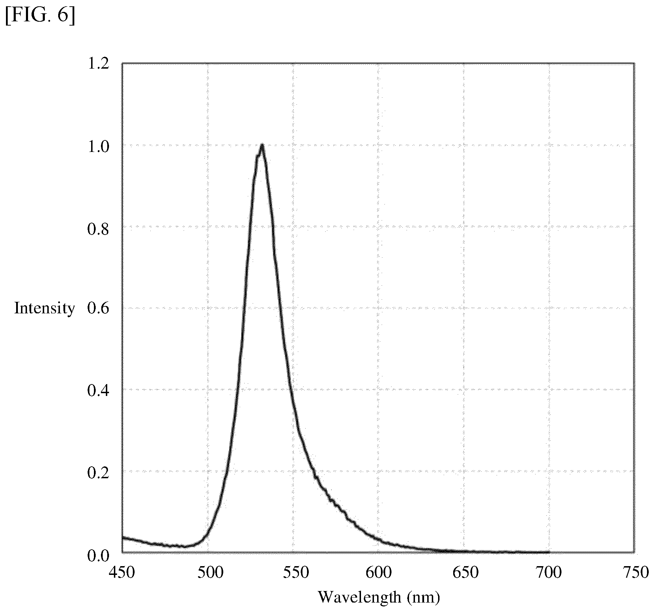

FIG. 6 shows a spectrum of compound 226. Test conditions (a toluene solution, 5×10⁻⁵ M). Test equipment: a research-grade fluorescence spectrometer Horiba Fluorolog-3.

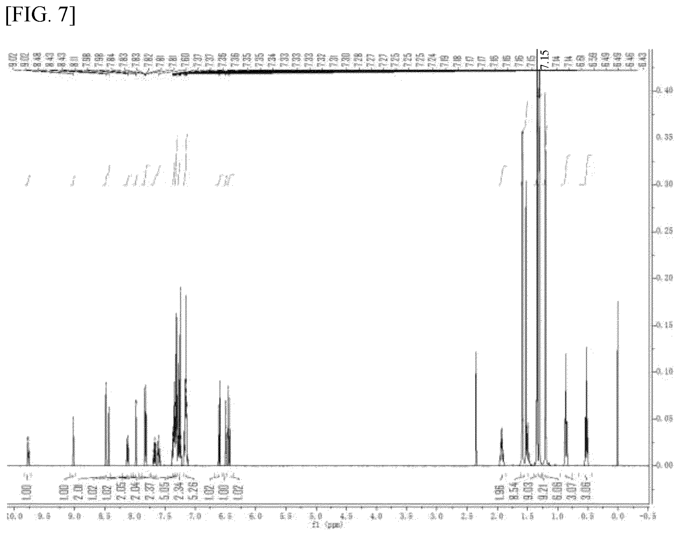

FIG. 7 shows a nuclear magnetic resonance spectrum of compound 226.

Structural formula (C₆₀H₄₁BN₂) of compound 264: theoretical value: C, 89.99; H, 5.16; N, 3.50; test value: C, 89.96; H, 5.18; N, 3.52. LC-MS: measured value: 801.20 ([M+H]+), exact mass: 800.34.

Structural formula (C₇₉H₇₅BN₂) of compound 273: theoretical value: C, 89.24; H, 7.11; N, 2.63; test value: C, 89.23; H, 7.08; N, 2.73. LC-MS: measured value: 1063.74 ([M+H]+), exact mass: 1062.60.

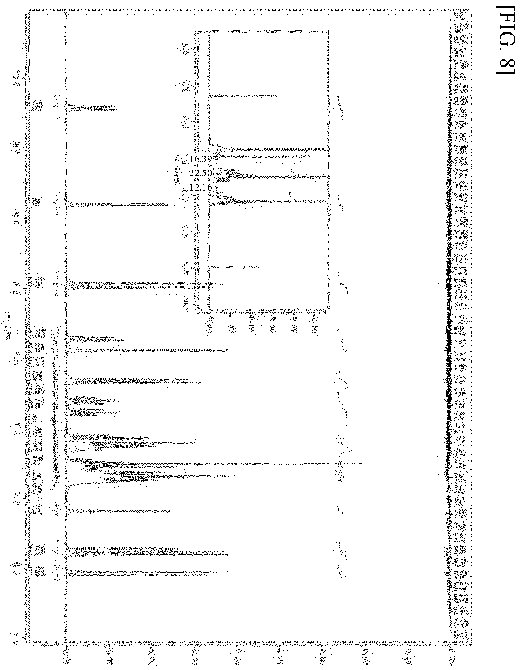

FIG. 8 shows a nuclear magnetic resonance spectrum of compound 273.

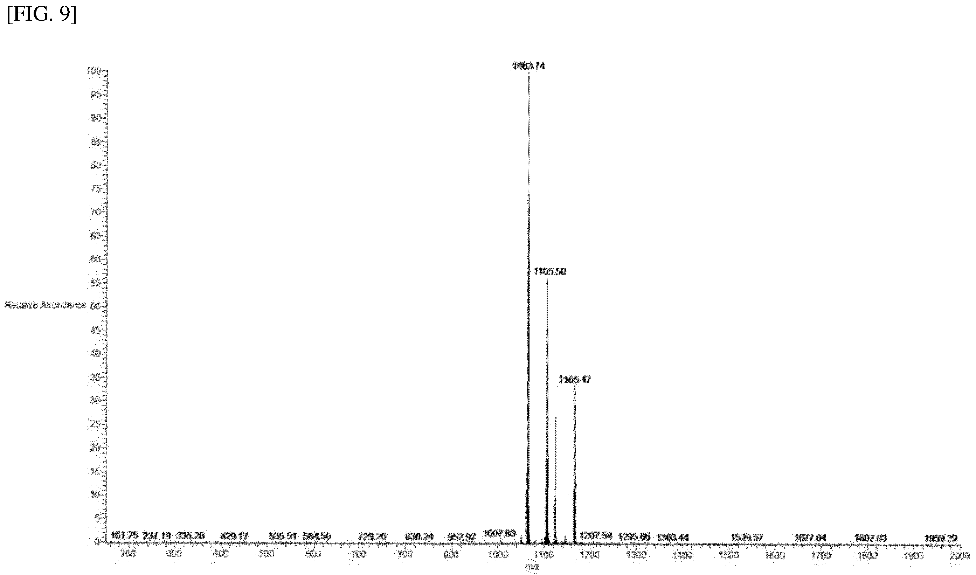

FIG. 9 shows a mass spectrum of compound 273.

Structural formula (C₇₉H₇₉BN₂) of compound 275: theoretical value: C, 88.90; H, 7.46; N, 2.62; test value: C, 88.86; H, 7.49; N, 2.58. LC-MS: measured value: 1067.81 ([M+H]+), exact mass: 1066.63.

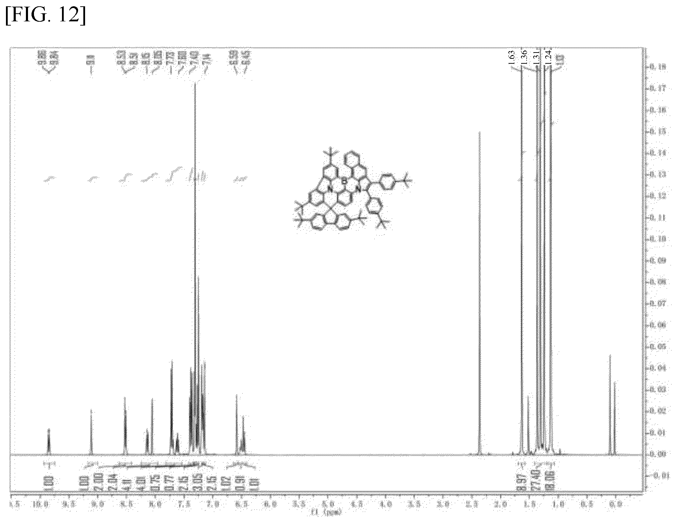

FIG. 12 shows a nuclear magnetic resonance spectrum of compound 275.

Structural formula (C₆₀H₄₁BN₂) of compound 409: theoretical value: C, 89.99; H, 5.16; N, 3.50; test value: C, 89.98; H, 5.22; N, 3.51. LC-MS: measured value: 801.43 ([M+H]+), exact mass: 800.34.

Structural formula (C₇₉H₇₅BN₂) of compound 417: theoretical value: C, 89.24; H, 7.11; N, 2.63; test value: C, 89.14; H, 7.14; N, 2.64. LC-MS: measured value: 1063.90 ([M+H]+), exact mass: 1062.60.

Structural formula (C₈₅H₈₃BN₂) of compound 481: theoretical value: C, 89.29; H, 7.32; N, 2.45; test value: C, 89.33; H, 7.29; N, 2.38. LC-MS: measured value: 1143.54 ([M+H]+), exact mass: 1142.66.

Note: PLQY (fluorescence quantum yield) and FWHM (full width at half maximum) are measured in a film state by the Horiba Fluorolog-3 series fluorescence spectrometer.

It can be learned from the foregoing compound data that the compound in the present invention, as a doping material, has a high fluorescence quantum yield, where the fluorescence quantum yield of the material is close to 100%; and the material has a narrow spectral FWHM, so that a color gamut of a device can be effectively improved, and light-emitting efficiency of the device can be effectively improved.

The following describes in detail effect of use of the OLED material synthesized in the present invention in a device by using Device Embodiments 1 to 30 and Device Comparative Examples 1 to 5. Through comparison between Device Embodiments 1 to 30 and Device Comparative Examples 1 to 5 in the present invention, manufacturing processes of devices are exactly the same, used substrate materials and electrode materials are the same, and thicknesses of the electrode materials are also the same. The difference lies in that light-emitting layer materials in the devices are changed. Table 3 and Table 4 show layer structures and test results respectively of the device embodiments.

### Device Embodiment 1

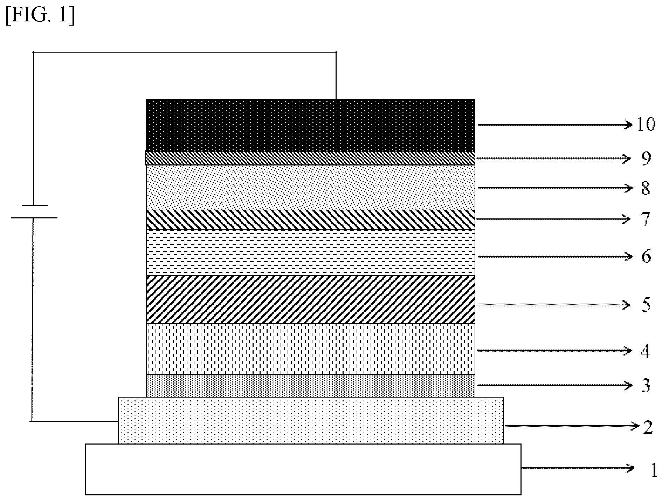

As shown in FIG. 1, a transparent substrate layer 1 is a transparent PI film. An ITO anode layer 2 (with a thickness of 150 nm) is washed sequentially with a cleaner (Semiclean M-L20) and pure water, dried, and then cleaned by ultraviolet-ozone to remove organic residues from the transparent ITO surface. 10 nm thick HT-1 and HI-1 are deposited by using a vacuum evaporation device on the cleaned ITO anode layer 2 to be used as a hole injection layer 3, where a mass ratio of HT-1 to HI-1 is 97:3. Next, 60 nm thick HT-1 is deposited as a hole transport layer 4. Then, 30 nm thick EB-1 is deposited as an electron blocking layer 5. After the electron blocking material is deposited, a light-emitting layer 6 of the OLED light-emitting device is prepared using GH-1 and GH-2 as a host material and using compound 5 as a doping material, where a mass ratio of GH-1 to GH-2 to compound 5 is 69:30:1, and a thickness of the light-emitting layer is 30 nm. 5 nm thick HB-1 is further deposited under vacuum on the light-emitting layer 6 to form a hole blocking layer 7. 30 nm thick ET-1 and Liq are further deposited under vacuum on the hole blocking layer 7 to form an electron transport layer 8, where a mass ratio of ET-1 to Liq is 1:1. A 1 nm thick LiF layer is prepared by using a vacuum evaporation device on the electron transport layer 8 to form an electron injection layer 9. An 80 nm thick Mg:Ag electrode layer is prepared by using a vacuum evaporation device on the electron injection layer 9 to form a cathode layer 10, where a mass ratio of Mg to Ag is 1:9.

The following describes in detail effect of use of the OLED material synthesized in the present invention in a device by using Device Embodiments 31 to 60 and Device Comparative Examples 6 to 10. Through comparison between Device Embodiments 31 to 60 and Device Comparative Examples 6 to 10 in the present invention, manufacturing processes of devices are exactly the same, used substrate materials and electrode materials are the same, and thicknesses of the electrode materials are also the same. The difference lies in that light-emitting layer materials in the devices are changed. Table 3 and Table 4 show layer structures and test results respectively of the device embodiments.

### Device Embodiment 31

A transparent substrate layer 1 is a transparent PI film. An ITO anode layer 2 (with a thickness of 150 nm) is washed sequentially with a cleaner (Semiclean M-L20) and pure water, dried, and then cleaned by ultraviolet-ozone to remove organic residues from the transparent ITO surface. 10 nm thick HT-1 and HI-1 are deposited by using a vacuum evaporation device on the cleaned ITO anode layer 2 to be used as a hole injection layer 3, where a mass ratio of HT-1 to HI-1 is 97:3. Next, 60 nm thick HT-1 is deposited as a hole transport layer 4. Then, 30 nm thick EB-1 is deposited as an electron blocking layer 5. After the electron blocking material is deposited, a light-emitting layer 6 of the OLED light-emitting device is prepared using GH-1 and GH-2 as a host material, using GD-1 as a first doping material, and using compound 5 as a second doping material, where a mass ratio of GH-1 to GH-2 to GD-1 to compound 5 is 66:30:3:1, and a thickness of the light-emitting layer is 30 nm. 5 nm thick HB-1 is further deposited under vacuum on the light-emitting layer 6 to form a hole blocking layer 7. 30 nm thick ET-1 and Liq are further deposited under vacuum on the hole blocking layer 7 to form an electron transport layer 8, where a mass ratio of ET-1 to Liq is 1:1. A 1 nm thick LiF layer is prepared by using a vacuum evaporation device on the electron transport layer 8 to form an electron inj cection layer 9. An 80 nm thick Mg:Ag electrode layer is prepared by using a vacuum evaporation device on the electron injection layer 9 to form a cathode layer 10, where a mass ratio of Mg to Ag is 1:9.

Molecular structural formulas of the related materials are shown as follows:

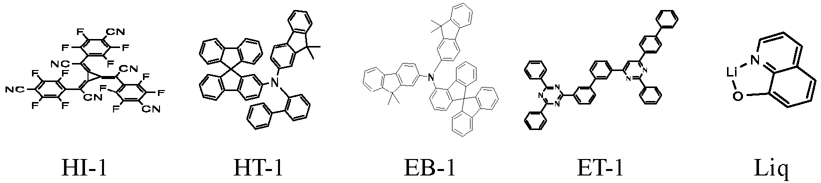

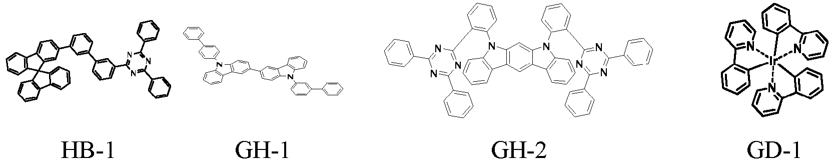

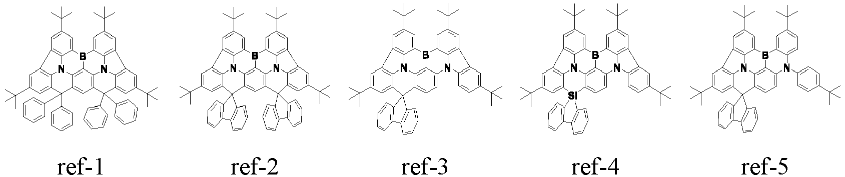

The comparative compounds ref-1, ref-2, ref-3, ref-4, and ref-5 are prepared with reference to methods recorded in the conventional technology.

After the foregoing OLED light-emitting devices are manufactured, the anode and the cathode are connected by a well-known drive circuit, and current efficiency of the device and a lifetime of the device are measured. Table 3 shows the device embodiments and comparative examples prepared by using the same method. Table 4 shows the test results of the current efficiency and lifetime of the obtained devices.

**Table 3**

| Device number | Hole injection layer /Thick-ness | Hole transport layer /Thick-ness | Electron blocking layer /Thick-ness | Light-emitting layer /Thickness | Hole blocking layer /Thick-ness | Electron transport layer /Thick-ness | Electron injection layer /Thick-ness | Cathode layer /Thick-ness |
|---|---|---|---|---|---|---|---|---|
| Compa rative Exampl e 1 | HT-1:HI-1 = 97:3 10 nm | HT-1 60 nm | EB-1 30 nm | GH-1:GH-2:ref-1 = 69:30:1 30 nm | HB-1 5 nm | ET-1:Liq = 1:1 30 nm | LiF 1 nm | Mg:Ag = 1:9 80 nm |
| Compa rative Exampl e 2 | HT-1:HI-1 = 97:3 10 nm | HT-1 60 nm | EB-1 30 nm | GH-1:GH-2:ref-2 = 69:30:1 30 nm | HB-1 5 nm | ET-1:Liq = 1:1 30 nm | LiF 1 nm | Mg:Ag = 1:9 80 nm |
| Compa rative Exampl e 3 | HT-1:HI-1 = 97:3 10 nm | HT-1 60 nm | EB-1 30 nm | GH-1:GH-2:ref-3 = 69:30:1 30 nm | HB-1 5 nm | ET-1:Liq = 1:1 30 nm | LiF 1 nm | Mg:Ag = 1:9 80 nm |
| Compa rative Exampl e 4 | HT-1:HI-1 = 97:3 10 nm | HT-1 60 nm | EB-1 30 nm | GH-1:GH-2:ref-4 = 69:30:1 30 nm | HB-1 5 nm | ET-1:Liq = 1:1 30 nm | LiF 1 nm | Mg:Ag = 1:9 80 nm |
| Compa rative Exampl e 5 | HT-1:HI-1 = 97:3 10 nm | HT-1 60 nm | EB-1 30 nm | GH-1:GH-2:ref-5 = 69:30:1 30 nm | HB-1 5 nm | ET-1:Liq = 1:1 30 nm | LiF 1 nm | Mg:Ag = 1:9 80 nm |
| Embod iment 1 | HT-1:HI-1 = 97:3 10 nm | HT-1 60 nm | EB-1 30 nm | GH-1:GH-2:compound 5 = 69:30:1 30 nm | HB-1 5 nm | ET-1:Liq = 1:1 30 nm | LiF 1 nm | Mg:Ag = 1:9 80 nm |
| Embod iment 2 | HT-1:HI-1 = 97:3 10 nm | HT-1 60 nm | EB-1 30 nm | GH-1:GH-2:compound 17 = 69:30:1 30 nm | HB-1 5 nm | ET-1:Liq = 1:1 30 nm | LiF 1 nm | Mg:Ag = 1:9 80 nm |
| Embod iment 3 | HT-1:HI-1 = 97:3 10 nm | HT-1 60 nm | EB-1 30 nm | GH-1:GH-2:compound 41 = 69:30:1 30 nm | HB-1 5 nm | ET-1:Liq = 1:1 30 nm | LiF 1 nm | Mg:Ag = 1:9 80 nm |
| Embod iment 4 | HT-1:HI-1 = 97:3 10 nm | HT-1 60 nm | EB-1 30 nm | GH-1:GH-2:compound 154 = 69:30:1 30 nm | HB-1 5 nm | ET-1:Liq = 1:1 30 nm | LiF 1 nm | Mg:Ag = 1:9 80 nm |
| Embod iment 5 | HT-1:HI-1 = 97:3 10 nm | HT-1 60 nm | EB-1 30 nm | GH-1:GH-2:compound 182 = 69:30:1 30 nm | HB-1 5 nm | ET-1:Liq = 1:1 30 nm | LiF 1 nm | Mg:Ag = 1:9 80 nm |
| Embod iment 6 | HT-1:HI-1 = 97:3 10 nm | HT-1 60 nm | EB-1 30 nm | GH-1:GH-2:compound 183 = 69:30:1 30 nm | HB-1 5 nm | ET-1:Liq = 1:1 30 nm | LiF 1 nm | Mg:Ag = 1:9 80 nm |
| Embod iment 7 | HT-1:HI-1 = 97:3 10 nm | HT-1 60 nm | EB-1 30 nm | GH-1:GH-2:compound 186 = 69:30:1 30 nm | HB-1 5 nm | ET-1:Liq = 1:1 30 nm | LiF 1 nm | Mg:Ag = 1:9 80 nm |
| Embod iment 8 | HT-1:HI-1 = 97:3 10 nm | HT-1 60 nm | EB-1 30 nm | GH-1:GH-2:compound 188 = 69:30:1 30 nm | HB-1 5 nm | ET-1:Liq = 1:1 30 nm | LiF 1 nm | Mg:Ag = 1:9 80 nm |
| Embod iment 9 | HT-1:HI-1 = 97:3 10 nm | HT-1 60 nm | EB-1 30 nm | GH-1:GH-2:compound 204 = 69:30:1 30 nm | HB-1 5 nm | ET-1:Liq = 1:1 30 nm | LiF 1 nm | Mg:Ag = 1:9 80 nm |
| Embod iment 10 | HT-1:HI-1 = 97:3 10 nm | HT-1 60 nm | EB-1 30 nm | GH-1:GH-2:compound 222 = 69:30:1 30 nm | HB-1 5 nm | ET-1:Liq = 1:1 30 nm | LiF 1 nm | Mg:Ag = 1:9 80 nm |
| Embod iment 11 | HT-1:HI-1 = 97:3 10 nm | HT-1 60 nm | EB-1 30 nm | GH-1:GH-2:compound 268 = 69:30:1 30 nm | HB-1 5 nm | ET-1:Liq = 1:1 30 nm | LiF 1 nm | Mg:Ag = 1:9 80 nm |
| Embod iment 12 | HT-1:HI-1 = 97:3 10 nm | HT-1 60 nm | EB-1 30 nm | GH-1:GH-2:compound 280 = 69:30:1 30 nm | HB-1 5 nm | ET-1:Liq = 1:1 30 nm | LiF 1 nm | Mg:Ag = 1:9 80 nm |
| Embod iment 13 | HT-1:HI-1 = 97:3 10 nm | HT-1 60 nm | EB-1 30 nm | GH-1:GH-2:compound 327 = 69:30:1 30 nm | HB-1 5 nm | ET-1:Liq = 1:1 30 nm | LiF 1 nm | Mg:Ag = 1:9 80 nm |
| Embod iment 14 | HT-1:HI-1 = 97:3 10 nm | HT-1 60 nm | EB-1 30 nm | GH-1:GH-2:compound 331 = 69:30:1 30 nm | HB-1 5 nm | ET-1:Liq = 1:1 30 nm | LiF 1 nm | Mg:Ag = 1:9 80 nm |
| Embod iment 15 | HT-1:HI-1 = 97:3 10 nm | HT-1 60 nm | EB-1 30 nm | GH-1:GH-2:compound 343 = 69:30:1 30 nm | HB-1 5 nm | ET-1:Liq = 1:1 30 nm | LiF 1 nm | Mg:Ag = 1:9 80 nm |
| Embod iment 16 | HT-1:HI-1 = 97:3 10 nm | HT-1 60 nm | EB-1 30 nm | GH-1:GH-2:compound 367 = 69:30:1 30 nm | HB-1 5 nm | ET-1:Liq = 1:1 30 nm | LiF 1 nm | Mg:Ag = 1:9 80 nm |
| Embod iment 17 | HT-1:HI-1 = 97:3 10 nm | HT-1 60 nm | EB-1 30 nm | GH-1:GH-2:compound 320 = 69:30:1 30 nm | HB-1 5 nm | ET-1:Liq = 1:1 30 nm | LiF 1 nm | Mg:Ag = 1:9 80 nm |

| Device number | Hole injection layer /Thickness | Hole transport layer /Thickness | Electron blocking layer Thick-ness | Light-emitting layer /Thickness | Hole blocking layer /Thickness | Electron transport layer /Thick-ness | Electron injection layer /Thick-ness | Cathode layer /Thick-ness |
|---|---|---|---|---|---|---|---|---|
| Embod iment 18 | HT-1:HI-1 = 97:3 10 nm | HT-1 60 nm | EB-1 30 nm | GH-1:GH-2:compound 324 = 69:30:1 30 nm | HB-1 5 nm | ET-1:Liq = 1:1 30 nm | LiF 1 nm | Mg:Ag = 1:9 80 nm |
| Embod iment 19 | HT-1:HI-1 = 97:3 10 nm | HT-1 60 nm | EB-1 30 nm | GH-1:GH-2:compound 321 = 69:30:1 30 nm | HB-1 5 nm | ET-1:Liq = 1:1 30 nm | LiF 1 nm | Mg:Ag = 1:9 80 nm |
| Embod iment 20 | HT-1:HI-1 = 97:3 10 nm | HT-1 60 nm | EB-1 30 nm | GH-1:GH-2:compound 83 = 69:30:1 30 nm | HB-1 5 nm | ET-1:Liq = 1:1 30 nm | LiF 1 nm | Mg:Ag = 1:9 80 nm |
| Embod iment 21 | HT-1:HI-1 = 97:3 10 nm | HT-1 60 nm | EB-1 30 nm | GH-1:GH-2:compound 116 = 69:30:1 30 nm | HB-1 5 nm | ET-1:Liq = 1:1 30 nm | LiF 1 nm | Mg:Ag = 1:9 80 nm |
| Embod iment 22 | HT-1:HI-1 = 97:3 10 nm | HT-1 60 nm | EB-1 30 nm | GH-1:GH-2:compound 190 = 69:30:1 30 nm | HB-1 5 nm | ET-1:Liq = 1:1 30 nm | LiF 1 nm | Mg:Ag = 1:9 80 nm |
| Embod iment 23 | HT-1:HI-1 = 97:3 10 nm | HT-1 60 nm | EB-1 30 nm | GH-1:GH-2:compound 212 = 69:30:1 30 nm | HB-1 5 nm | ET-1:Liq = 1:1 30 nm | LiF 1 nm | Mg:Ag = 1:9 80 nm |
| Embod iment 24 | HT-1:HI-1 = 97:3 10 nm | HT-1 60 nm | EB-1 30 nm | GH-1:GH-2:compound 226 = 69:30:1 30 nm | HB-1 5 nm | ET-1:Liq = 1:1 30 nm | LiF 1 nm | Mg:Ag = 1:9 80 nm |

| Device number | Hole injection layer /Thick-ness | Hole transport layer /Thick-ness | Electron blocking layer /Thick-ness | Light-emitting layer /Thickness | Hole blocking layer /Thick-ness | Electron transport layer /Thick-ness | Electron injection layer /Thick-ness | Cathode layer /Thick-ness |
|---|---|---|---|---|---|---|---|---|
| Embod iment 25 | HT-1:HI-1 = 97:3 10 nm | HT-1 60 nm | EB-1 30 nm | GH-1:GH-2:compound 264 = 69:30:1 30 nm | HB-1 5 nm | ET-1:Liq = 1:1 30 nm | LiF 1 nm | Mg:Ag = 1:9 80 nm |
| Embod iment 26 | HT-1:HI-1 = 97:3 10 nm | HT-1 60 nm | EB-1 30 nm | GH-1:GH-2:compound 273 = 69:30:1 30 nm | HB-1 5 nm | ET-1:Liq = 1:1 30 nm | LiF 1 nm | Mg:Ag = 1:9 80 nm |
| Embod iment 27 | HT-1:HI-1 = 97:3 10 nm | HT-1 60 nm | EB-1 30 nm | GH-1:GH-2:compound 275 = 69:30:1 30 nm | HB-1 5 nm | ET-1:Liq = 1:1 30 nm | LiF 1 nm | Mg:Ag = 1:9 80 nm |
| Embod iment 28 | HT-1:HI-1 = 97:3 10 nm | HT-1 60 nm | EB-1 30 nm | GH-1:GH-2:compound 409 = 69:30:1 30 nm | HB-1 5 nm | ET-1:Liq = 1:1 30 nm | LiF 1 nm | Mg:Ag = 1:9 80 nm |
| Embod iment 29 | HT-1:HI-1 = 97:3 10 nm | HT-1 60 nm | EB-1 30 nm | GH-1:GH-2:compound 417 = 69:30:1 30 nm | HB-1 5 nm | ET-1:Liq = 1:1 30 nm | LiF 1 nm | Mg:Ag = 1:9 80 nm |
| Embod iment 30 | HT-1:HI-1 = 97:3 10 nm | HT-1 60 nm | EB-1 30 nm | GH-1:GH-2:compound 481 = 69:30:1 30 nm | HB-1 5 nm | ET-1:Liq = 1:1 30 nm | LiF 1 nm | Mg:Ag = 1:9 80 nm |
| Compa rative Exampl e 6 | HT-1:HI-1 = 97:3 10 nm | HT-1 60 nm | EB-1 30 nm | GH-1:GH-2:GD-1:ref-1 = 66:30:3:1 30 nm | HB-1 5 nm | ET-1:Liq = 1:1 30 nm | LiF 1 nm | Mg:Ag = 1:9 80 nm |
| Compa rative Exampl e 7 | HT-1:HI-1 = 97:3 10 nm | HT-1 60 nm | EB-1 30 nm | GH-1:GH-2:GD-1:ref-2 = 66:30:3:1 30 nm | HB-1 5 nm | ET-1:Liq = 1:1 30 nm | LiF 1 nm | Mg:Ag = 1:9 80 nm |
| Compa rative Exampl e 8 | HT-1:HI-1 = 97:3 10 nm | HT-1 60 nm | EB-1 30 nm | GH-1:GH-2:GD-1:ref-3 = 66:30:3:1 30 nm | HB-1 5 nm | ET-1:Liq = 1:1 30 nm | LiF 1 nm | Mg:Ag = 1:9 80 nm |
| Compa rative Exampl e 9 | HT-1:HI-1 = 97:3 10 nm | HT-1 60 nm | EB-1 30 nm | GH-1:GH-2:GD-1:ref-4 = 66:30:3:1 30 nm | HB-1 5 nm | ET-1:Liq = 1:1 30 nm | LiF 1 nm | Mg:Ag = 1:9 80 nm |
| Compa rative Exampl e 10 | HT-1:HI-1 = 97:3 10 nm | HT-1 60 nm | EB-1 30 nm | GH-1:GH-2:GD-1:ref-5 = 66:30:3:1 30 nm | HB-1 5 nm | ET-1:Liq = 1:1 30 nm | LiF 1 nm | Mg:Ag = 1:9 80 nm |
| Embod iment 31 | HT-1:HI-1 = 97:3 10 nm | HT-1 60 nm | EB-1 30 nm | GH-1:GH-2:GD-1:compound 5 = 66:30:3:1 30 nm | HB-1 5 nm | ET-1:Liq = 1:1 30 nm | LiF 1 nm | Mg:Ag = 1:9 80 nm |
| Embod iment 32 | HT-1:HI-1 = 97:3 10 nm | HT-1 60 nm | EB-1 30 nm | GH-1:GH-2:GD-1:compound 17 = 66:30:3:1 30 nm | HB-1 5 nm | ET-1:Liq = 1:1 30 nm | LiF 1 nm | Mg:Ag = 1:9 80 nm |
| Embod iment 33 | HT-1:HI-1 = 97:3 10 nm | HT-1 60 nm | EB-1 30 nm | GH-1:GH-2:GD-1:compound 41 = 66:30:3:1 30 nm | HB-1 5 nm | ET-1:Liq = 1:1 30 nm | LiF 1 nm | Mg:Ag = 1:9 80 nm |
| Embod iment 34 | HT-1:HI-1 = 97:3 10 nm | HT-1 60 nm | EB-1 30 nm | GH-1:GH-2:GD-1: compound 154 = 66:30:3:1 30 nm | HB-1 5 nm | ET-1:Liq = 1:1 30 nm | LiF 1 nm | Mg:Ag = 1:9 80 nm |
| Embod iment 35 | HT-1:HI-1 = 97:3 10 nm | HT-1 60 nm | EB-1 30 nm | GH-1:GH-2:GD-1: compound 182 = 66:30:3:1 30 nm | HB-1 5 nm | ET-1:Liq = 1:1 30 nm | LiF 1 nm | Mg:Ag = 1:9 80 nm |
| Embod iment 36 | HT-1:HI-1 = 97:3 10 nm | HT-1 60 nm | EB-1 30 nm | GH-1:GH-2:GD-1: compound 183 = 66:30:3:1 30 nm | HB-1 5 nm | ET-1:Liq = 1:1 30 nm | LiF 1 nm | Mg:Ag = 1:9 80 nm |
| Embod iment 37 | HT-1:HI-1 = 97:3 10 nm | HT-1 60 nm | EB-1 30 nm | GH-1:GH-2:GD-1: compound 186 = 66:30:3:1 30 nm | HB-1 5 nm | ET-1:Liq = 1:1 30 nm | LiF 1 nm | Mg:Ag = 1:9 80 nm |
| Embod iment 38 | HT-1:HI-1 = 97:3 10 nm | HT-1 60 nm | EB-1 30 nm | GH-1:GH-2:GD-1: compound 188 = 66:30:3:1 30 nm | HB-1 5 nm | ET-1:Liq = 1:1 30 nm | LiF 1 nm | Mg:Ag = 1:9 80 nm |
| Embod iment 39 | HT-1:HI-1 = 97:3 10 nm | HT-1 60 nm | EB-1 30 nm | GH-1:GH-2:GD-1: compound 204 = 66:30:3:1 30 nm | HB-1 5 nm | ET-1:Liq = 1:1 30 nm | LiF 1 nm | Mg:Ag = 1:9 80 nm |
| Embod iment 40 | HT-1:HI-1 = 97:3 10 nm | HT-1 60 nm | EB-1 30 nm | GH-1:GH-2:GD-1: compound 222 = 66:30:3:1 30 nm | HB-1 5 nm | ET-1:Liq = 1:1 30 nm | LiF 1 nm | Mg:Ag = 1:9 80 nm |
| Embod iment 41 | HT-1:HI-1 = 97:3 10 nm | HT-1 60 nm | EB-1 30 nm | GH-1:GH-2:GD-1: compound 268 = 66:30:3:1 30 nm | HB-1 5 nm | ET-1:Liq = 1:1 30 nm | LiF 1 nm | Mg:Ag = 1:9 80 nm |
| Embod iment 42 | HT-1:HI-1 = 97:3 10 nm | HT-1 60 nm | EB-1 30 nm | GH-1:GH-2:GD-1: compound 280 = 66:30:3:1 30 nm | HB-1 5 nm | ET-1:Liq = 1:1 30 nm | LiF 1 nm | Mg:Ag = 1:9 80 nm |
| Embod iment 43 | HT-1:HI-1 = 97:3 10 nm | HT-1 60 nm | EB-1 30 nm | GH-1:GH-2:GD-1: compound 327 = 66:30:3:1 30 nm | HB-1 5 nm | ET-1:Liq = 1:1 30 nm | LiF 1 nm | Mg:Ag = 1:9 80 nm |
| Embod iment 44 | HT-1:HI-1 = 97:3 10 nm | HT-1 60 nm | EB-1 30 nm | GH-1:GH-2:GD-1: compound 331 = 66:30:3:1 30 nm | HB-1 5 nm | ET-1:Liq = 1:1 30 nm | LiF 1 nm | Mg:Ag = 1:9 80 nm |
| Embod iment 45 | HT-1:HI-1 = 97:3 10 nm | HT-1 60 nm | EB-1 30 nm | GH-1:GH-2:GD-1: compound 343 = 66:30:3:1 30 nm | HB-1 5 nm | ET-1:Liq = 1:1 30 nm | LiF 1 nm | Mg:Ag = 1:9 80 nm |
| Embod iment 46 | HT-1:HI-1 = 97:3 10 nm | HT-1 60 nm | EB-1 30 nm | GH-1:GH-2:GD-1: compound 367 = 66:30:3:1 30 nm | HB-1 5 nm | ET-1:Liq = 1:1 30 nm | LiF 1 nm | Mg:Ag = 1:9 80 nm |
| Embod iment 47 | HT-1:HI-1 = 97:3 10 nm | HT-1 60 nm | EB-1 30 nm | GH-1:GH-2:GD-1: compound 320 = 66:30:3:1 30 nm | HB-1 5 nm | ET-1:Liq = 1:1 30 nm | LiF 1 nm | Mg:Ag = 1:9 80 nm |
| Embod iment 48 | HT-1:HI-1 = 97:3 10 nm | HT-1 60 nm | EB-1 30 nm | GH-1:GH-2:GD-1: compound 324 = 66:30:3:1 30 nm | HB-1 5 nm | ET-1:Liq = 1:1 30 nm | LiF 1 nm | Mg:Ag = 1:9 80 nm |
| Embod iment 49 | HT-1:HI-1 = 97:3 10 nm | HT-1 60 nm | EB-1 30 nm | GH-1:GH-2:GD-1: compound 321 = 66:30:3:1 30 nm | HB-1 5 nm | ET-1:Liq = 1:1 30 nm | LiF 1 nm | Mg:Ag = 1:9 80 nm |
| Embod iment 50 | HT-1:HI-1 = 97:3 10 nm | HT-1 60 nm | EB-1 30 nm | GH-1:GH-2:GD-1:compound 83 = 66:30:3:1 30 nm | HB-1 5 nm | ET-1:Liq = 1:1 30 nm | LiF 1 nm | Mg:Ag = 1:9 80 nm |
| Embod iment 51 | HT-1:HI-1 = 97:3 10 nm | HT-1 60 nm | EB-1 30 nm | GH-1:GH-2:GD-1: compound 116 = 66:30:3:1 30 nm | HB-1 5 nm | ET-1:Liq = 1:1 30 nm | LiF 1 nm | Mg:Ag = 1:9 80 nm |
| Embod iment 52 | HT-1:HI-1 = 97:3 10 nm | HT-1 60 nm | EB-1 30 nm | GH-1:GH-2:GD-1: compound 190 = 66:30:3:1 30 nm | HB-1 5 nm | ET-1:Liq = 1:1 30 nm | LiF 1 nm | Mg:Ag = 1:9 80 nm |
| Embod iment 53 | HT-1:HI-1 = 97:3 10 nm | HT-1 60 nm | EB-1 30 nm | GH-1:GH-2:GD-1: compound 212 = 66:30:3:1 30 nm | HB-1 5 nm | ET-1:Liq = 1:1 30 nm | LiF 1 nm | Mg:Ag = 1:9 80 nm |
| Embod iment 54 | HT-1:HI-1 = 97:3 10 nm | HT-1 60 nm | EB-1 30 nm | GH-1:GH-2:GD-1: compound 226 = 66:30:3:1 30 nm | HB-1 5 nm | ET-1:Liq = 1:1 30 nm | LiF 1 nm | Mg:Ag = 1:9 80 nm |
| Embod iment 55 | HT-1:HI-1 = 97:3 10 nm | HT-1 60 nm | EB-1 30 nm | GH-1:GH-2:GD-1: compound 264 = 66:30:3:1 30 nm | HB-1 5 nm | ET-1:Liq = 1:1 30 nm | LiF 1 nm | Mg:Ag = 1:9 80 nm |
| Embod iment 56 | HT-1:HI-1 = 97:3 10 nm | HT-1 60 nm | EB-1 30 nm | GH-1:GH-2:GD-1: compound 273 = 66:30:3:1 30 nm | HB-1 5 nm | ET-1:Liq = 1:1 30 nm | LiF 1 nm | Mg:Ag = 1:9 80 nm |
| Embod iment 57 | HT-1:HI-1 = 97:3 10 nm | HT-1 60 nm | EB-1 30 nm | GH-1:GH-2:GD-1: compound 275 = 66:30:3:1 30 nm | HB-1 5 nm | ET-1:Liq = 1:1 30 nm | LiF 1 nm | Mg:Ag = 1:9 80 nm |
| Embod iment 58 | HT-1:HI-1 = 97:3 10 nm | HT-1 60 nm | EB-1 30 nm | GH-1:GH-2:GD-1: compound 409 = 66:30:3:1 30 nm | HB-1 5 nm | ET-1:Liq = 1:1 30 nm | LiF 1 nm | Mg:Ag = 1:9 80 nm |
| Embod iment 59 | HT-1:HI-1 = 97:3 10 nm | HT-1 60 nm | EB-1 30 nm | GH-1:GH-2:GD-1: compound 417 = 66:30:3:1 30 nm | HB-1 5 nm | ET-1:Liq = 1:1 30 nm | LiF 1 nm | Mg:Ag = 1:9 80 nm |
| Embod iment 60 | HT-1:HI-1 = 97:3 10 nm | HT-1 60 nm | EB-1 30 nm | GH-1:GH-2:GD-1: compound 481 = 66:30:3:1 30 nm | HB-1 5 nm | ET-1:Liq = 1:1 30 nm | LiF 1 nm | Mg:Ag = 1:9 80 nm |

**Table 4**

| Device embodiment | Current efficiency (cd/A) | Luminescence peak (nm) | LT95 lifetime (H) | Device embodiment | Current efficiency (cd/A) | Luminescence peak (nm) | LT95 lifetime (H) |
|---|---|---|---|---|---|---|---|
| Comparative Example 1 | 44.33 | 527 | 0.1 | Comparative Example 6 | 52.13 | 528 | 0.7 |
| Comparative Example 2 | 59.43 | 533 | 61 | Comparative Example 7 | 68.16 | 534 | 107 |
| Comparative Example 3 | 51.23 | / | 188 | Comparative Example 8 | 53.63 | / | 269 |
| Comparative Example 4 | 50.87 | / | 191 | Comparative Example 9 | 62.58 | / | 275 |
| Comparative Example 5 | 32.47 | / | 84 | Comparative Example 10 | 42.71 | / | 112 |
| Embodiment 1 | 55.88 | 524 | 255 | Embodiment 31 | 60.53 | 527 | 345 |
| Embodiment 2 | 54.79 | 526 | 266 | Embodiment 32 | 59.41 | 528 | 359 |
| Embodiment 3 | 51.19 | 526 | 268 | Embodiment 33 | 56.44 | 527 | 363 |
| Embodiment 4 | 60.29 | 529 | 271 | Embodiment 34 | 65.04 | 533 | 377 |
| Embodiment 5 | 60.28 | 526 | 330 | Embodiment 35 | 65.66 | 530 | 460 |
| Embodiment 6 | 61.24 | 528 | 308 | Embodiment 36 | 66.12 | 531 | 448 |
| Embodiment 7 | 63.44 | 533 | 322 | Embodiment 37 | 68.17 | 534 | 478 |
| Embodiment 8 | 58.96 | 534 | 299 | Embodiment 38 | 67.63 | 536 | 406 |
| Embodiment 9 | 59.96 | 534 | 297 | Embodiment 39 | 65.86 | 536 | 402 |
| Embodiment 10 | 60.58 | 535 | 337 | Embodiment 40 | 69.72 | 535 | 465 |
| Embodiment 11 | 60.05 | 537 | 296 | Embodiment 41 | 64.86 | 537 | 399 |
| Embodiment 12 | 56.72 | 518 | 299 | Embodiment 42 | 62.51 | 520 | 398 |
| Embodiment 13 | 61.04 | 522 | 250 | Embodiment 43 | 66.17 | 525 | 361 |
| Embodiment 14 | 53.56 | 527 | 271 | Embodiment 44 | 60.73 | 528 | 364 |
| Embodiment 15 | 58.7 | 523 | 245 | Embodiment 45 | 63.83 | 524 | 343 |
| Embodiment 16 | 51.59 | 525 | 235 | Embodiment 46 | 56.87 | 527 | 344 |
| Embodiment 17 | 58.62 | 541 | 219 | Embodiment 47 | 61.98 | 542 | 318 |
| Embodiment 18 | 56.84 | 533 | 248 | Embodiment 48 | 63.16 | 534 | 345 |
| Embodiment 19 | 54.25 | 517 | 273 | Embodiment 49 | 59.02 | 520 | 368 |
| Embodiment 20 | 54.39 | 518 | 311 | Embodiment 50 | 59.31 | 519 | 423 |
| Embodiment 21 | 53.82 | 516 | 303 | Embodiment 51 | 58.86 | 525 | 403 |
| Embodiment 22 | 61.21 | 532 | 328 | Embodiment 52 | 66.33 | 533 | 457 |
| Embodiment 23 | 52.83 | 531 | 309 | Embodiment 53 | 52.77 | 532 | 418 |
| Embodiment 24 | 60.76 | 536 | 332 | Embodiment 54 | 65.96 | 535 | 469 |
| Embodiment 25 | 52.91 | 531 | 312 | Embodiment 55 | 57.86 | 532 | 419 |
| Embodiment 26 | 60.41 | 537 | 329 | Embodiment 56 | 65.35 | 536 | 462 |
| Embodiment 27 | 63.42 | 536 | 354 | Embodiment 57 | 68.64 | 535 | 486 |
| Embodiment 28 | 56.34 | 528 | 311 | Embodiment 58 | 61.27 | 529 | 421 |
| Embodiment 29 | 55.19 | 529 | 305 | Embodiment 59 | 60.02 | 528 | 413 |
| Embodiment 30 | 64.31 | 536 | 348 | Embodiment 60 | 69.64 | 537 | 483 |

| | | | | | | | |
|---|---|---|---|---|---|---|---|
| Note: The current efficiency and luminescence peak are measured by using an IVL (current-voltage-luminance) measurement system (Suzhou Fstar Scientific Instruments Co., Ltd.); a lifetime testing system is an EAS-62C OLED device lifetime tester from Japan Giken company; LT95 is time taken for the device luminance to decay to 95%; and all data is measured at 10 mA/cm². | | | | | | | |

It can be learned from the device data results in Table 4 that, compared with Device Comparative Examples 1 to 5, a device lifetime of the device of a single-doped system with the compound in the present invention is longer than those in Comparative Examples 1 to 5, and the device efficiency of the device of the single-doped system is also good; and compared with Device Comparative Examples 6 to 10, the current efficiency and device lifetime of the device of a double-doped system with the compound in the present invention using an exciton-sensitizing material as a first doping material are greatly improved compared with an OLED device with a known material, and the device efficiency of the double-doped device is also significantly improved compared with the single-doped device.

In conclusion, the foregoing descriptions are merely preferred embodiments of the present invention, but are not intended to limit the present invention. Any modification, equivalent replacement, and improvement made within the spirit and principle of the present invention shall fall within the protection scope of the present invention.

## Claims

1. A boron-containing organic compound, wherein a structure of the boron-containing organic compound is shown in general formula (A-1): 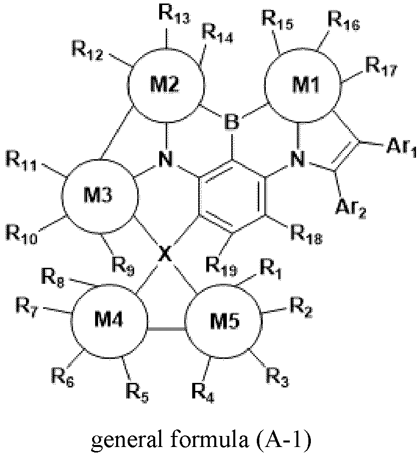
in general formula (A-1), R₁ to R₁₉ each time present identically or differently represent one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkenyl, substituted or unsubstituted C1-C10 alkynyl, substituted or unsubstituted silanyl, substituted or unsubstituted boranyl, substituted or unsubstituted C1-C10 alkoxy, substituted or unsubstituted C6-C30 aryloxy, substituted or unsubstituted arylamido, substituted or unsubstituted C6-C30 aryl, and substituted or unsubstituted C2-C30 heteroaryl;
any adjacent two of R₁ to R₁₇ are linkable to form a ring;
R₁₈ and R₁₉ are linkable to form a ring;
Ar₁ and Ar₂ each time present identically or differently represent one of a hydrogen atom, substituted or unsubstituted C1-C10 alkyl, substituted or unsubstituted C3-C10 cycloalkyl, substituted or unsubstituted C1-C10 alkenyl, substituted or unsubstituted C1-C10 alkynyl, substituted or unsubstituted silanyl, substituted or unsubstituted boranyl, substituted or unsubstituted C1-C10 alkoxy, substituted or unsubstituted C6-C30 aryloxy, substituted or unsubstituted arylamido, substituted or unsubstituted C6-C30 aryl, and substituted or unsubstituted C2-C30 heteroaryl;
M₁, M₂, M₃, M₄, and M₅ each independently represent one of a substituted or
unsubstituted C₆-C₃₀ aromatic ring, a substituted or unsubstituted 5-membered to 30-membered heteroaromatic ring, and a substituted or unsubstituted C6-C10 aliphatic ring;
X represents C or Si; and
a substituent for substituting a group is optionally selected from any one of deuterium, tritium, a halogen atom, cyano, C1-C10 alkyl, deuterium- or tritium-substituted C1-C10 alkyl, C6-C30 aryl, deuterium- or tritium-substituted C6-C30 aryl, C2-C30 heteroaryl, and deuterium- or tritium-substituted C2-C30 heteroaryl.

2. The boron-containing organic compound according to claim 1, wherein a structure of the boron-containing organic compound is shown in general formula (A): 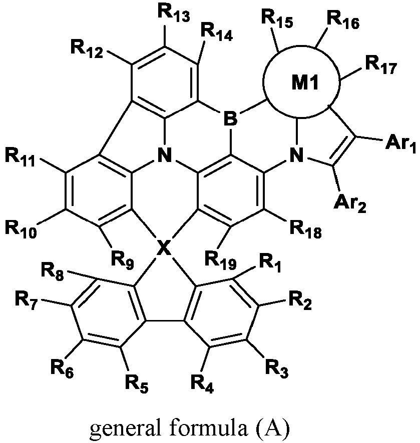
in general formula (A), R₁ to R₁₉ each time present identically or differently represent one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
any adjacent two of R₁ to R₁₄ are linkable to form a ring;
R₁₈ and R₁₉ are linkable to form a ring;
Ar₁ and Ar₂ each time present identically or differently represent one of substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
M₁ represents one of a substituted or unsubstituted C₆-C₃₀ aromatic ring and a substituted or unsubstituted 5-membered to 30-membered heteroaromatic ring; X represents C or Si; and
a substituent for substituting a group is optionally selected from any one of deuterium, tritium, a halogen atom, cyano, C1-C10 alkyl, deuterium- or tritium-substituted C1-C10 alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

3. The boron-containing organic compound according to claim 2, wherein a structure of the boron-containing organic compound is shown in any one of general formula (1-1) and general formula (1-2): 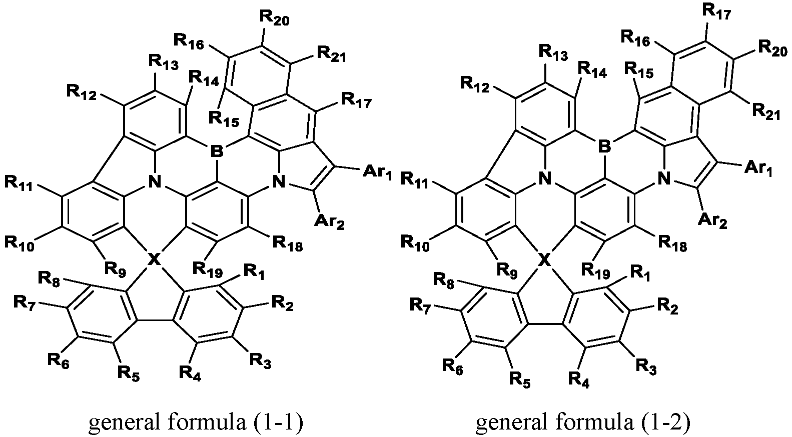
in general formula (1-1) and general formula (1-2), R₁ to R₂₁ each time present identically or differently represent one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
any adjacent two of R₁ to R₂₁ are linkable to form a ring;
Ar₁ and Ar₂ each time present identically or differently represent one of substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
X represents C or Si; and
a substituent for substituting a group is optionally selected from any one of deuterium, tritium, a halogen atom, cyano, C1-C10 alkyl, deuterium- or tritium-substituted C1-C10 alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

4. The boron-containing organic compound according to claim 1, wherein a structure of the boron-containing organic compound is shown in any one of general formula (1-3) and general formula (1-4): 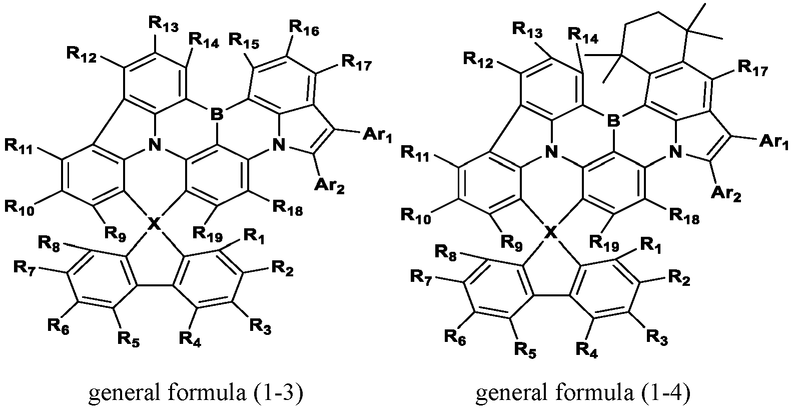
in general formula (1-3) and general formula (1-4), R₁ to R₁₉ each time present identically or differently represent one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkenyl, substituted or unsubstituted C1-C10 alkynyl, substituted or unsubstituted silanyl, substituted or unsubstituted boranyl, substituted or unsubstituted C1-C10 alkoxy, substituted or unsubstituted C6-C30 aryloxy, substituted or unsubstituted arylamido, substituted or unsubstituted C6-C30 aryl, and substituted or unsubstituted C2-C30 heteroaryl;
any adjacent two of R₁ to R₁₉ are linkable to form a ring;
Ar₁ and Ar₂ each time present identically or differently represent one of substituted or unsubstituted C1-C10 alkyl, substituted or unsubstituted C3-C10 cycloalkyl, substituted or unsubstituted C1-C10 alkenyl, substituted or unsubstituted C1-C10 alkynyl, substituted or unsubstituted silanyl, substituted or unsubstituted boranyl, substituted or unsubstituted C1-C10 alkoxy, substituted or unsubstituted C6-C30 aryloxy, substituted or unsubstituted arylamido, substituted or unsubstituted C6-C30 aryl, and substituted or unsubstituted C2-C30 heteroaryl;
X represents C or Si; and
a substituent for substituting a group is optionally selected from any one of deuterium, tritium, a halogen atom, cyano, C1-C10 alkyl, deuterium- or tritium-substituted C1-C10 alkyl, C₆-C₃₀ aryl, deuterium- or tritium-substituted C₆-C₃₀ aryl, C₂-C₃₀ heteroaryl, and deuterium- or tritium-substituted C₂-C₃₀ heteroaryl.

5. The boron-containing organic compound according to claim 2, wherein a structure of the boron-containing organic compound is shown in general formula (2): 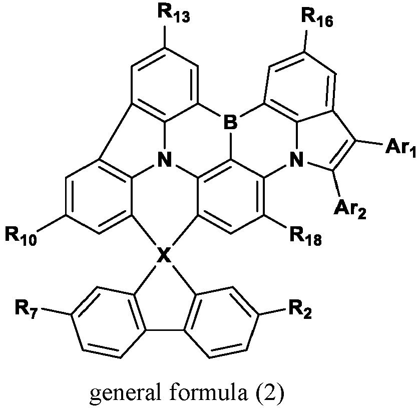 in general formula (2), meanings of R₂, R₇, R₁₀, R₁₃, R₁₆, R₁₈, Ar₁, Ar₂, and X are the same as those defined according to claim 2.

6. The boron-containing organic compound according to claim 2, wherein a structure of the boron-containing organic compound is shown in any one of general formula (2-1) and general formula (2-2): 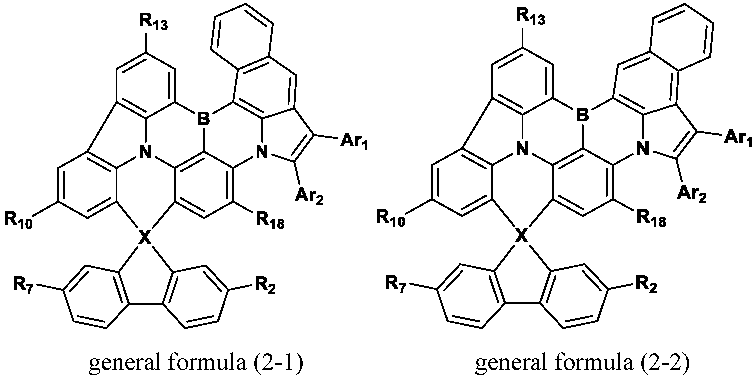 in general formula (2-1) and general formula (2-2), meanings of R₂, R₇, R₁₀, R₁₃, R₁₈, Ar₁, Ar₂, and X are the same as those defined according to claim 2.

7. The boron-containing organic compound according to claim 2, wherein a structure of the boron-containing organic compound is shown in general formula (3-1): 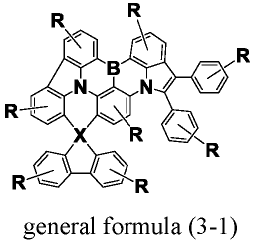
in general formula (3-1), R each time present identically or differently represents one of a hydrogen atom, a deuterium atom, a tritium atom, a halogen atom, cyano, substituted or unsubstituted C1-C10 alkyl, substituted or unsubstituted C3-C10 cycloalkyl, substituted or unsubstituted C1-C10 alkoxy, substituted or unsubstituted C1-C10 aryloxy, substituted or unsubstituted arylamido, substituted or unsubstituted C6-C30 aryl, and substituted or unsubstituted C2-C30 heteroaryl;
X represents C or Si; and
a substituent for substituting a group is optionally selected from any one of deuterium, tritium, a halogen atom, cyano, C1-C10 alkyl, deuterium- or tritium-substituted C1-C10 alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

8. The boron-containing organic compound according to any one of claims 1 to 7, wherein R and R₁ to R₂₁ each independently represent one of a hydrogen atom, a deuterium atom, a tritium atom, a fluorine atom, cyano, adamantyl, methyl, deuterated methyl, tritiated methyl, trifluoromethyl, ethyl, deuterated ethyl, tritiated ethyl, isopropyl, deuterated isopropyl, tritiated isopropyl, tert-butyl, deuterated tert-butyl, tritiated tert-butyl, cyclopentyl, deuterated cyclopentyl, tritiated cyclopentyl, methyl-substituted cyclopentyl, cyclohexyl, phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, tert-butyl-substituted dibenzofuryl, phenyl-substituted tert-butyl, xanthone, phenyl-substituted triazinyl, phenyl-substituted boranyl, methoxy, and tert-butoxy;
Ar₁ and Ar₂ each independently represent one of phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, phenyl-substituted amino, tert-butylbenzene-substituted amino, tert-butyl-substituted dibenzofuryl, phenyl-substituted tert-butyl, xanthone, phenyl-substituted triazinyl, phenyl-substituted boranyl, methoxy, and tert-butoxy;
M₁, M₂, M₃, M₄, and M₅ represent one of phenyl, deuterated phenyl, diphenyl, deuterated diphenyl, triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, phenyl-substituted amino, tert-butyl-substituted dibenzofuryl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, and xanthone; and
a substituent for substituting a substitutable group is optionally selected from one or more of a deuterium atom, a chlorine atom, a fluorine atom, trifluoromethyl, adamantyl, cyano, methyl, ethyl, propyl, isopropyl, tert-pentyl, tert-butyl, butyl, methoxy, phenyl, diphenyl, naphthyl, anthryl, phenanthryl, pyridinyl, pyrimidinyl, pyrazinyl, pyridazinyl, benzoxazolyl, benzothiazolyl, quinoxalinyl, quinolyl, isoquinolyl, furyl, thienyl, indolyl, pyrrolyl, dibenzofuryl, dibenzothienyl, 9,9-dimethylfluorenyl, spirofluorenyl, carbazolyl, N-phenylcarbazolyl, carbazolinyl, and azaphenanthryl.

9. The boron-containing organic compound according to any one of claims 1 to 7, wherein R and R₁ to R₂₁ each independently represent the following structures: any one of a hydrogen atom, cyano, 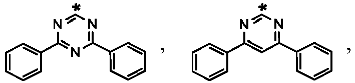 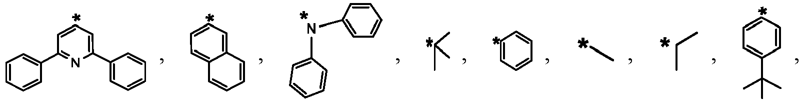 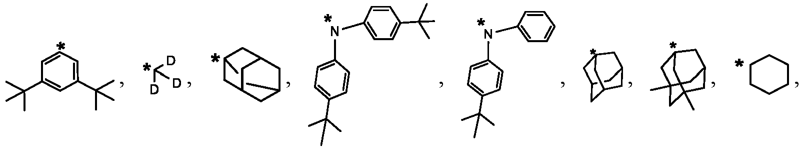 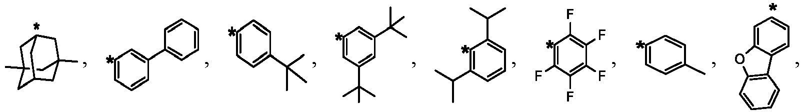 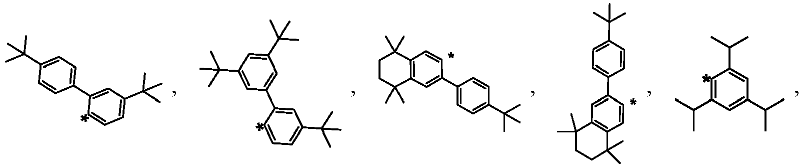 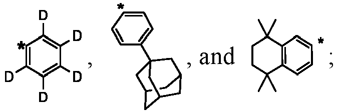
Ar₁ and Ar₂ represent the following structures:
any one of 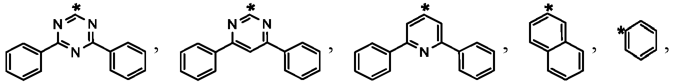 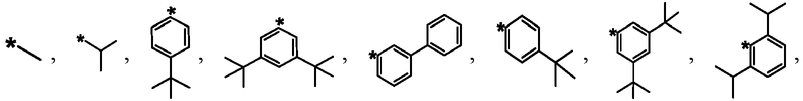 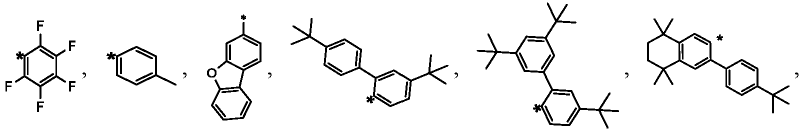 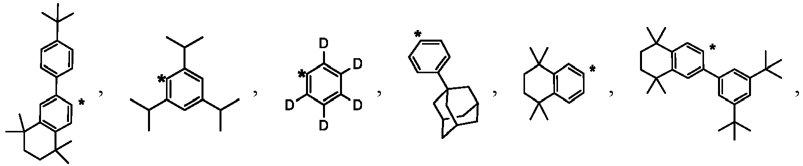 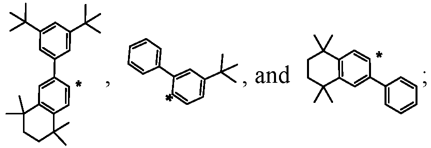
M₁, M₂, and M₃ represent any one of the following ring structures: 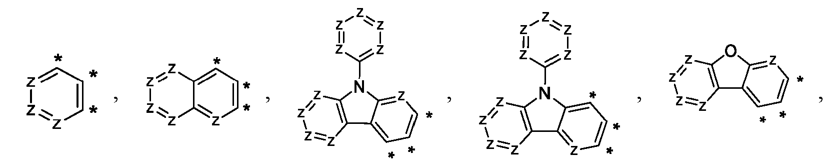 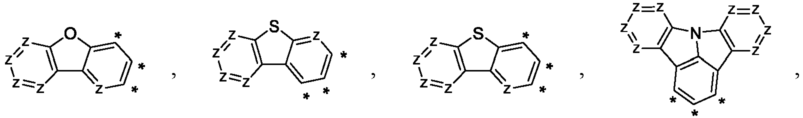 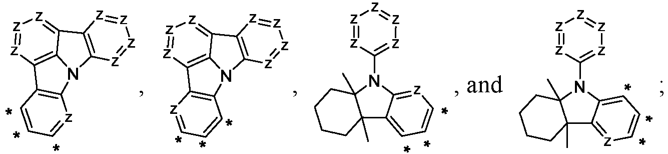
M₄ and M₅ represent any one of the following ring structures: 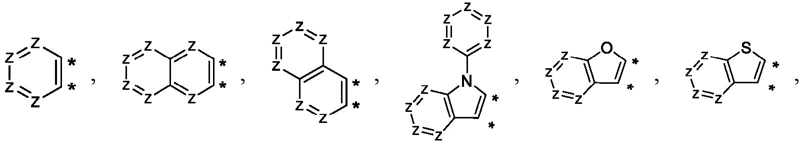 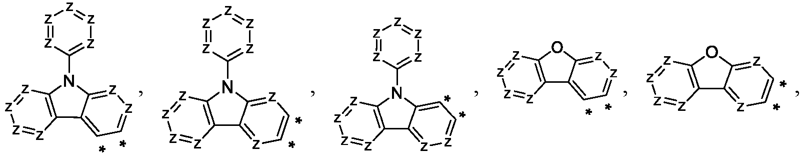 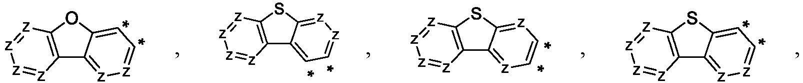 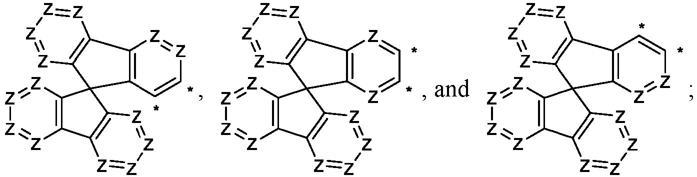
Z represents C-Rₐ; and
Rₐ each time present independently represents one of a hydrogen atom, a deuterium atom, a tritium atom, a halogen atom, cyano, adamantyl, methyl, deuterated methyl, tritiated methyl, trifluoromethyl, ethyl, deuterated ethyl, tritiated ethyl, isopropyl, deuterated isopropyl, tritiated isopropyl, tert-butyl, deuterated tert-butyl, tritiated tert-butyl, cyclopentyl, deuterated cyclopentyl, tritiated cyclopentyl, methyl-substituted cyclopentyl, cyclohexyl, phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, phenyl-substituted amino, tert-butylbenzene-substituted amino, tert-butyl-substituted dibenzofuryl, phenyl-substituted tert-butyl, xanthone, phenyl-substituted triazinyl, phenyl-substituted boranyl, methoxy, and tert-butoxy.

10. The boron-containing organic compound according to any one of claims 1 to 7, wherein R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀, and R₂₁ each time present identically or differently represent: any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 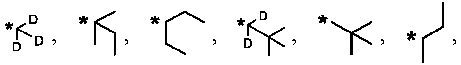 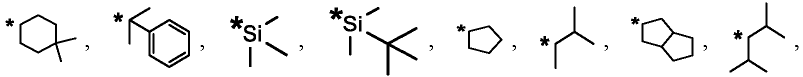 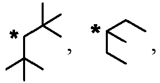 or phenyl;
Ar₁ and Ar₂ each time present identically or differently represent:
any one of methyl, 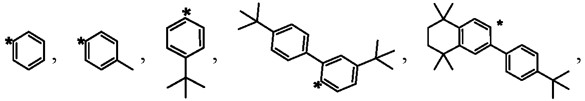 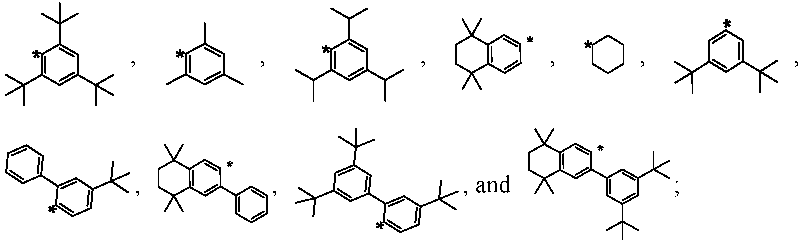
M₁, M₂, and M₃ represent any one of the following ring structures: 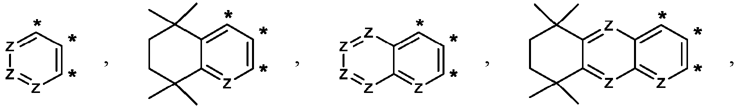 and 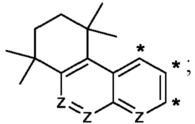
M₄ and M₅ represent the following ring structure: 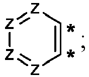
Z represents C-Rₐ;
Rₐ each time present independently represents: any one of a hydrogen atom, a deuterium atom, cyano, methyl, ethyl, isopropyl, tert-butyl, trifluoromethyl, deuterated methyl, deuterated ethyl, deuterated isopropyl, deuterated tert-butyl, 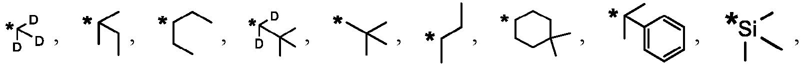 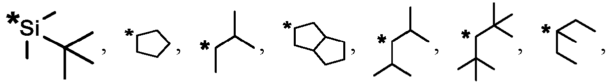 or phenyl; and
X represents C or Si.

11. The boron-containing organic compound according to claim 1, wherein a specific structural formula of the boron-containing organic compound is any one of the following structures:

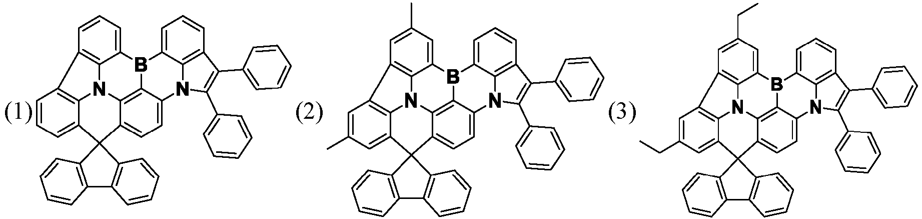

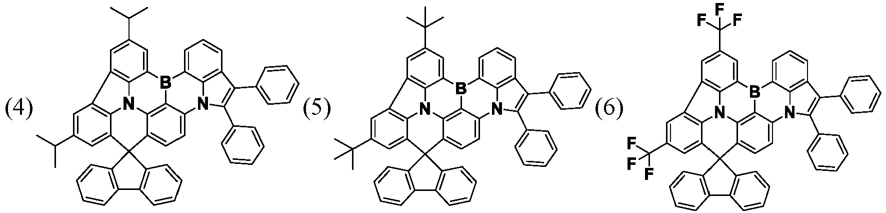

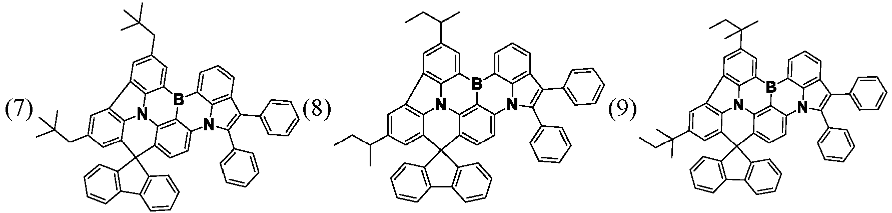

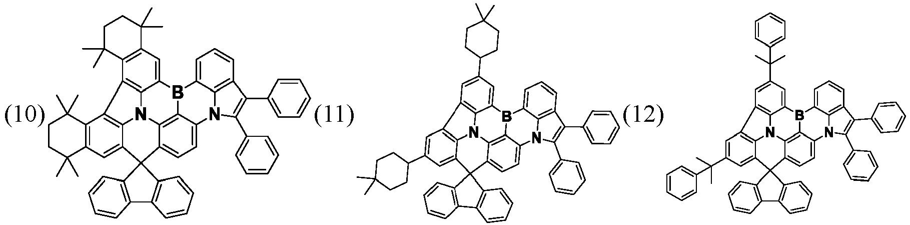

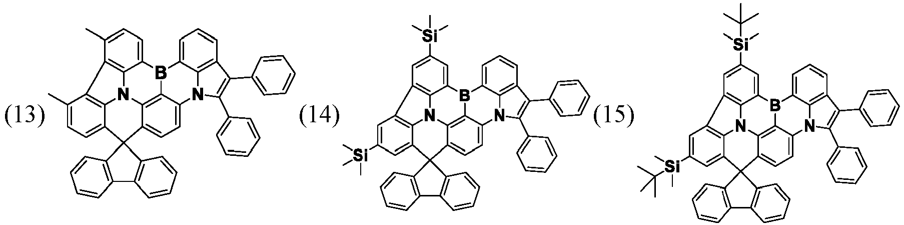

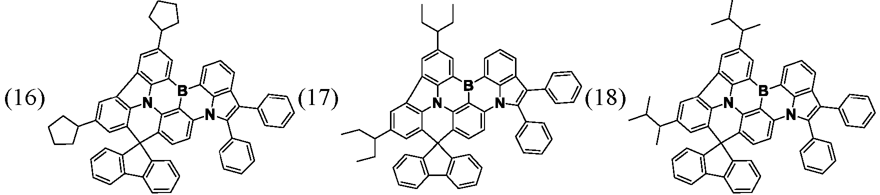

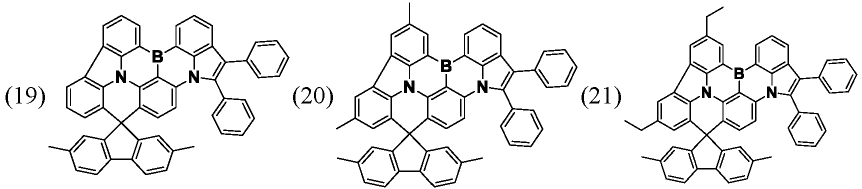

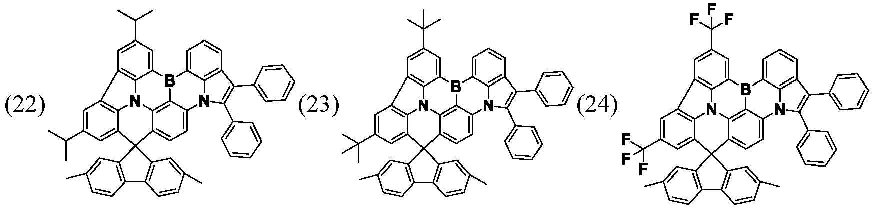

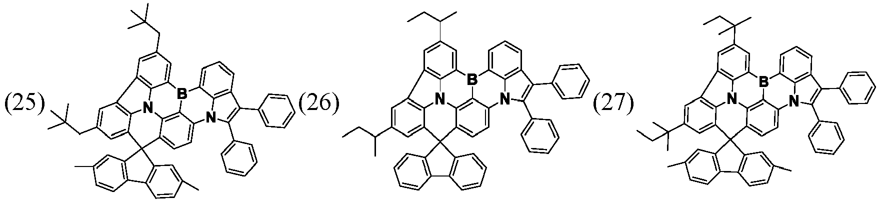

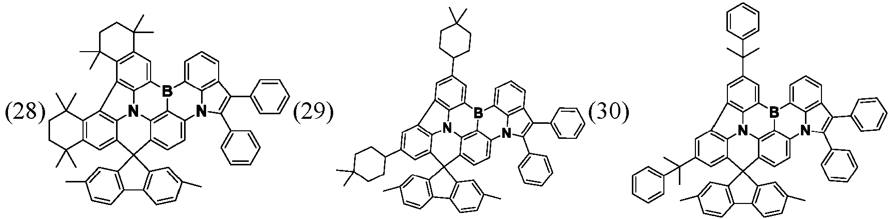

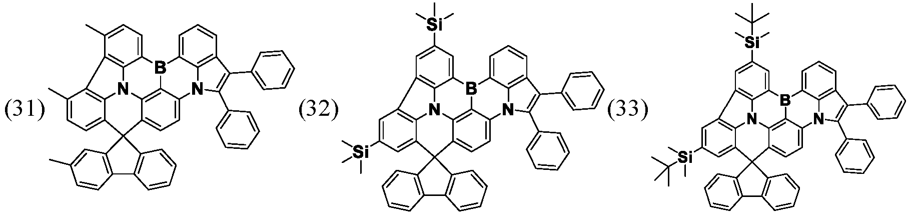

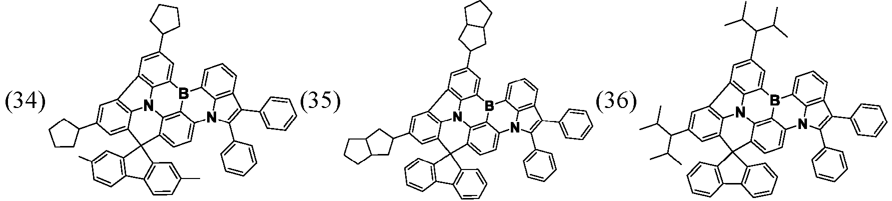

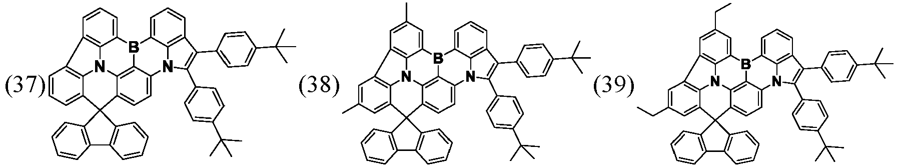

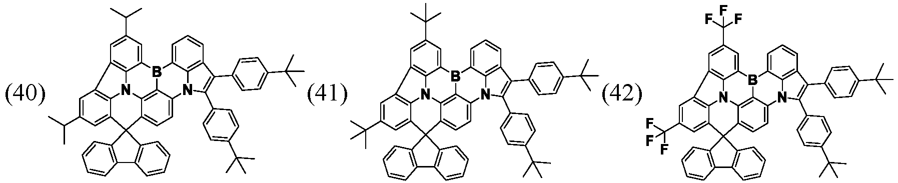

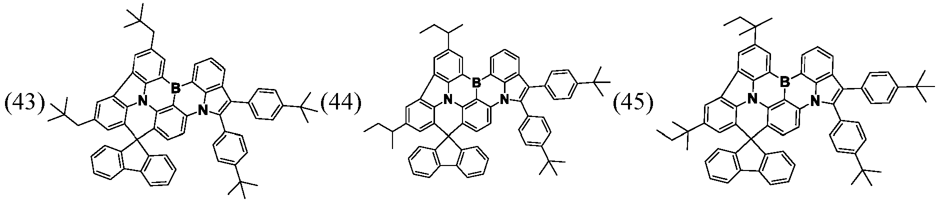

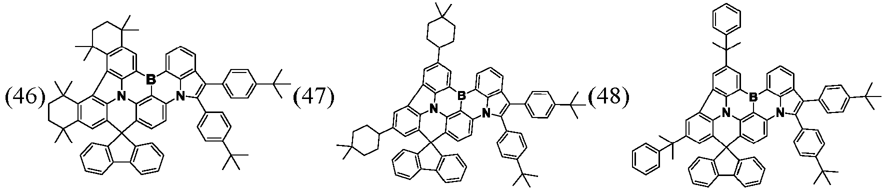

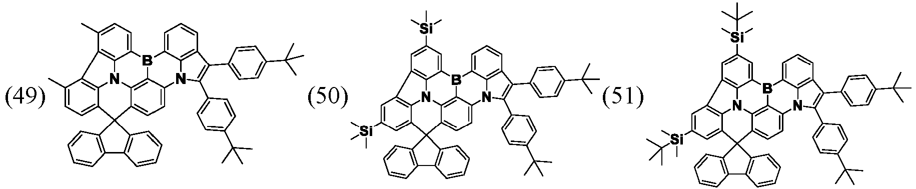

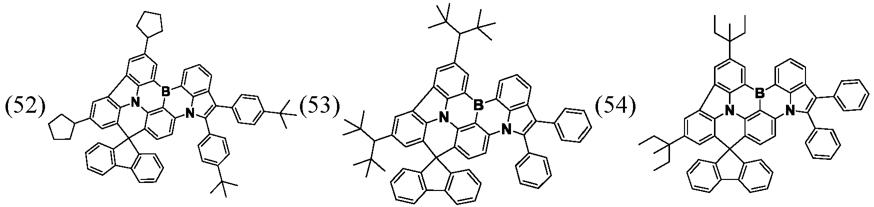

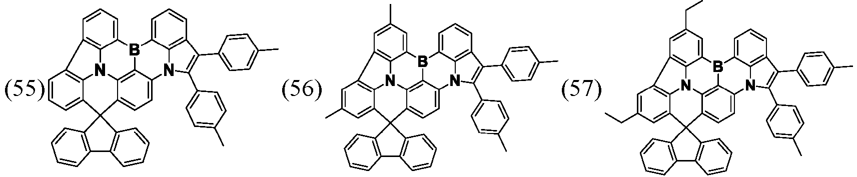

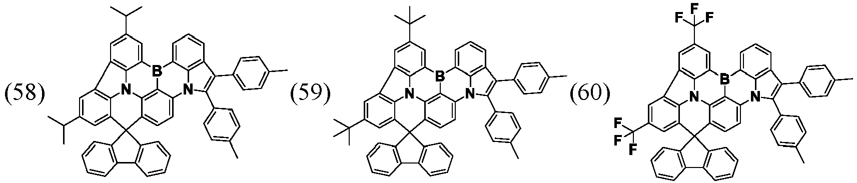

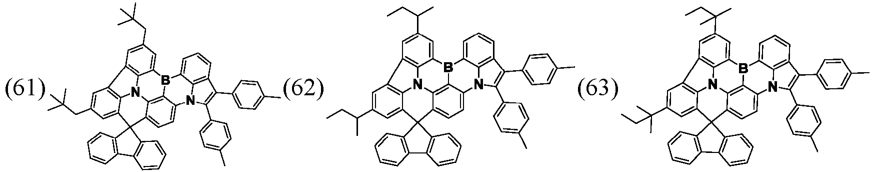

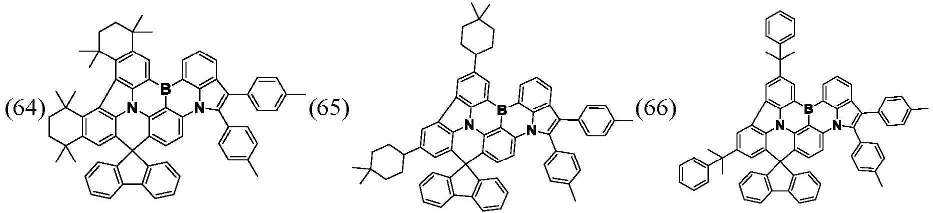

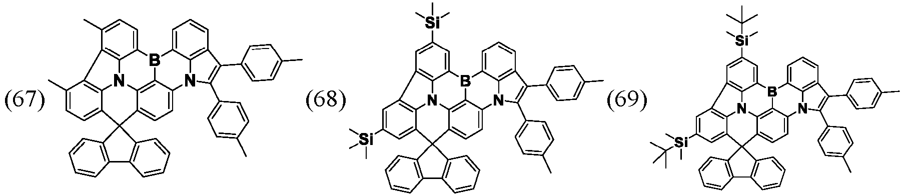

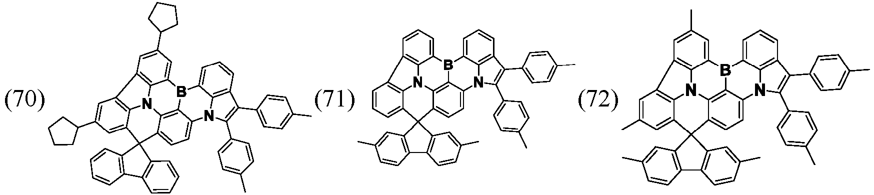

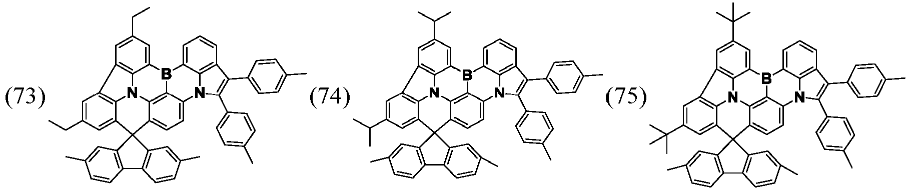

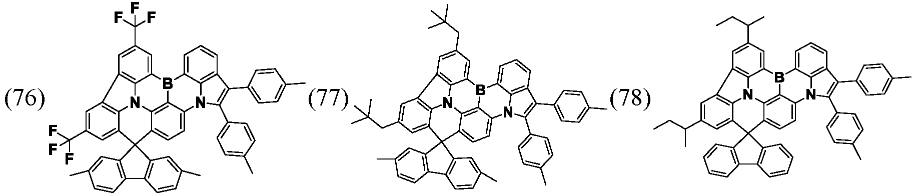

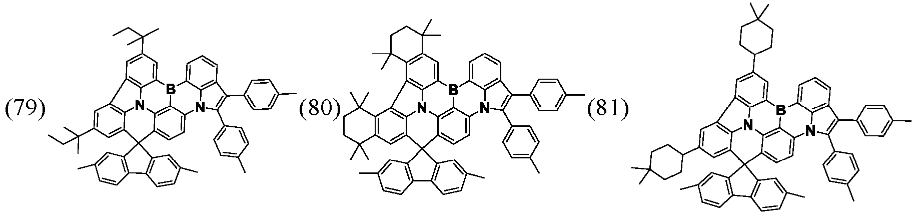

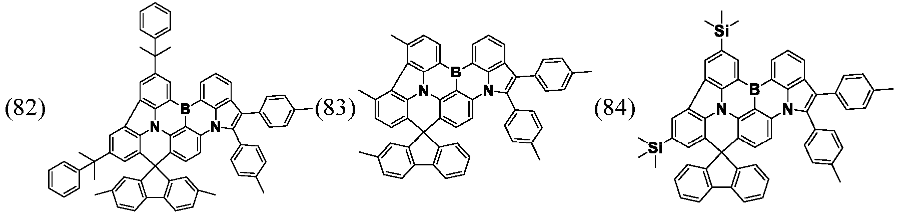

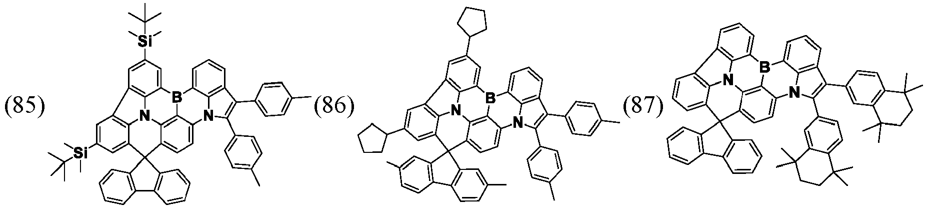

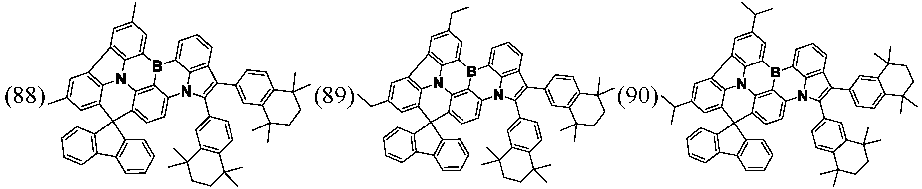

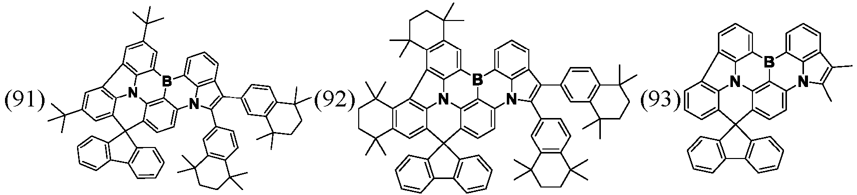

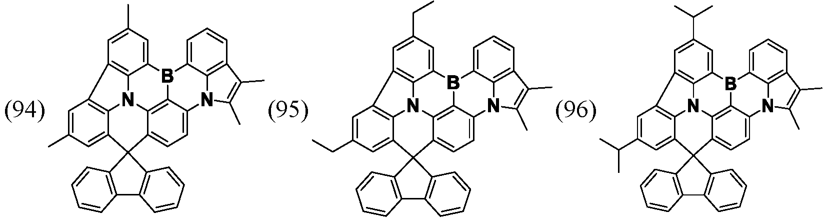

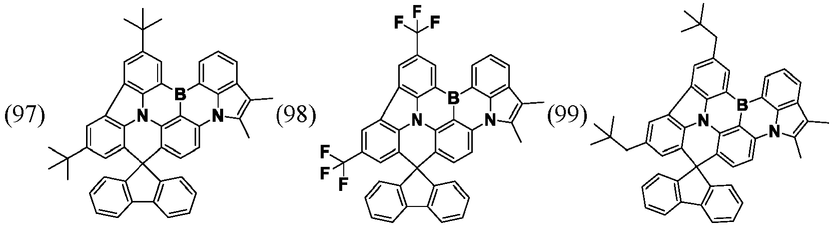

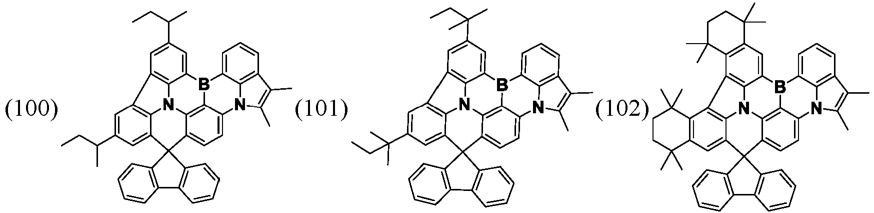

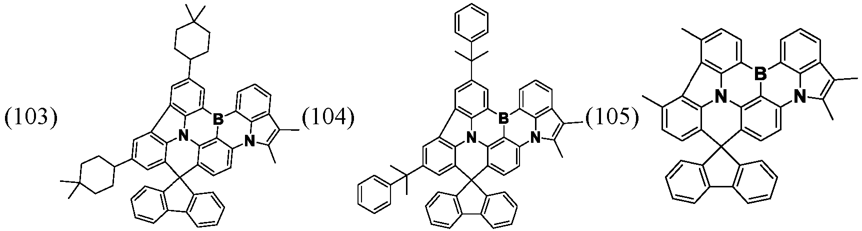

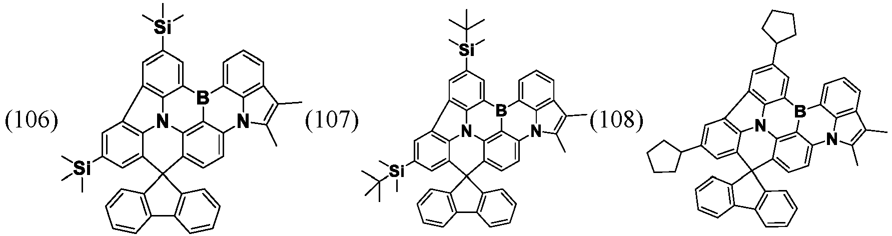

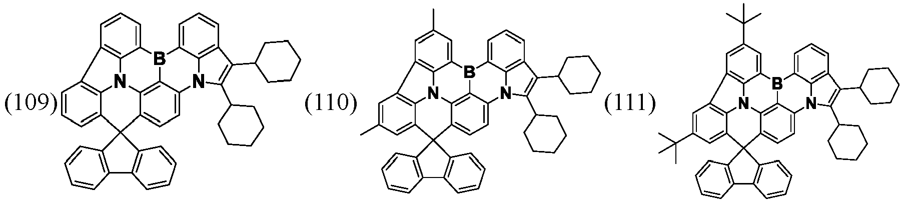

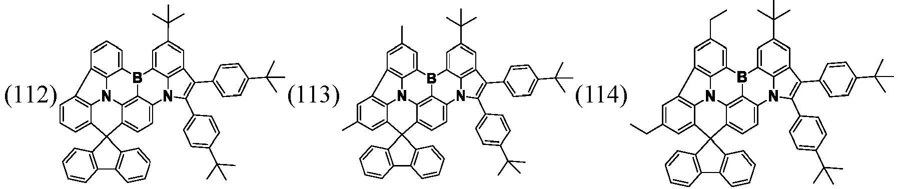

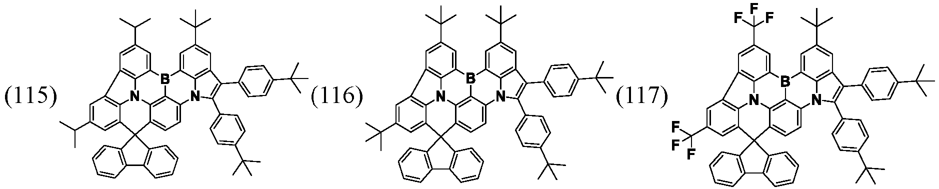

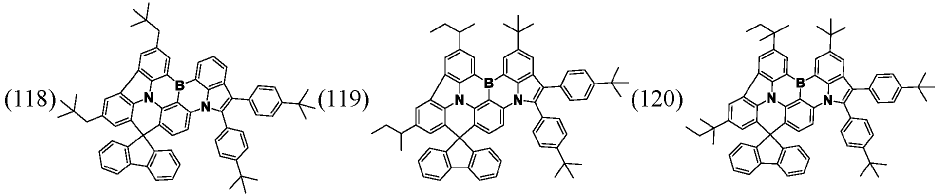

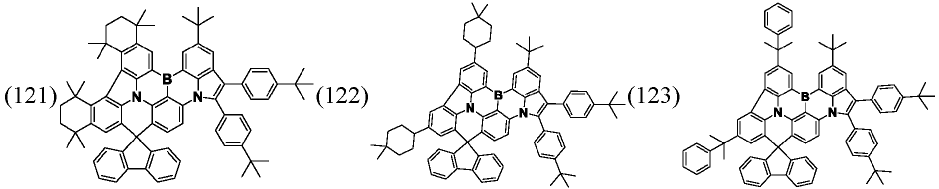

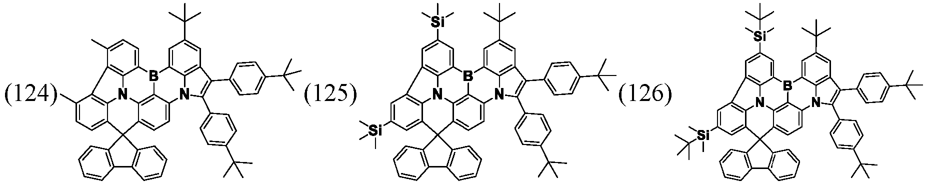

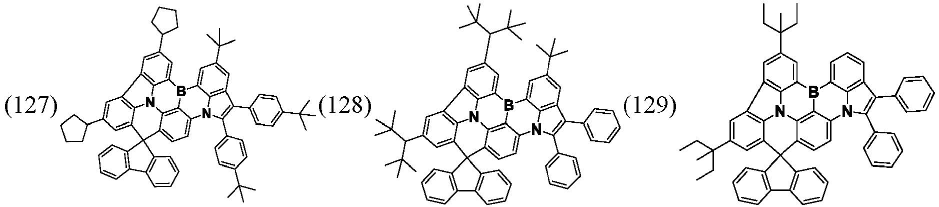

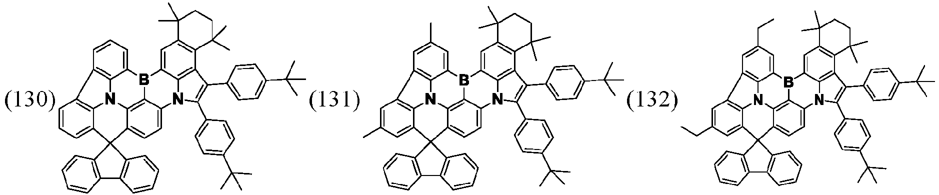

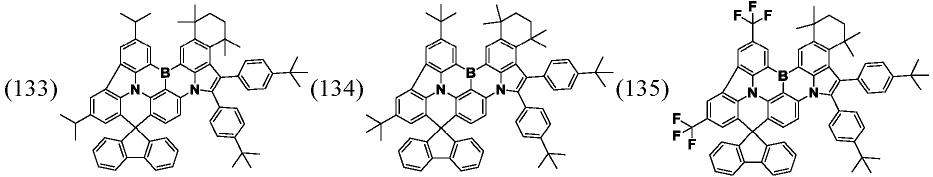

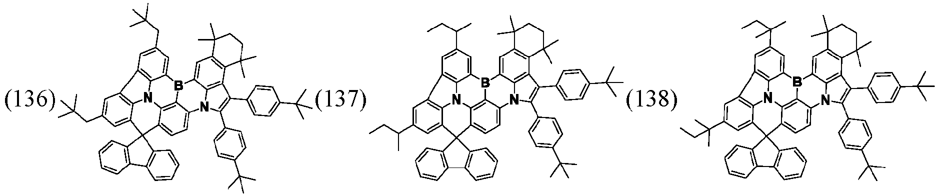

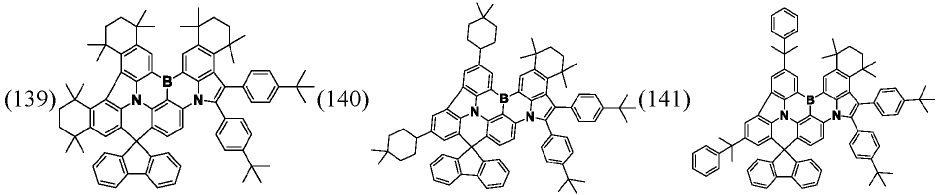

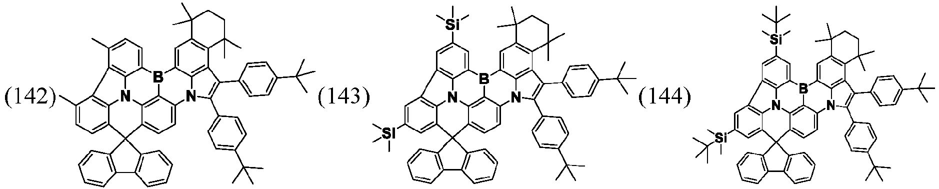

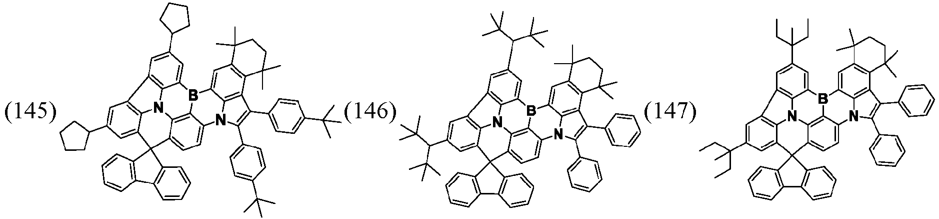

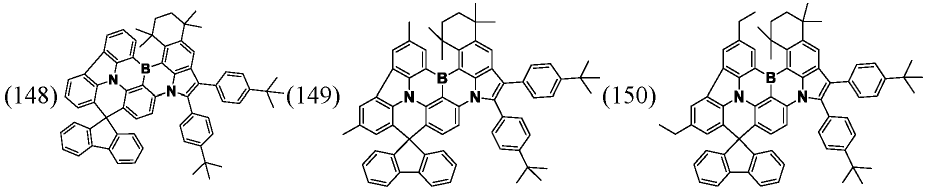

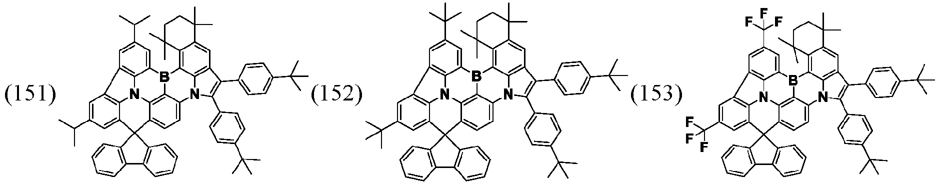

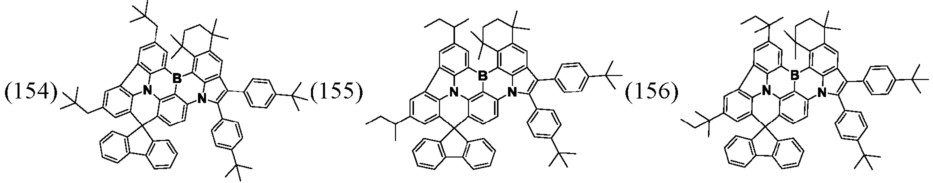

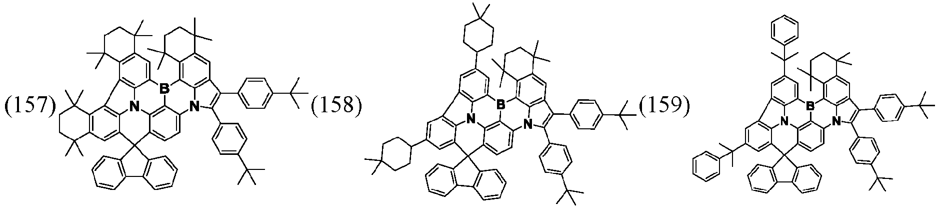

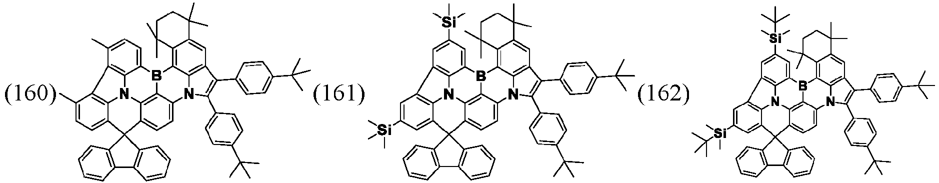

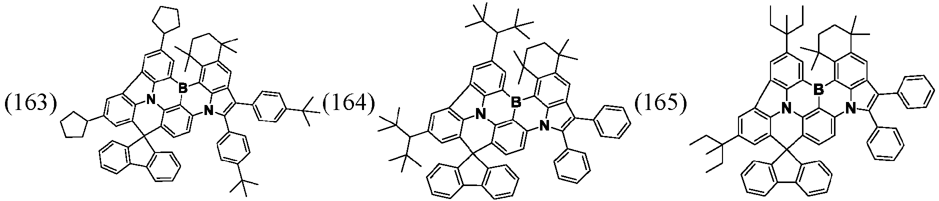

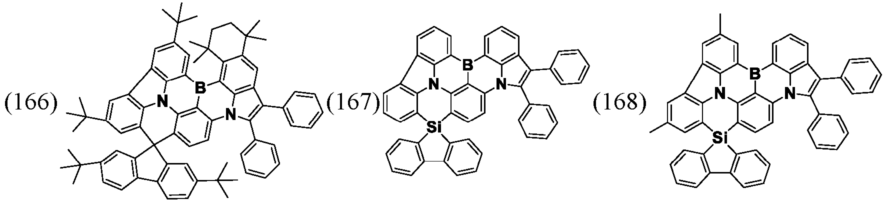

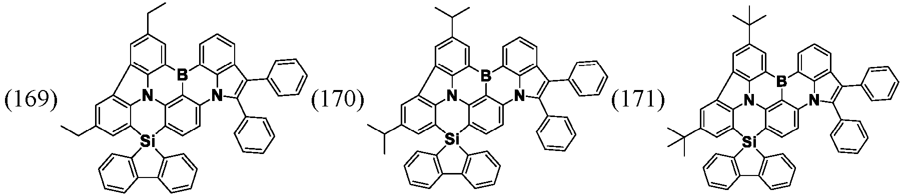

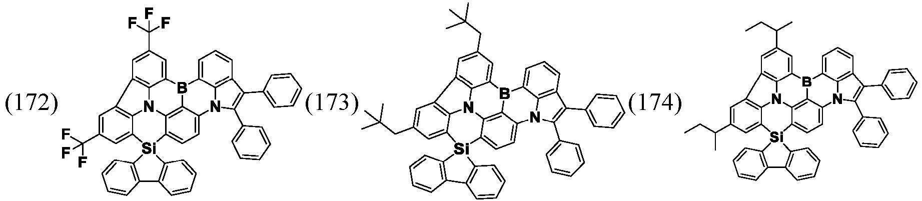

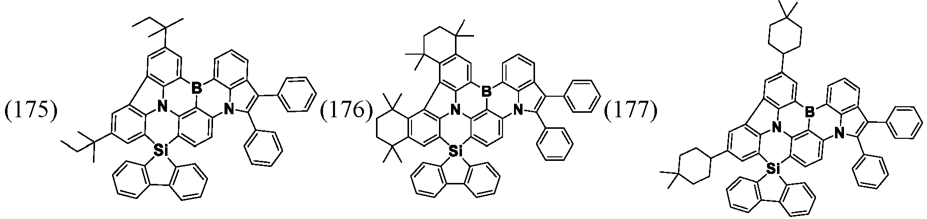

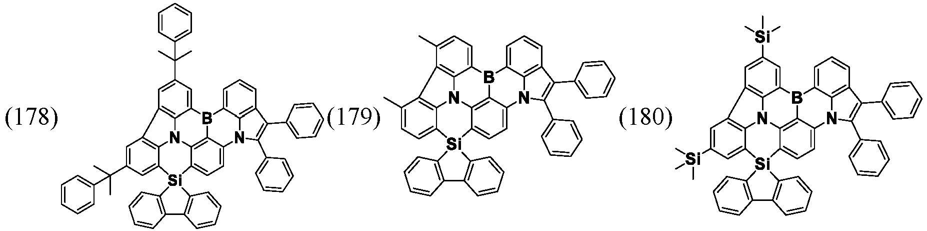

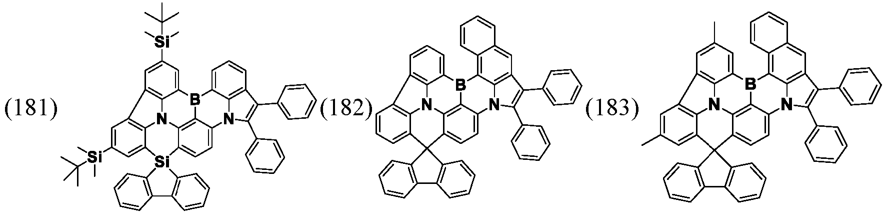

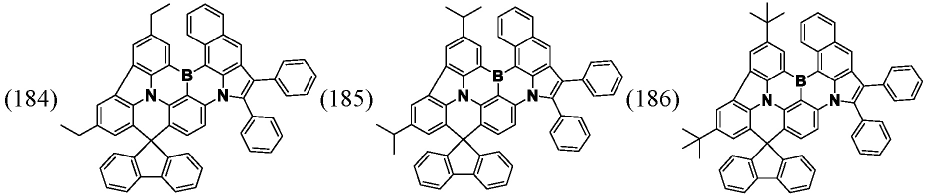

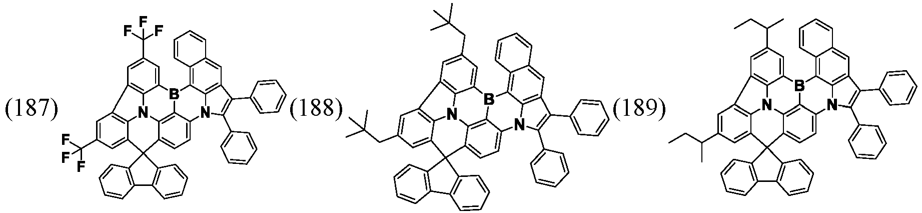

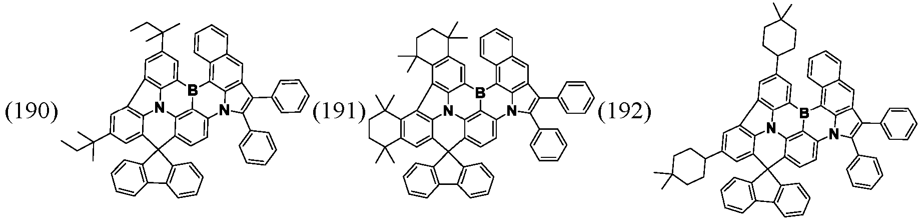

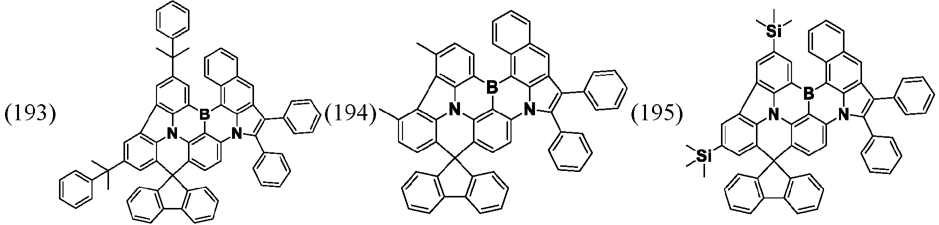

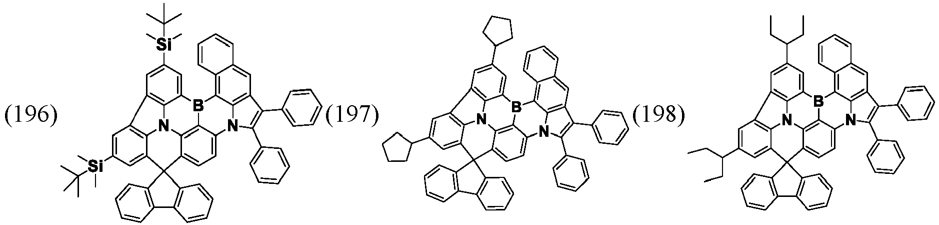

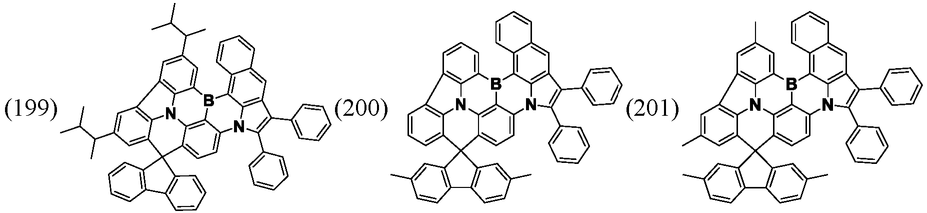

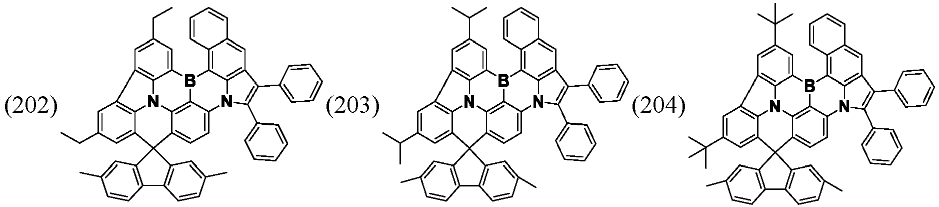

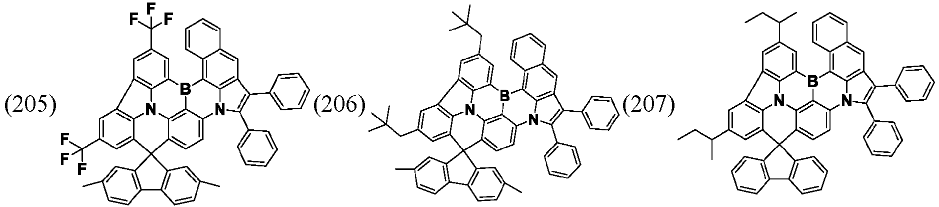

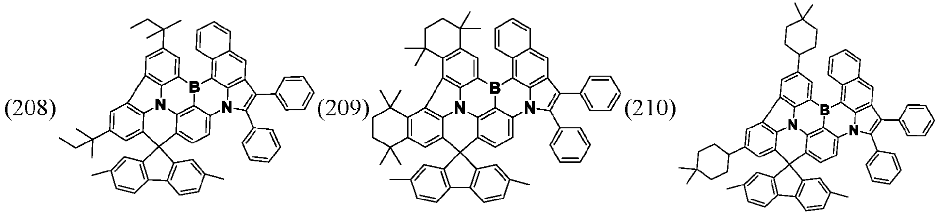

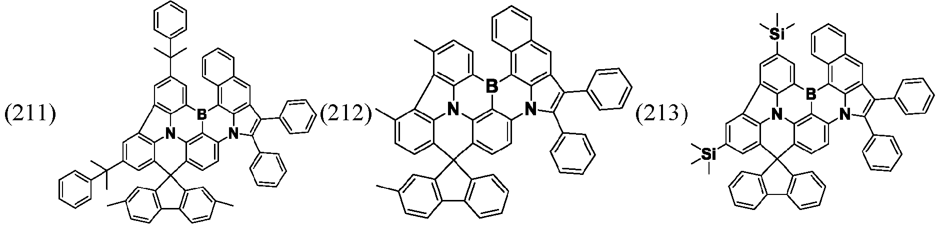

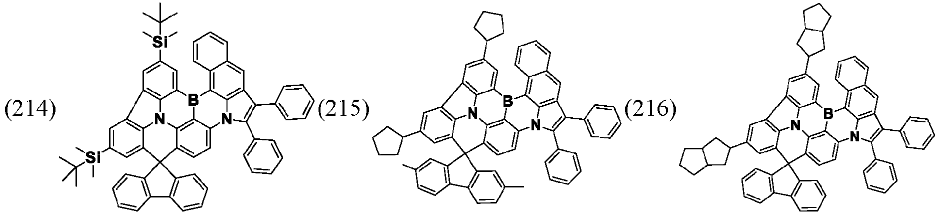

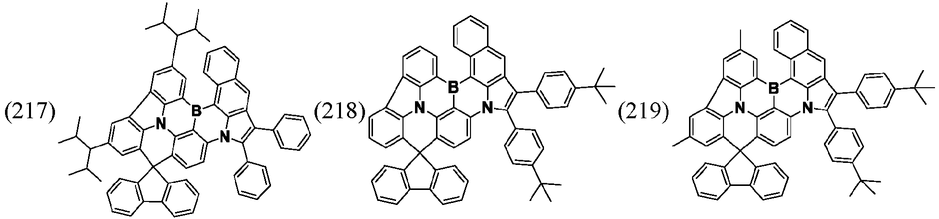

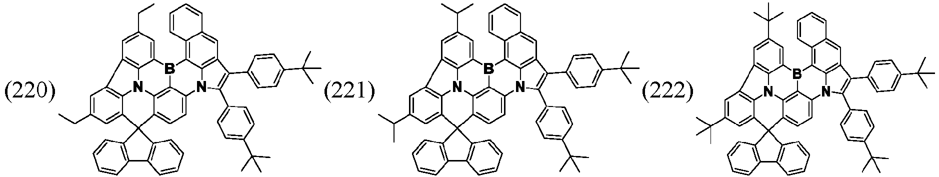

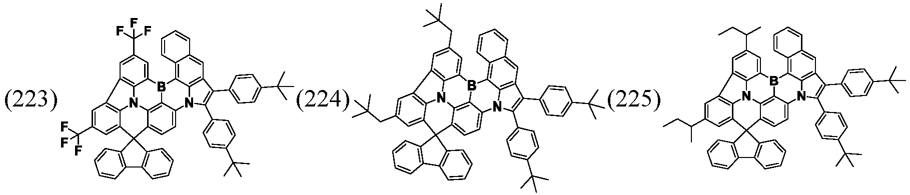

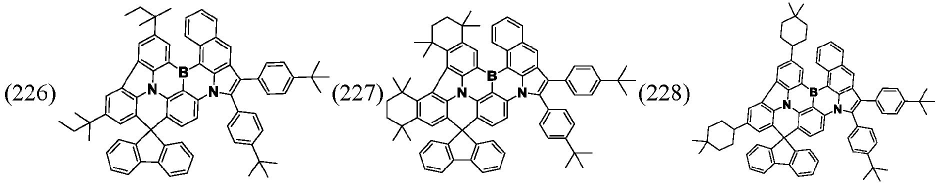

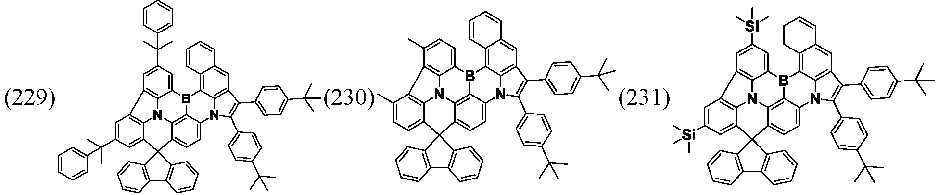

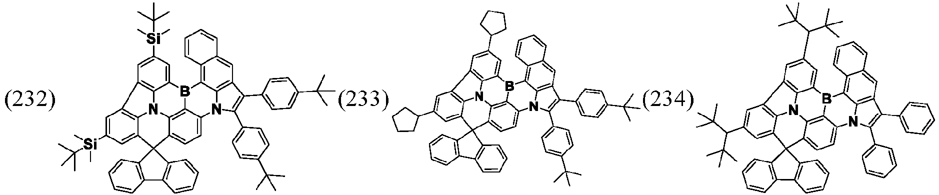

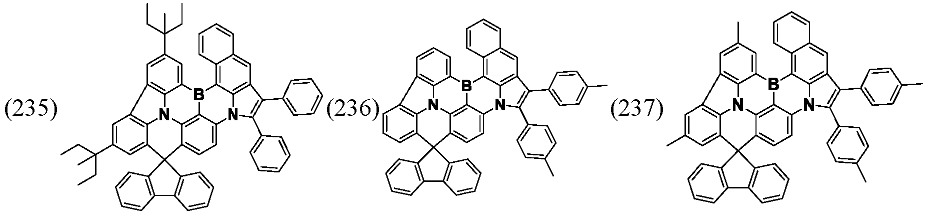

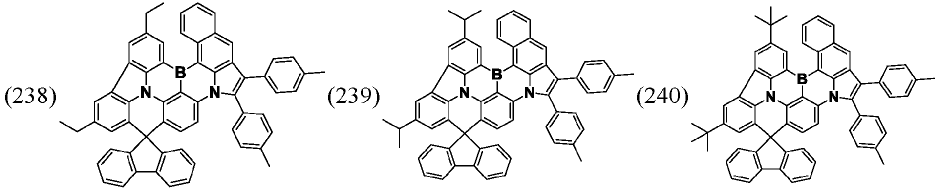

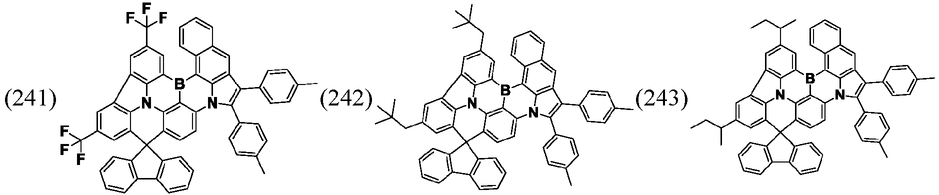

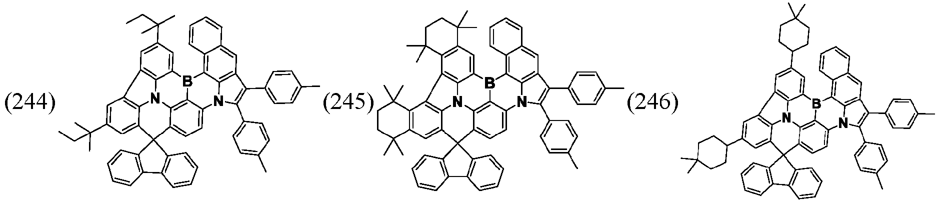

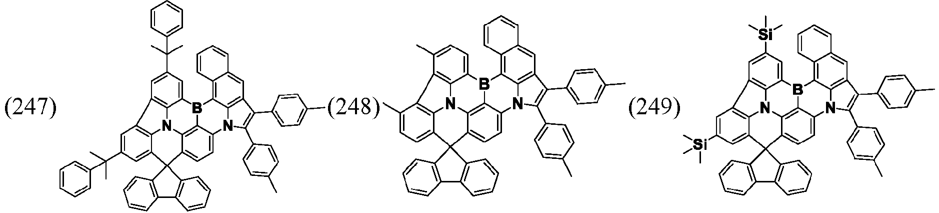

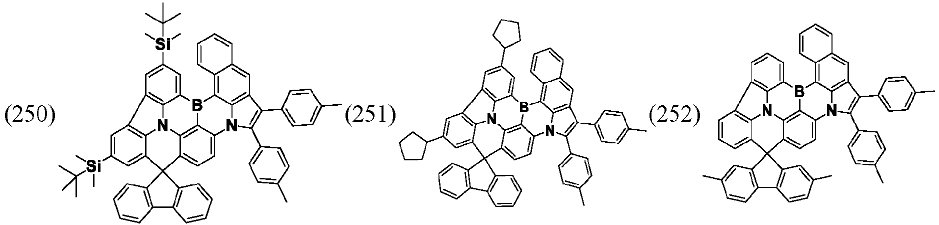

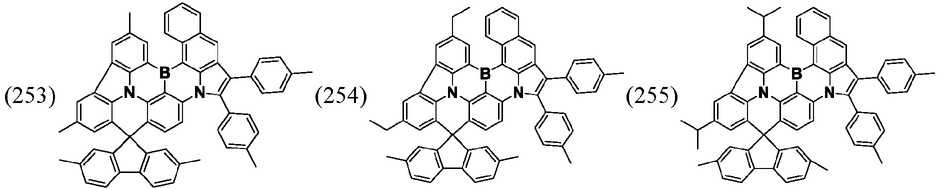

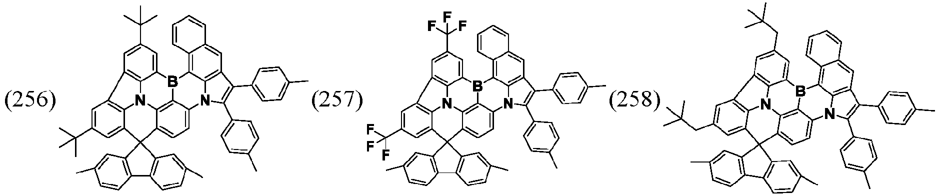

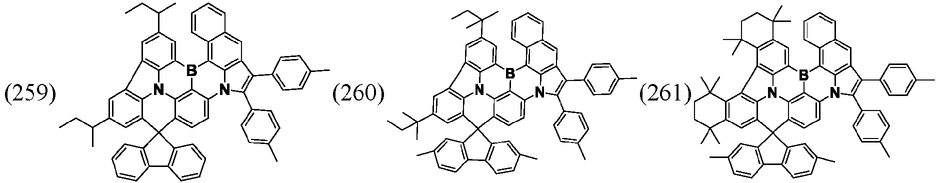

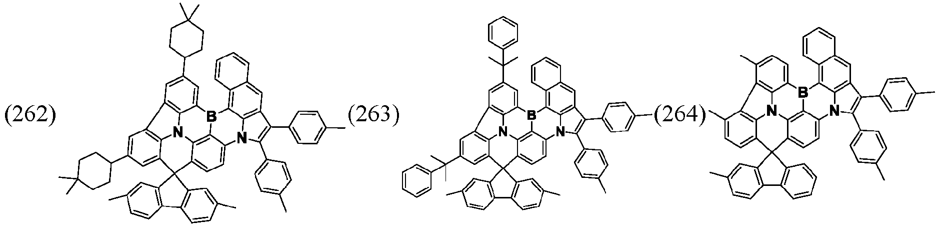

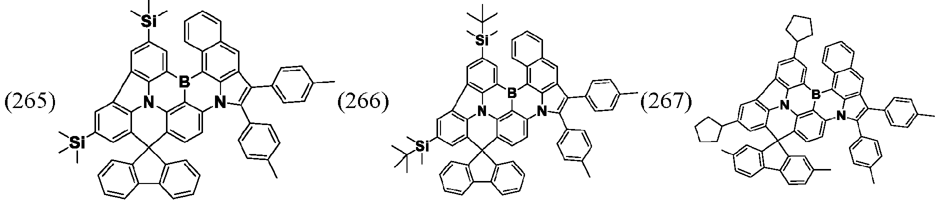

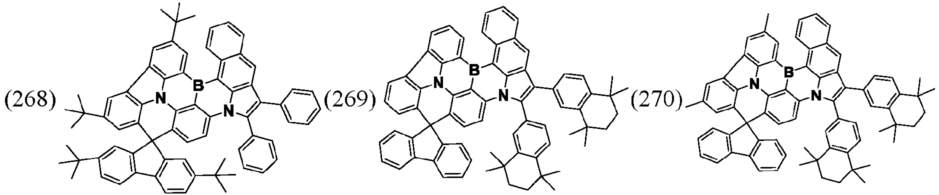

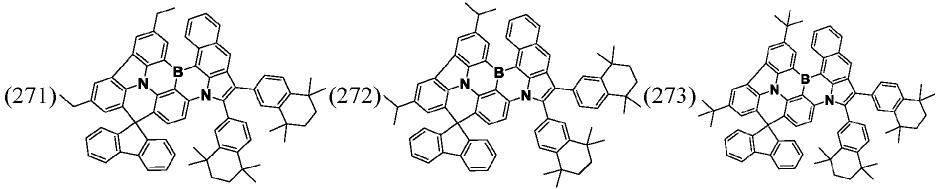

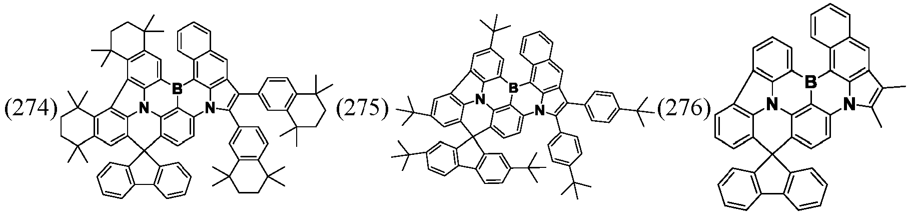

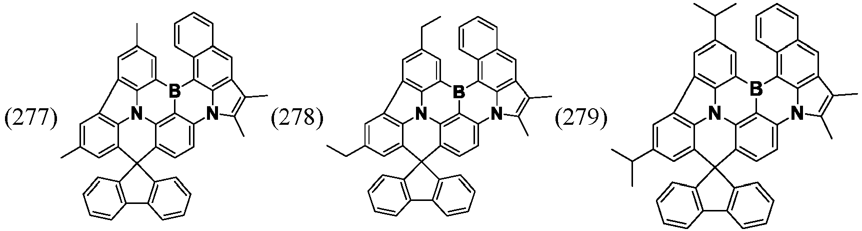

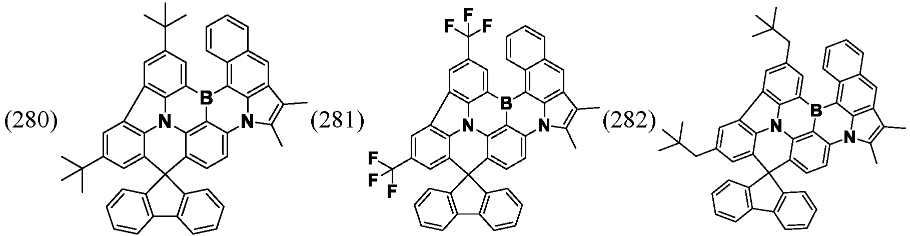

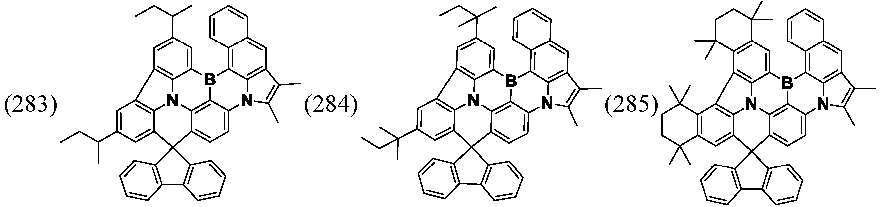

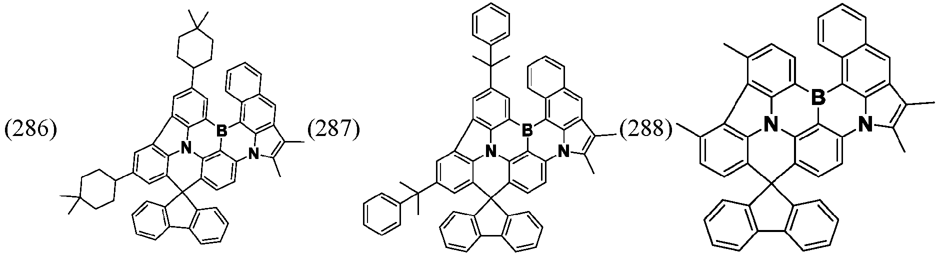

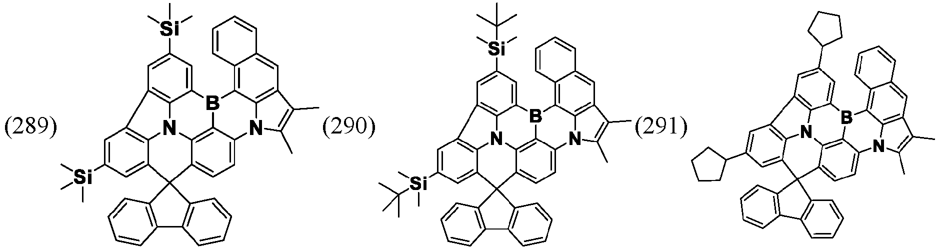

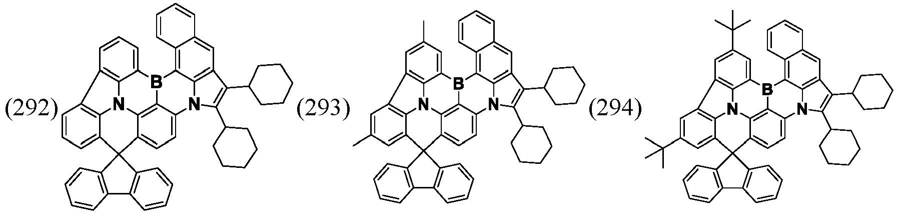

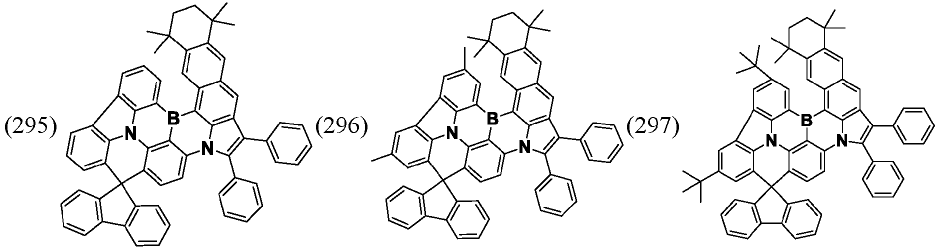

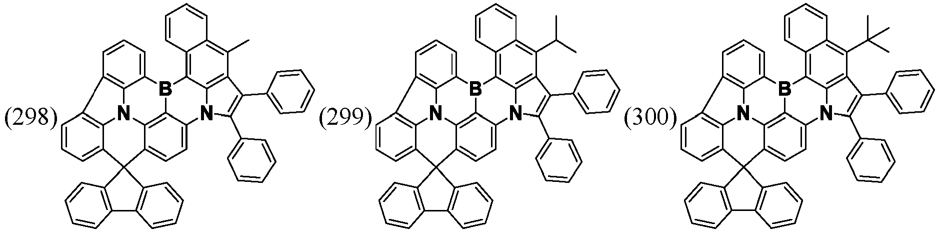

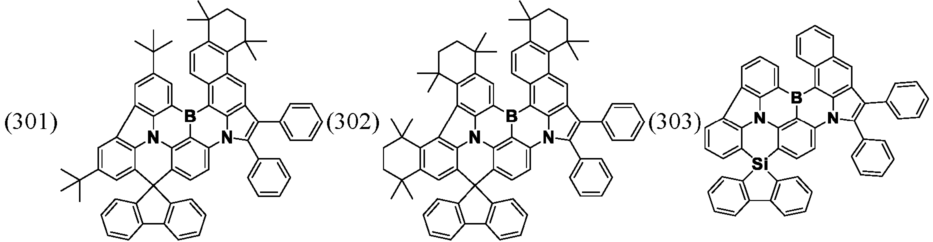

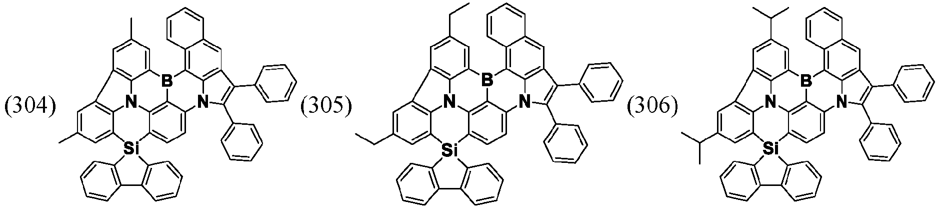

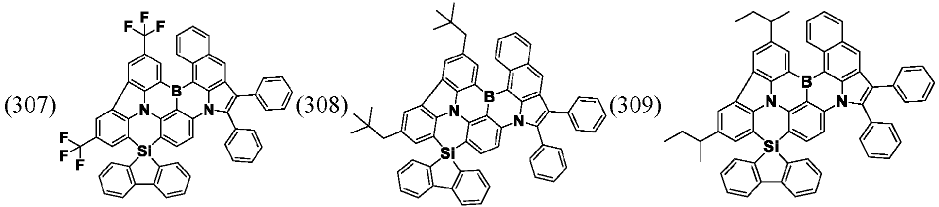

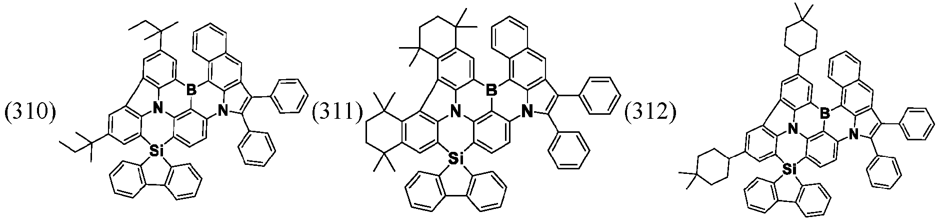

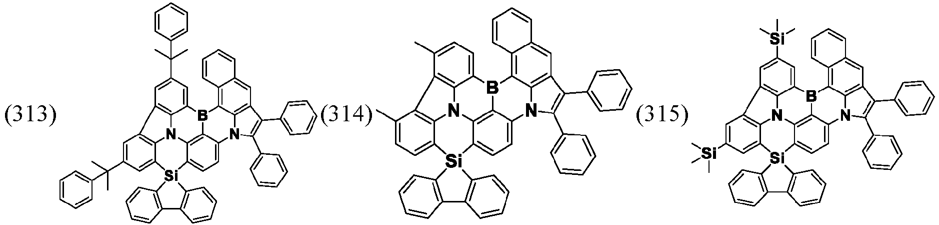

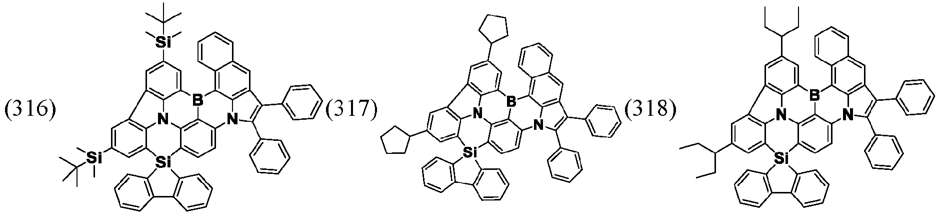

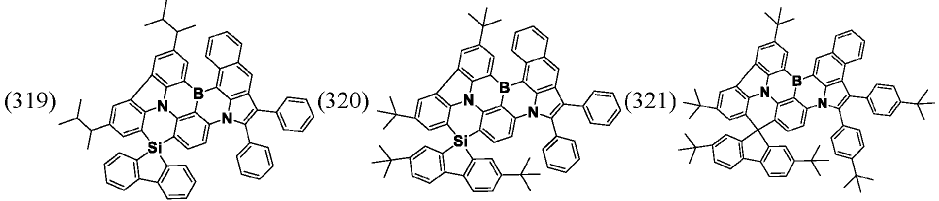

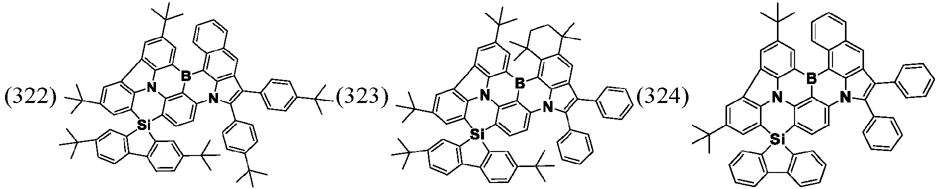

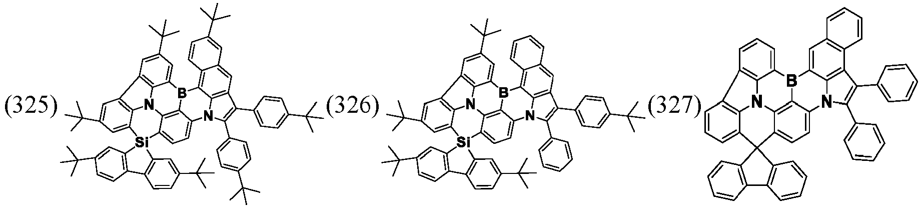

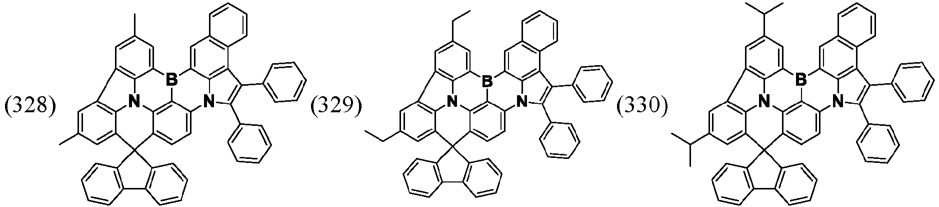

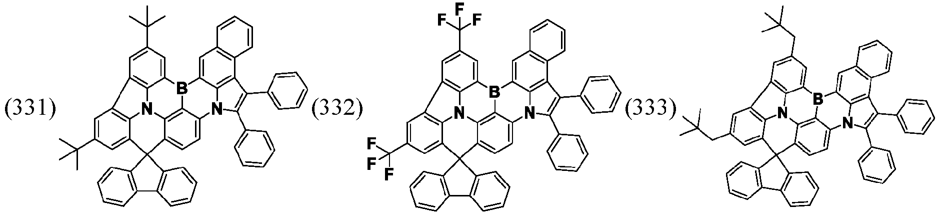

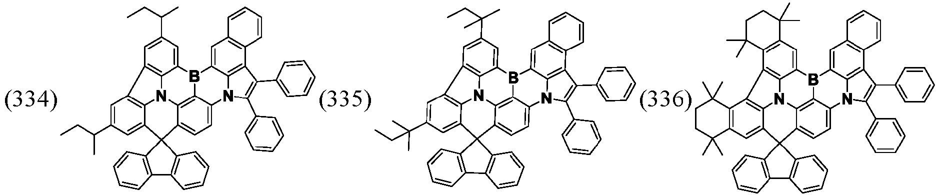

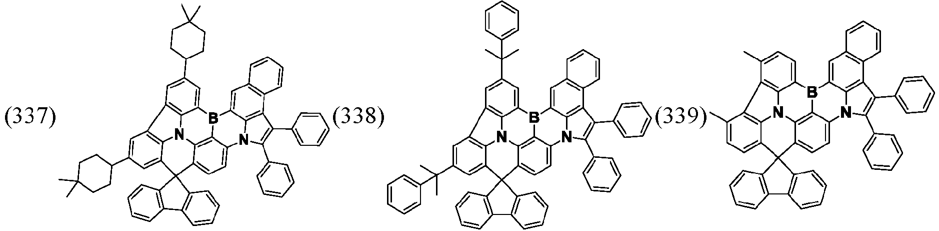

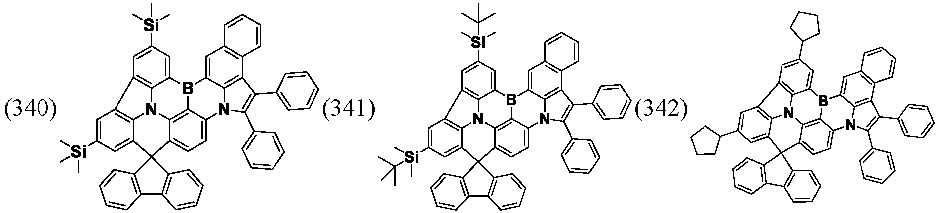

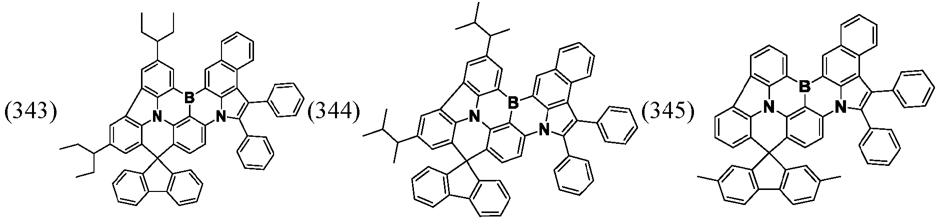

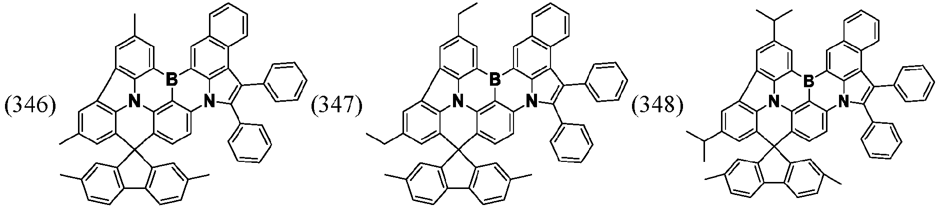

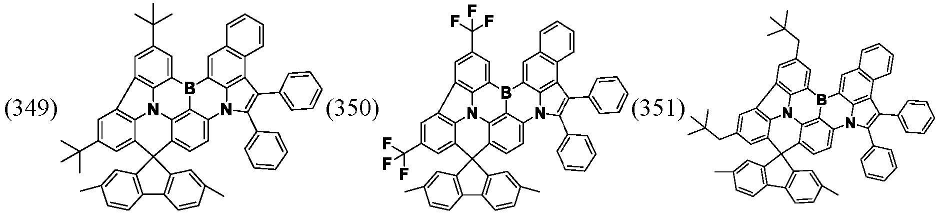

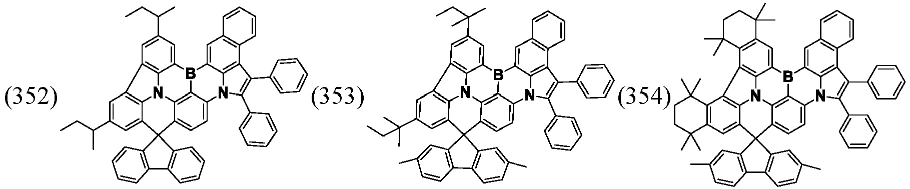

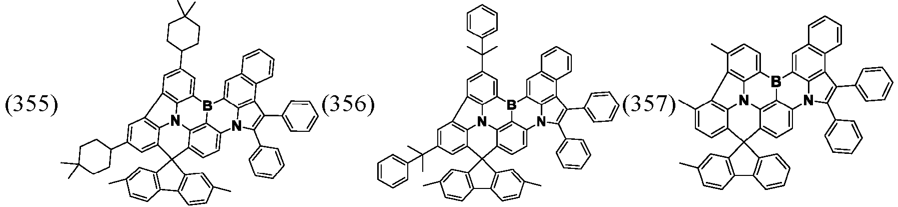

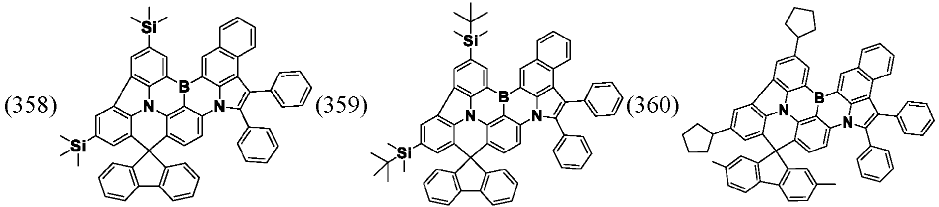

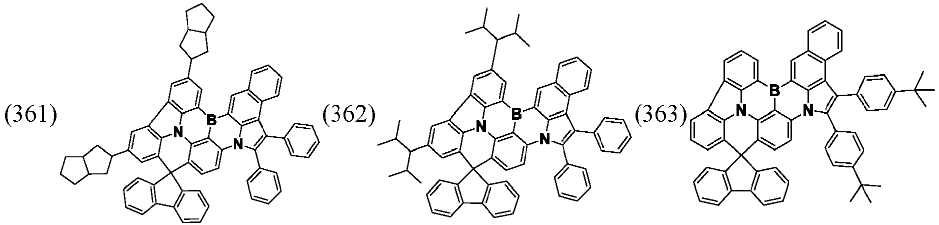

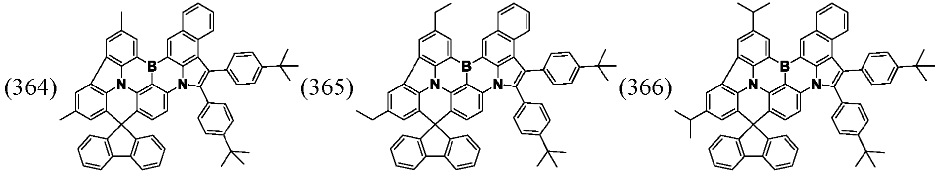

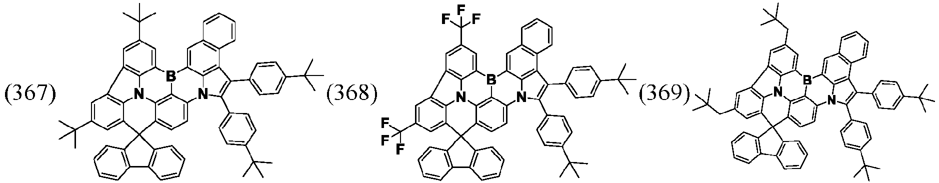

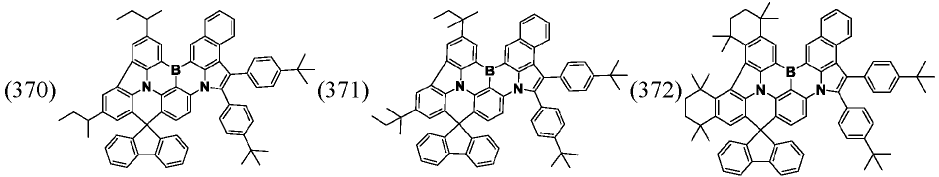

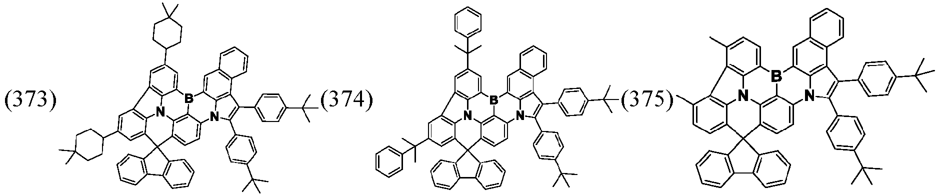

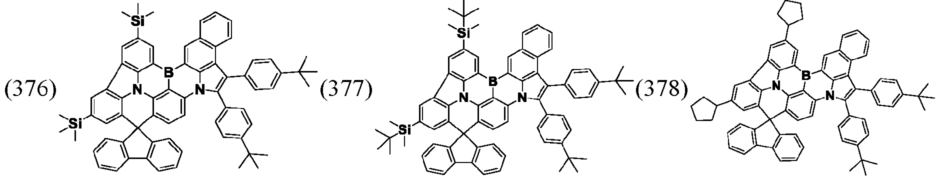

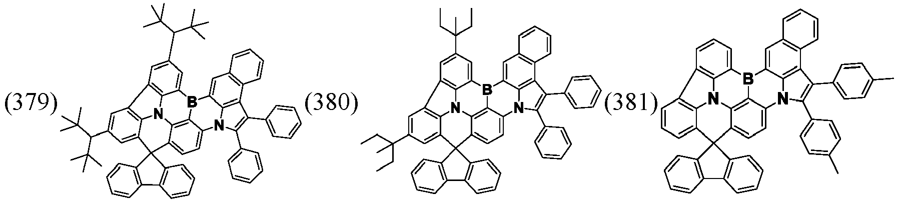

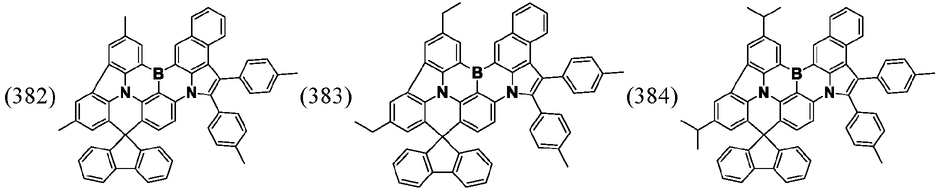

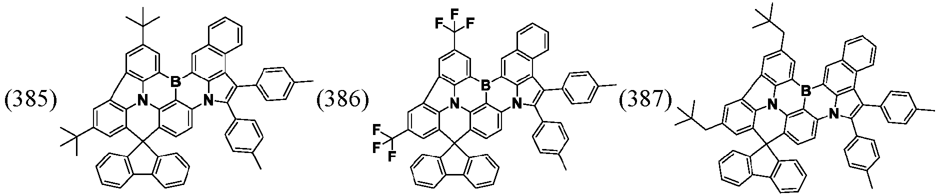

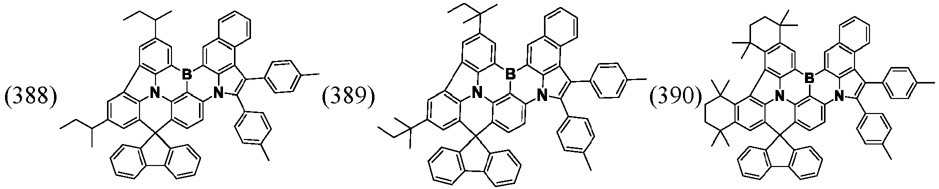

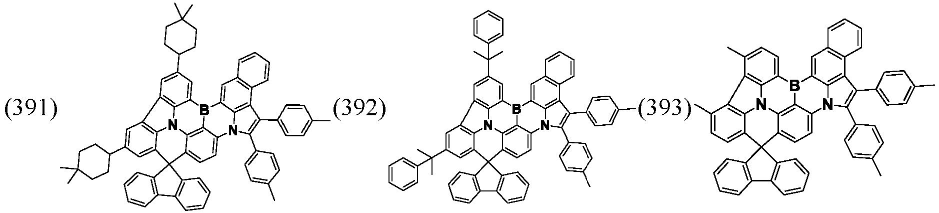

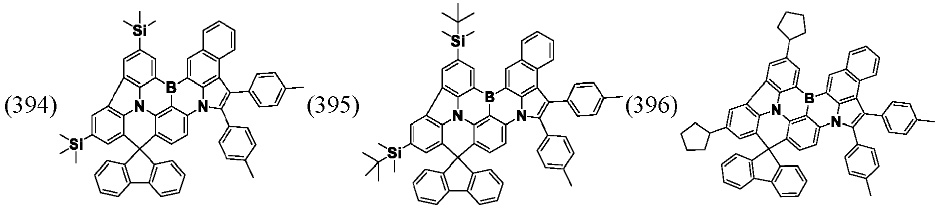

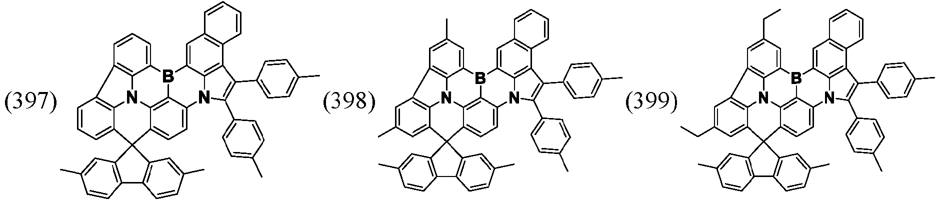

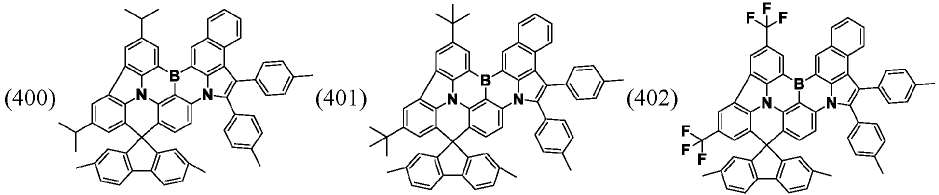

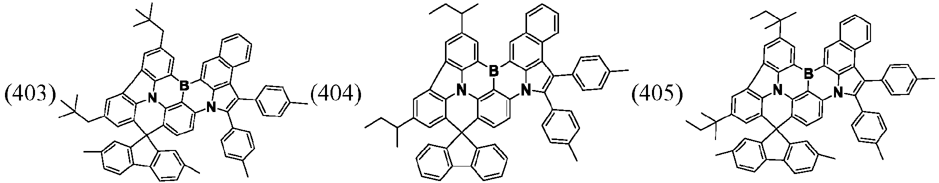

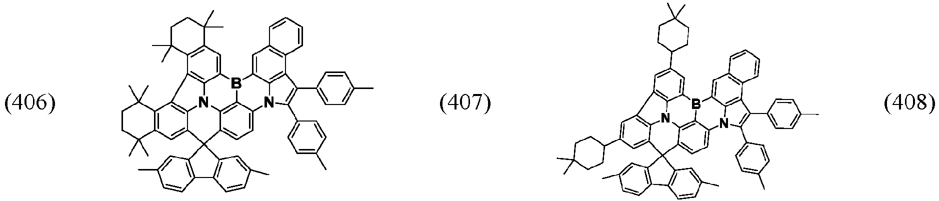

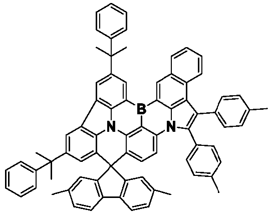

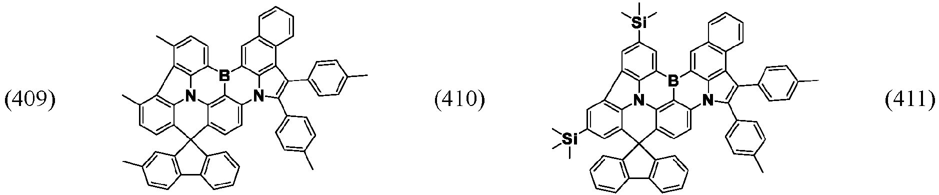

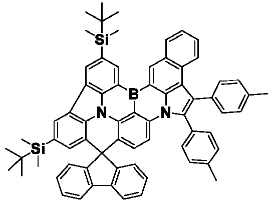

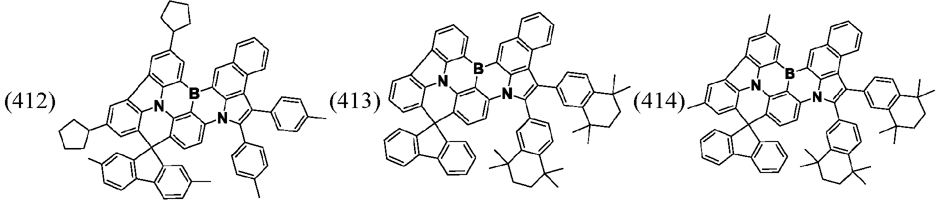

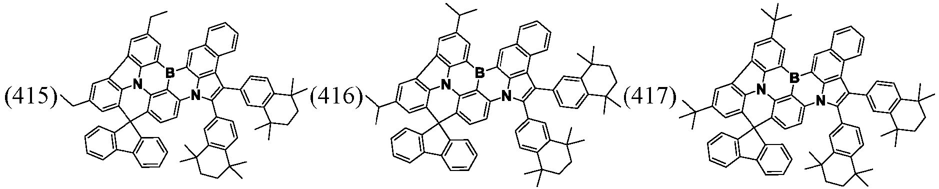

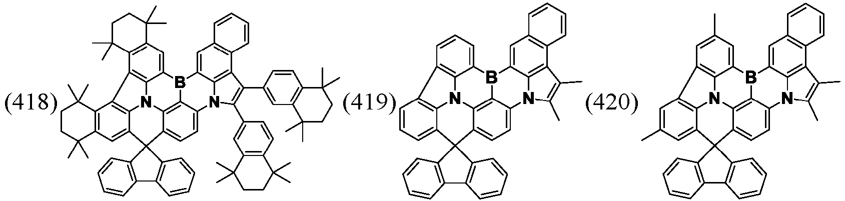

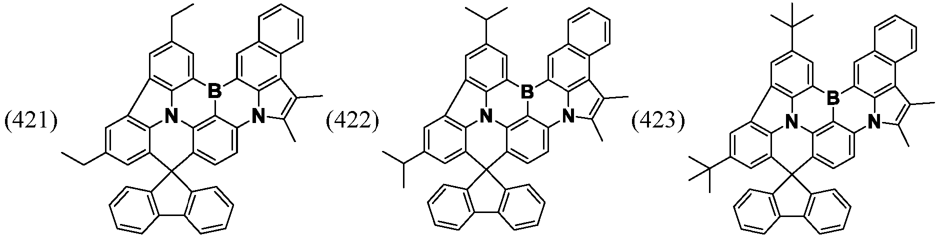

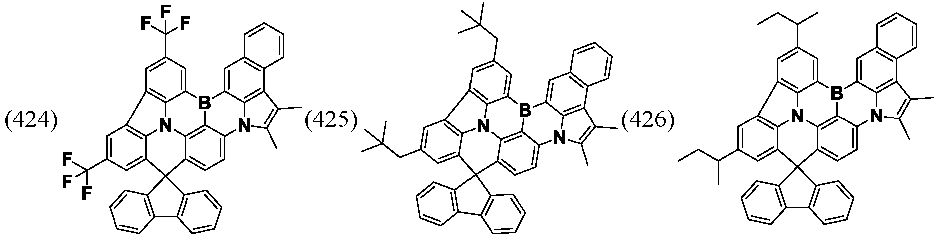

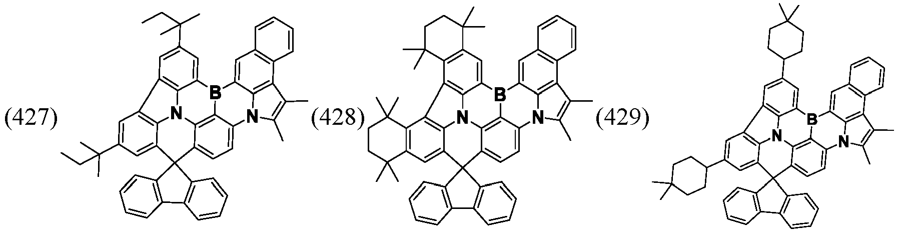

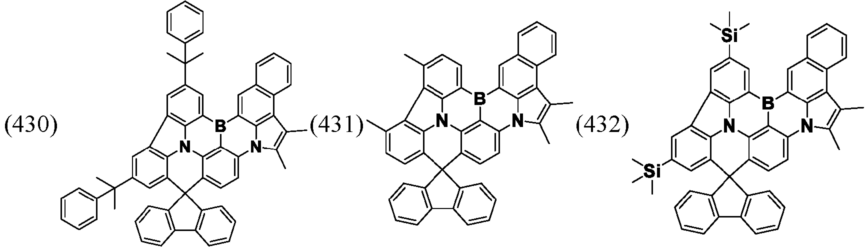

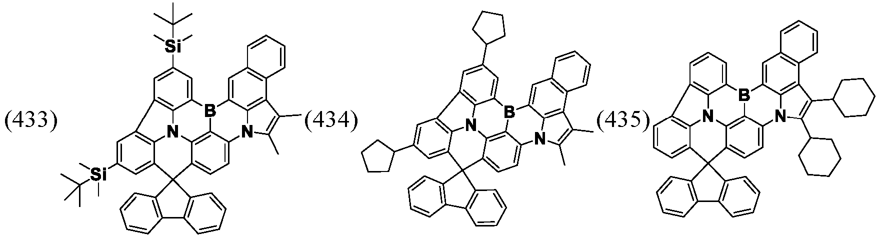

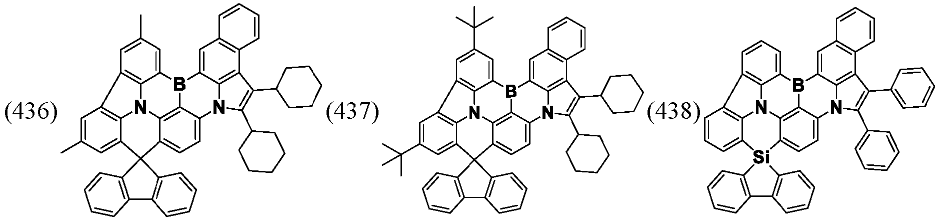

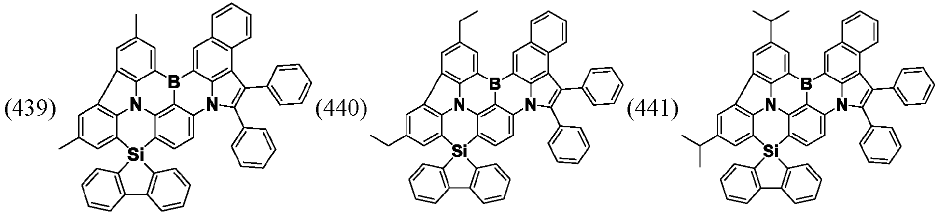

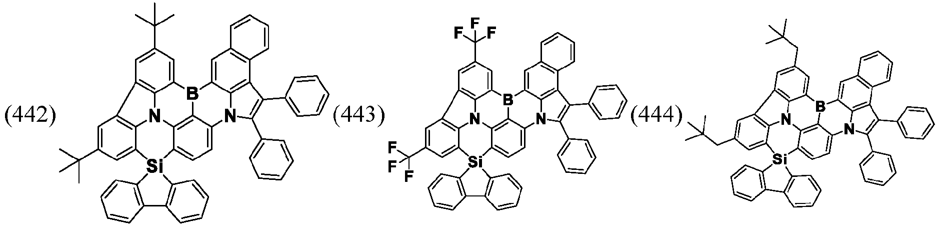

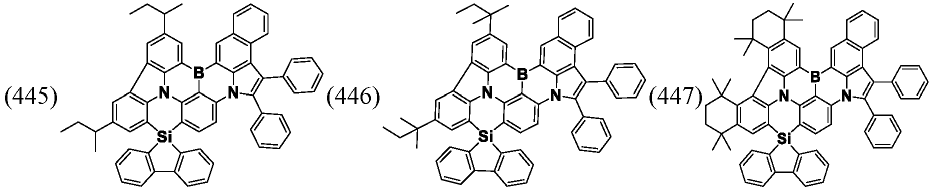

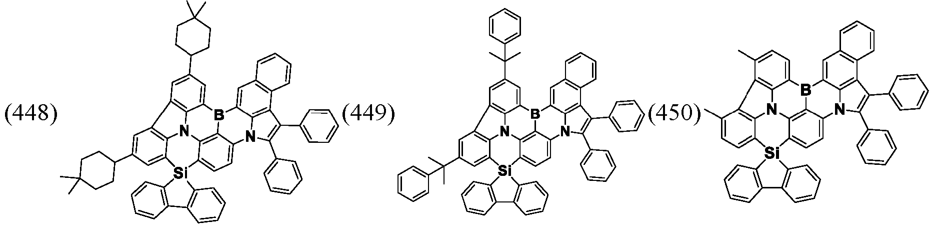

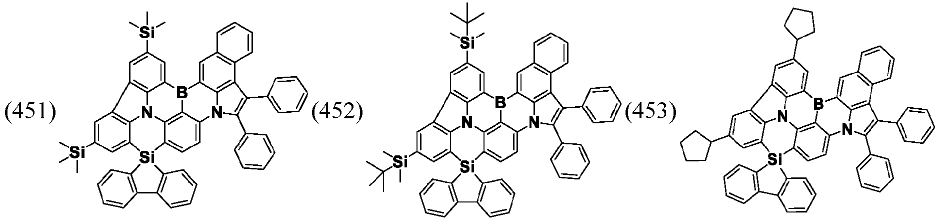

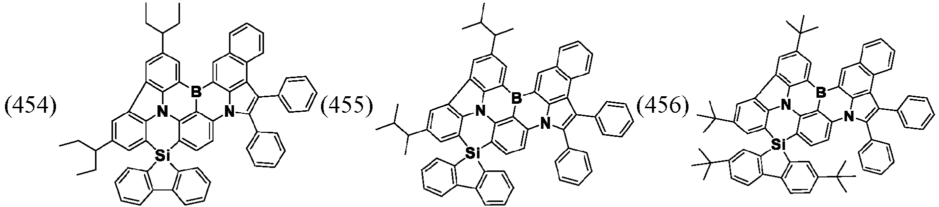

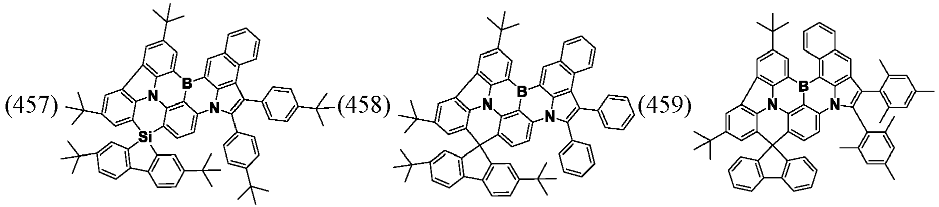

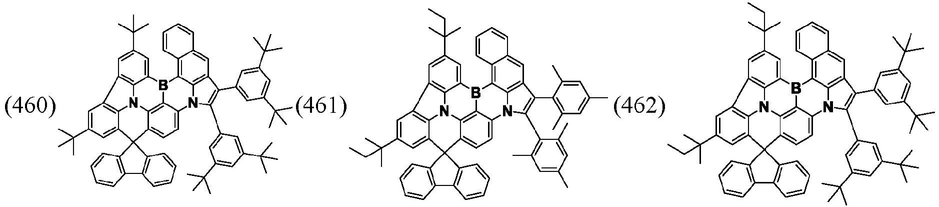

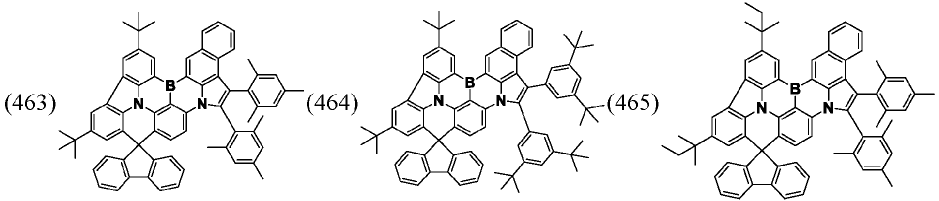

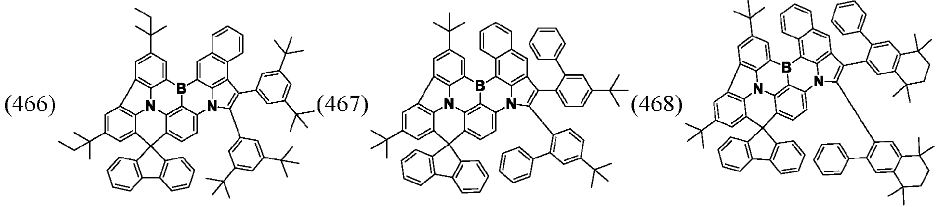

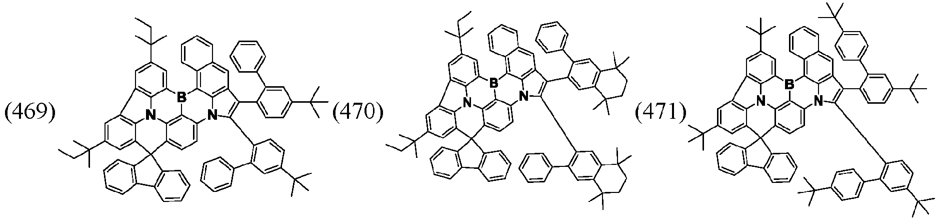

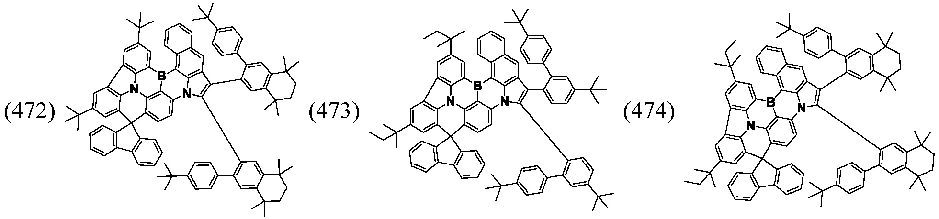

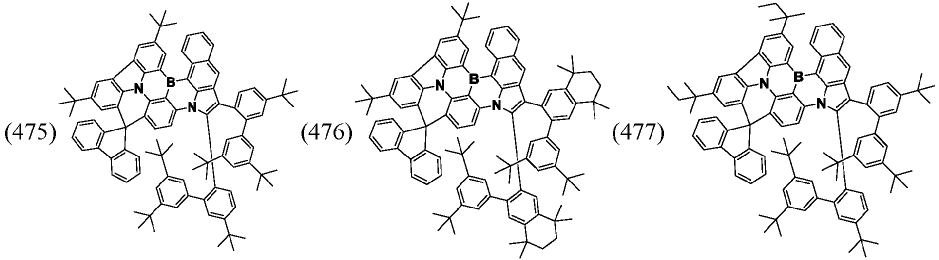

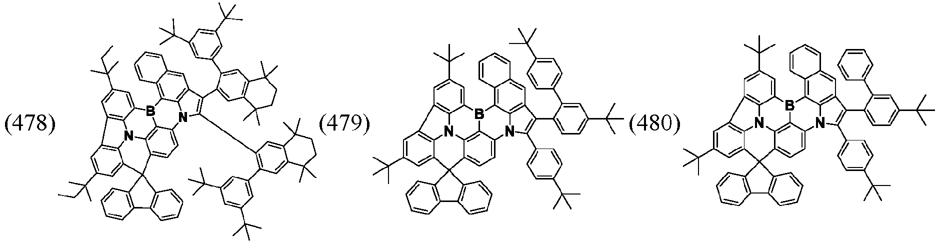

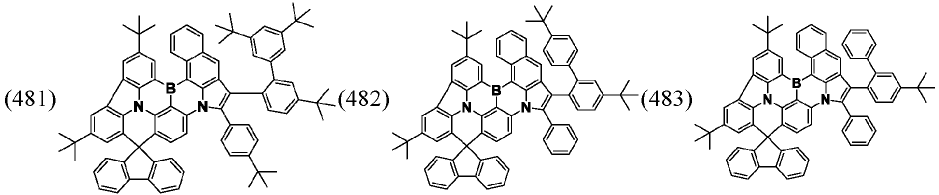

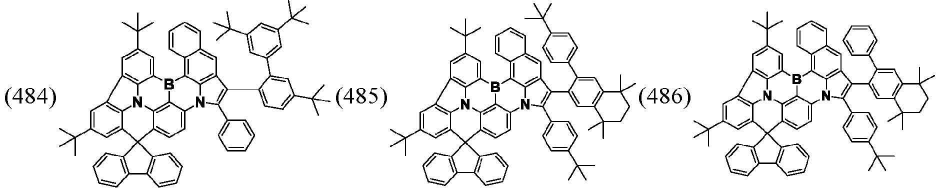

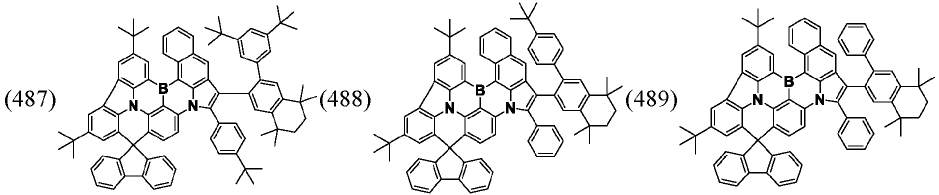

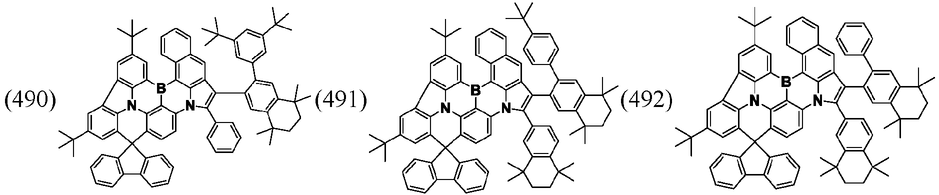

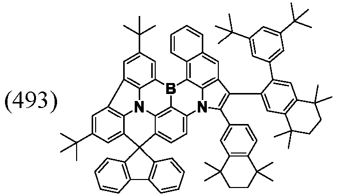

12. An organic electroluminescent device, comprising a cathode, an anode, and an organic light-emitting functional layer between the cathode and the anode, wherein the organic light-emitting functional layer comprises a light-emitting layer, and the light-emitting layer comprises the boron-containing organic compound according to any one of claims 1 to 11; and
preferably, the light-emitting layer comprises a host material and a doping material, and the doping material comprises the boron-containing organic compound according to any one of claims 1 to 11.

13. The organic electroluminescent device according to claim 12, wherein the light-emitting layer comprises a first host material, a second host material, and a doping material, at least one of the first host material and the second host material is a TADF material, and the doping material is the boron-containing organic compound according to any one of claims 1 to 11.

14. The organic electroluminescent device according to claim 12, wherein the light-emitting layer comprises a host material, an exciton-sensitizing material, and a doping material, the exciton-sensitizing material is a complex containing a metal element, and the doping material is the boron-containing organic compound according to any one of claims 1 to 11.

15. A material for an organic electroluminescent device, comprising the boron-containing organic compound according to any one of claims 1 to 11.

16. Use of the boron-containing organic compound according to any one of claims 1 to 11, in an organic electroluminescent device.

17. The use according to claim 16, wherein the organic light-emitting functional layer comprises a light-emitting layer, and the boron-containing organic compound according to any one of claims 1 to 11 is used in the light-emitting layer.

18. A display component, comprising the organic electroluminescent device according to any one of claims 12 to 14.

19. A lighting apparatus, comprising the organic electroluminescent device according to any one of claims 12 to 14.

20. An electronic device, carrying the organic electroluminescent device according to any one of claims 12 to 14.
